# EUROPEAN PATENT APPLICATION

(11) **EP 4 502 290 A1**
(43) Date of publication of application: **05.02.2025**
(21) Application number: 23780710.2
(22) Date of filing: 29.03.2023
(51) Int. Cl.: E02F 9/16, H04B 1/3822, H05K 5/02

(54) **WORKING MACHINE**

(30) Priority: 30.03.2022 JP 2022056714; 30.03.2022 JP 2022056713; 30.03.2022 JP 2022056715
(71) Applicant: KUBOTA CORPORATION, Osaka-shi, Osaka 556-8601 (JP)
(72) Inventor: TAKADA, Toshiki, Sakai-shi, Osaka 590-0908 (JP); SAKUTA, Takuya, Sakai-shi, Osaka 590-0908 (JP); KONISHI, Hironobu, Sakai-shi, Osaka 590-0908 (JP); MITSUI, Yusuke, Sakai-shi, Osaka 590-0908 (JP); MIMURA, Takuto, Sakai-shi, Osaka 590-0908 (JP); TANAKA, Shohei, Sakai-shi, Osaka 590-0908 (JP); NAKABAYASHI, Shintaro, Sakai-shi, Osaka 590-0908 (JP); KASHIWAGI, Atsushi, Sakai-shi, Osaka 590-0908 (JP); YANAGISAWA, Issei, Sakai-shi, Osaka 590-0908 (JP); YAMADA, Yuta, Sakai-shi, Osaka 590-0908 (JP); SAKATA, Tokio, Sakai-shi, Osaka 590-0908 (JP)
(74) Representative: Cabinet Beau de Loménie
(86) International application number: PCT/JP2023/012846
(87) International publication number: WO 2023/190701

(57) **Abstract**

A working machine (1) includes a machine body (2); a seat (6) on the machine body; a console (44R) located outward of the seat in a machine-body width direction; a meter (51) provided at a front portion of the console; a communication unit (58) located forward of the meter; and a unit support (61) to support the communication unit. The unit support includes a unit bracket (65) to which the communication unit is attached, a support bracket (66) located outward of the meter in the machine-body width direction (K2) and attached directly or indirectly to the machine body, and an attachment tool (76) to attach the unit bracket to the support bracket. The unit bracket includes an attached section (67). The support bracket includes an attaching section (118) with which the attached section overlaps in the machine-body width direction. The attachment tool attaches the attached section to the attaching section in the machine-body width direction.

## Description

### Technical Field

The present invention relates to a working machine.

### Background Art

A working machine disclosed in PTL 1 is known.

In the working machine disclosed in PTL 1, a console provided with a meter at a front portion is located at one side of a seat mounted on a machine body, and a communication unit is located forward of the meter. A unit support that supports the communication unit includes a unit bracket to which the communication unit is attached, and a support bracket located outward of the meter in a machine-body width direction and attached directly or indirectly to the machine body. An attached section of the unit bracket is overlapped with a lower surface of an attaching section of the support bracket. The overlapped portions are fastened from below by a bolt.

Also, in the working machine disclosed in PTL 1, the console is located at one side of the seat, and the communication unit and the unit bracket to which the communication unit is attached are located forward of the console. Also, the console is supported by the support bracket vertically provided on the machine body.

Additionally, a working machine disclosed in PTL 2 is known.

The working machine disclosed in PTL 2 includes a communication unit including an information processing device (first controller) that receives and transmits information relating to the working machine and performs processing and a communication device (working-machine wireless terminal) that receives data from and transmits data to the information processing device. The communication device transmits information relating to the working machine to an information collection terminal.

### Citation List

### Patent Literature

PTL 1: Japanese Unexamined Patent Application Publication No. 2021-150509
PTL2: Japanese Unexamined Patent Application Publication No. 2013-16118

### Summary of Invention

### Technical Problem

In the PTL 1, the space between the communication unit and the meter is narrow, and therefore it is not so good in workability to attach the attached section of the unit bracket to the attaching section of the support bracket from below.

Additionally, in PTL 1, a controller is located at the opposite side of the console from the seat. The controller is supported by a controller support fixed to the support bracket. The unit bracket is attached to a front portion of an attachment bracket attached on the controller support. Therefore, the structure for attaching the communication unit is large.

Additionally, in the working machine, when the communication unit including the communication device and the information processing device is mounted on the machine body, a useful layout is required.

An object of the present invention is to provide a working machine in which a communication unit is located forward of a meter and a unit bracket can be easily attached to a support bracket.

An object of the present invention is to provide a working machine that can make a structure for attaching a communication unit compact.

An object of the present invention is to provide a working machine in which a communication unit including a communication device and an information processing device is provided in a useful layout.

### Solution to Problem

A working machine according to an aspect of the present invention includes a machine body; a seat on the machine body; a console located outward of the seat in a machine-body width direction; a meter provided at a front portion of the console; a communication unit located forward of the meter; and a unit support to support the communication unit. The unit support includes a unit bracket to which the communication unit is attached, a support bracket located outward of the meter in the machine-body width direction and attached directly or indirectly to the machine body, and an attachment tool to attach the unit bracket to the support bracket. The unit bracket includes an attached section. The support bracket includes an attaching section with which the attached section overlaps in the machine-body width direction. The attachment tool is configured to attach the attached section to the attaching section in the machine-body width direction.

The working machine may include a pin provided at one of the attaching section and the attached section such that the pin is deviated from a position at which the attachment tool is attached; and a pin insertion hole provided in the other of the attaching section and the attached section. The attached section may be attached to the attaching section via the attachment tool with the pin inserted through the pin insertion hole.

The pin insertion hole may be a long hole elongated in an up-down direction. The attachment tool may be configured to fasten the attaching section and the attached section above the pin.

The working machine may further include a controller located outward of the meter in the machine-body width direction; and a controller support attached directly or indirectly to the machine body to support the controller. The support bracket may be attached on the controller support along a front-rear direction. The controller support may include a constituent portion including an upper surface extending below the attaching section and the attached section and extending diagonally forward and downward.

The communication unit may include an information processing device and a communication device to receive data from and transmit data to the information processing device, the communication device containing a communication antenna and configured to transmit data. The information processing device may be located on a back side of the communication device and include, at a lower side thereof, a connection portion to have a harness connected thereto. The unit bracket may include a guard member to guard the harness connected to the connection portion from below.

A pedal member to be depressed by a user seated on the seat may be located below the guard member.

The attachment tool may be attached to the attached section and the attaching section through a space between the meter and the communication unit in an inward-to-outward direction along the machine-body width direction.

The support bracket may include a harness guide to restrict a movement in the machine-body width direction and a downward movement of a harness guided rearward from the communication unit and above the support bracket.

A working machine according to an aspect of the present invention includes a machine body; a seat on the machine body; a console located at one side of the seat; a communication unit; a unit bracket to which the communication unit is attached; a support bracket vertically provided on the machine body to support the console; and an attachment bracket provided at the support bracket to attach the unit bracket.

The communication unit may include an information processing device and a communication device to receive data from and transmit data to the information processing device, the communication device containing a communication antenna and configured to transmit data. The information processing device and the communication device may be arranged in a front-rear direction.

The communication device may include an electronic substrate with the communication antenna attached on an obverse side thereof, and a case to house the electronic substrate such that the obverse side faces in the same direction as a device front surface of the communication device, and the device front surface may be positioned to face a space above a floor portion located forward of the seat.

The unit bracket may include an attachment member attached to the attachment bracket, a vertical member extending in an up-down direction and including an upper portion to which the attachment member is fixed, a first bracket member fixed forward of the vertical member, and a second bracket member fixed rearward of the vertical member. One of the information processing device and the communication device may be attached to the first bracket member, and the other of the information processing device and the communication device may be attached to the second bracket member.

The attachment bracket may be provided at an upper portion of the support bracket such that the attachment bracket protrudes sideways from the support bracket away from the seat and include an attachment wall including an attachment surface facing in the up-down direction. The attachment member may be attached to the attachment wall such that the attachment member and the attachment wall overlap each other in the up-down direction.

The working machine may include a fixing member which is attached to the machine body and to which a lower portion of the support bracket is attached. The unit bracket may include an attachment stay fixed to a lower portion of the vertical member and attached to the fixing member.

The working machine may further include a fixing bracket fixed to a lower portion of the support bracket. The unit bracket may include a coupling stay fixed to a lower portion of the vertical member and coupled to the fixing bracket.

The working machine may further include a harness connected to the communication unit; and a cover member attached to the support bracket to cover a side of the harness that faces the seat.

The working machine may further include a harness connected to the communication unit, the harness being for use for both working machines including a cabin on the machine body and working machines including no cabins on the machine body.

A working machine according to an aspect of the present invention includes a machine body; a seat on the machine body; a console located at one side of the seat and including a manual operator; and a communication unit located rearward of the console and including an information processing device and a communication device to receive data from and transmit data to the information processing device, the communication device containing a communication antenna and configured to transmit data.

The seat may be provided at a position deviated in a first direction along a machine-body width direction from a central portion in the machine-body width direction of the machine body. The console may be located sideward of the seat in a second direction along the machine-body width direction. The communication unit may be located rearward of the seat and sideward of the seat in the second direction along the machine-body width direction.

The working machine may further include a prime mover provided at a rear portion of the machine body; and a hood to house the prime mover. The communication unit may be located above the hood.

The working machine may further include a seat protector provided on the machine body; a unit support to support the communication unit; and a support frame provided on the machine body to support the hood. The seat protector may include an attachment frame attached to the support frame. The unit support may include an attachment member attached to the attachment frame.

The unit support may include a first device bracket to which the communication device is attached with a device front surface of the communication device facing rearward, and a second device bracket to which the information processing device is attached.

The working machine may further include a lamp member; and a lamp stay to which the lamp member is attached. The unit support may include a lamp stay attachment portion to which the lamp stay is attached.

The seat protector in the working machine may be a cabin surrounding the seat. The unit support may include a support member attached to a pillar of the cabin.

The seat may include a seat portion for a user to sit on and a backrest portion provided at a rear portion of the seat portion such that the backrest portion is reclineable. The communication unit may be located diagonally rearward of the backrest portion and sideward of the backrest portion in a second direction along a machine-body width direction such that the backrest portion does not contact the communication unit even when the backrest portion is reclined.

The working machine may further include a grease gun holder to hold a grease gun including a grease tank to store grease and a discharge pipe to allow the grease to be discharged from the grease tank. The grease gun holder may include a pipe housing tool to house the discharge pipe, and a tank holding tool to elastically hold the grease tank by pressing the grease tank between portions thereof, and the grease gun holder may be attached to the attachment frame such that the pipe housing tool is located below the communication unit and the tank holding tool is located not below the communication unit.

### Advantageous Effects of Invention

With the above-described working machine, by attaching the attached section of the unit bracket to the attaching section of the support bracket in the machine-body width direction, the unit bracket can be easily attached to the support bracket.

With the above-described working machine, by attaching the communication unit and the unit bracket to which the communication unit is attached to the support bracket that supports the console via the attachment bracket, the structure for attaching the communication unit can be made compact.

With the above-described working machine, by providing the communication unit including the information processing device and the communication device rearward of the console including the manual operator, the communication unit can be provided in a useful layout in which communication performance of the communication unit can be ensured and operability of the manual operator can be ensured.

### Brief Description of Drawings

[FIG. 1] FIG. 1 is a perspective view of a working machine according to a first embodiment.
[FIG. 2] FIG. 2 is a perspective view of an operation section.
[FIG. 3] FIG. 3 is a side view of a right console.
[FIG. 4] FIG. 4 is a perspective view of a communication unit, a unit support, and a front portion frame as viewed from above.
[FIG. 5] FIG. 5 is a plan view of the communication unit, the unit support, and the front portion frame.
[FIG. 6] FIG. 6 is a perspective view of the communication unit, the unit support, and a controller support as viewed from the left.
[FIG. 7] FIG. 7 is a front view of the communication unit.
[FIG. 8] FIG. 8 is an exploded perspective view of the communication unit and a unit bracket.
[FIG. 9] FIG. 9 is a perspective view illustrating attachment of the unit bracket.
[FIG. 10] FIG. 10 is a perspective view of the communication unit and the unit bracket as viewed from the rear.
[FIG. 11] FIG. 11 is a side view of the communication unit, the unit support, and the controller support.
[FIG. 12] FIG. 12 is a perspective view of the unit support and a turning base plate.
[FIG. 13] FIG. 13 is a perspective view illustrating attachment of a stay member.
[FIG. 14] FIG. 14 is a perspective view of a support bracket.
[FIG. 15] FIG. 15 is a perspective view of a first bracket.
[FIG. 16] FIG. 16 is a perspective view illustrating attachment of the first bracket.
[FIG. 17] FIG. 17 is a plan view illustrating an attachment portion of the unit support.
[FIG. 18] FIG. 18 is a side view of the communication unit and a meter.
[FIG. 19] FIG. 19 is a side view of a working machine according to a second embodiment.
[FIG. 20] FIG. 20 is a perspective view of a machine body and an operation section.
[FIG. 21] FIG. 21 is a left side view of a turning frame and an attachment portion of a communication unit.
[FIG. 22] FIG. 22 is a right side view of the attachment portion of the communication unit.
[FIG. 23] FIG. 23 is a left side view of the attachment portion of the communication unit.
[FIG. 24] FIG. 24 is a plan view of the attachment portion of the communication unit.
[FIG. 25] FIG. 25 is a perspective view illustrating routing of a harness.
[FIG. 26] FIG. 26 is a view of a communication device as viewed from a back surface of the communication device.
[FIG. 27] FIG. 27 is a perspective view illustrating how a communication unit is attached.
[FIG. 28] FIG. 28 is a perspective view illustrating a structure to attach the communication unit.
[FIG. 29] FIG. 29 is a perspective view of an upper portion of a support bracket.
[FIG. 30] FIG. 30 is a perspective view of an attachment portion of a fixing member.
[FIG. 31] FIG. 31 is a perspective view illustrating a state in which the fixing member is not attached.
[FIG. 32] FIG. 32 is an exploded perspective view of the communication unit and a unit bracket.
[FIG. 33] FIG. 33 is a perspective view of the unit bracket.
[FIG. 34] FIG. 34 is a plan view of an attachment portion of the communication unit when a cabin is mounted.
[FIG. 35] FIG. 35 is a perspective view of an upper portion of a support bracket of an embodiment according to a variation.
[FIG. 36] FIG. 36 is a perspective view of the upper portion of the support bracket of the embodiment according to the variation.
[FIG. 37] FIG. 37 is a side view of a console and its surroundings of a cabin-equipped working machine.
[FIG. 38] FIG. 38 is a perspective view illustrating an attachment structure unit of a communication unit of an embodiment according to a variation.
[FIG. 39] FIG. 39 is a perspective view illustrating the attachment structure unit of the communication unit of the embodiment according to the variation.
[FIG. 40] FIG. 40 is a perspective view of an attachment portion of a support bracket of the embodiment according to the variation.
[FIG. 41] FIG. 41 is a side view of a working machine according to a third embodiment.
[FIG. 42] FIG. 42 is a perspective view of the working machine as viewed obliquely from the rear right.
[FIG. 43] FIG. 43 is a plan view of a machine body and the like.
[FIG. 44] FIG. 44 is a side sectional view of a seat and the rear thereof.
[FIG. 45] FIG. 45 is a perspective view illustrating an overall structure of an attachment portion of a communication unit.
[FIG. 46] FIG. 46 is a perspective view of the attachment portion of the communication unit.
[FIG. 47] FIG. 47 is a back view of the attachment portion of the communication unit.
[FIG. 48] FIG. 48 is a perspective view illustrating routing of a harness of the communication unit.
[FIG. 49] FIG. 49 is a back view of a DCU.
[FIG. 50] FIG. 50 is a side view of the attachment portion of the communication unit.
[FIG. 51] FIG. 51 is an exploded perspective view of a unit support.
[FIG. 52] FIG. 52 is an exploded perspective view illustrating an attachment structure of the DCU.
[FIG. 53] FIG. 53 is an exploded perspective view illustrating an attachment structure of an IPU.
[FIG. 54] FIG. 54 is a side view illustrating the positional relationship between the seat and the communication unit.
[FIG. 55] FIG. 55 is a plan view illustrating the positional relationship between the seat and the communication unit.
[FIG. 56] FIG. 56 is a back view of a machine body and a cabin of an embodiment according to a variation.
[FIG. 57] FIG. 57 is a perspective view of the cabin as viewed obliquely from the rear left.
[FIG. 58] FIG. 58 is a perspective view of the cabin as viewed from below.
[FIG. 59] FIG. 59 is a perspective view of a top plate and an attachment frame.
[FIG. 60] FIG. 60 is a side view of an attachment portion of the communication unit.
[FIG. 61] FIG. 61 is a front view of the communication unit, a grease gun holder, and the like.
[FIG. 62] FIG. 62 is a perspective view of the grease gun holder.
[FIG. 63] FIG. 63 is a perspective view of an attachment structure of the communication unit.
[FIG. 64] FIG. 64 is a perspective view of a unit support as viewed from a back surface.
[FIG. 65] FIG. 65 is a perspective view of the unit support as viewed from a front surface.

### Description of Embodiments

Hereinafter, embodiments of the present invention will be described with reference to the drawings as appropriate.

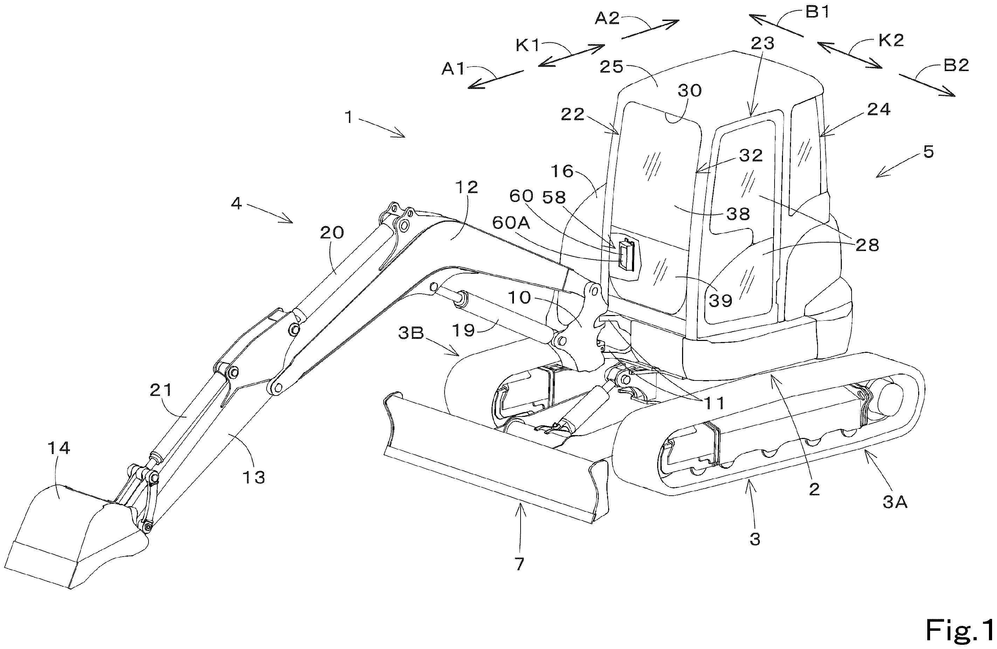

FIGS. 1 to 18 illustrate a first embodiment.

FIG. 1 is a perspective view illustrating an overall configuration of a working machine 1 according to the first embodiment. In the first embodiment, a backhoe, which is a turning working machine, is exemplified as the working machine 1.

As illustrated in FIG. 1, the working machine 1 includes a machine body (turning base) 2, a traveling device 3, and a front working device (working device) 4. A cabin 5 is mounted on the machine body 2.

In the first embodiment, the working machine (cabin-equipped working machine) 1 in which a communication unit 58 (DCU 60 and IPU 59) (described later) is mounted inside the cabin 5 mounted on the machine body 2 is exemplified, but a working machine (canopy-equipped working machine) 1 in which a canopy is mounted on a machine body 2 instead of the cabin 5 may be used, or a working machine 1 not including the cabin 5 or the canopy may be used.

In the first embodiment, as illustrated in FIG. 1, a direction indicated by arrow A1 is referred to as a forward side, a direction indicated by arrow A2 is referred to as a rearward side, and a direction indicated by arrow K1 is referred to as a front-rear direction. Also, a direction indicated by arrow B1 is referred to as a leftward direction, a direction indicated by arrow B2 is referred to as a rightward direction, and a direction indicated by arrow K2 is referred to as a machine-body width direction. The machine-body width direction K2 is a horizontal direction orthogonal to the front-rear direction K1.

Also, a direction from a central portion of the machine body 2 in the width direction toward the rightward side or the leftward side is referred to as an outward side in the machine-body width direction (outward in the machine-body width direction). A direction opposite to the outward side in the machine-body width direction is referred to as an inward side in the machine-body width direction (inward in the machine-body width direction).

As illustrated in FIG. 1, the traveling device 3 is a crawler type traveling device including a first crawler travel unit 3A provided on one of opposite sides (left) of the machine body 2 in the machine-body width direction K2 and a second crawler travel unit 3B provided on the other of the opposite sides (right) of the machine body 2 in the machine-body width direction K2. The machine body 2 is supported by the traveling device 3 so as to be able to travel. Also, the machine body 2 is supported on the traveling device 3 so as to be turnable about a vertical axis (an axis extending in an up-down direction). A dozer device 7 is attached to a front portion of the traveling device 3.

As illustrated in FIG. 1, the front working device 4 is located forward of the cabin 5. Also, the front working device 4 is attached to a front portion of the machine body 2. Specifically, the front working device 4 is supported by a swing bracket 10 so as to be swingable upward/downward. The swing bracket 10 is supported by a support bracket 11 so as to be rotatable about a vertical axis. The support bracket 11 is fixed to the machine body 2 and protrudes forward from the machine body 2.

Additionally, the front working device 4 includes a boom 12, an arm 13, and a working tool (bucket) 14. The boom 12 has a proximal portion pivotally supported by an upper portion of the swing bracket 10 so as to be rotatable and is swingable in the up-down direction. The arm 13 has a proximal portion pivotally supported by a distal end portion of the boom 12 so as to be rotatable and is swingable in a direction toward the boom 12 and in a direction away from the boom 12. The working tool 14 is pivotally supported by a distal end portion of the arm 13 so as to be rotatable and is swingable in a direction toward the arm 13 and in a direction away from the arm 13.

Additionally, the front working device 4 includes a boom cylinder 19 that drives the boom 12, an arm cylinder 20 that drives the arm 13, and a working tool cylinder 21 that drives the working tool 14. The boom cylinder 19, the arm cylinder 20, and the working tool cylinder 21 include hydraulic cylinders.

As illustrated in FIG. 1, the cabin 5 includes, in a front surface, a front window 22 including a glass (front surface glass) 32 fitted to close a window opening 30. The front surface glass 32 includes an upper portion glass 38 provided in an upper portion of the window opening 30 and a lower portion glass 39 provided in a lower portion of the window opening 30. Additionally, the cabin 5 includes an entrance door 23 in a front portion of a left side surface. The entrance door 23 includes glasses (door glasses) 28 in an upper portion and a lower portion. Additionally, the cabin 5 includes a side portion window 24 in a rear portion of the left side surface, and a roof 25 at an upper surface.

The cabin 5 includes a rear portion window in a rear surface, and a side portion window (right side portion window) in a right side surface. The rear portion window and the right side portion window also include glasses that close window openings in window frames defining the window openings. Each of the glasses provided in the front surface, the rear surface, the left side surface, and the right side surface of the cabin 5 has light transmissivity.

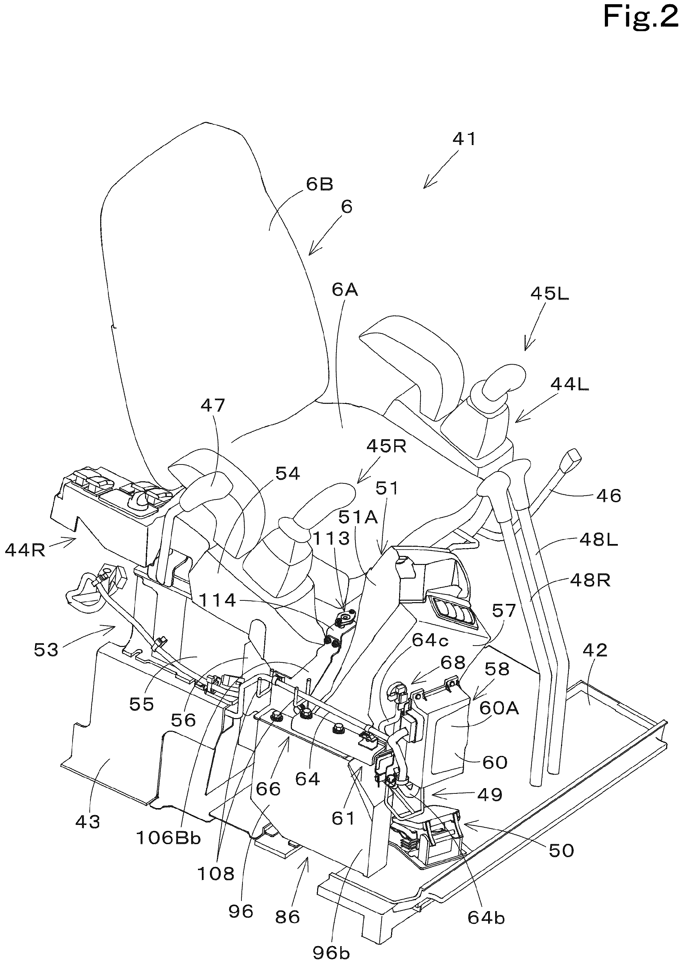

FIG. 2 illustrates an operation section 41 including a seat 6 on which a user (driver) sits. The operation section 41 is located in (inside) the cabin 5. The operation section 41 includes a floor portion 42 attached to the machine body 2. The operation section 41 is surrounded by the cabin 5. That is, the operation section 41 is located in the cabin 5.

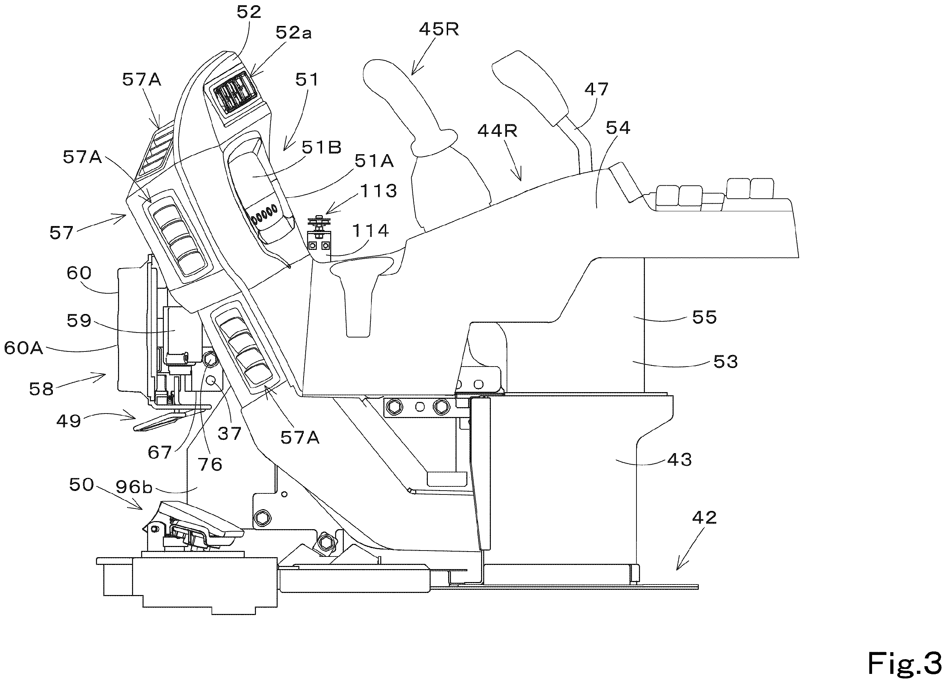

As illustrated in FIGS. 2 and 3, the operation section 41 includes a seat base 43 to which the seat 6 is attached. The seat base 43 is attached to the floor portion 42. Thus, the operation section 41 (seat 6) is mounted on the machine body 2. As illustrated in FIG. 2, the seat 6 includes a seat portion 6A for the user to sit on (supporting the buttocks of the user) and a backrest portion 6B that supports the back of the user. A forward side is the front of the user seated on the seat 6.

As illustrated in FIG. 2, the operation section 41 includes a console (operator base) 44L located outward (sideward) of the seat 6 in a first direction along the machine-body width direction K2, and a console (operator base) 44R located outward (sideward) of the seat 6 in a second direction along the machine-body width direction K2. Specifically, the console 44L is located leftward of the seat 6, and the console 44R is located rightward of the seat 6.

The console 44L is provided with an unloading lever 46 and a manual operator 45L. The unloading lever 46 can swing upward from a state illustrated in FIG. 2. In a state in which the unloading lever 46 has swung upward, a hydraulic fluid cannot be supplied to a hydraulic device. The console 44R is provided with various switches, a manual operator 45R, and a dozer lever 47 that operates the dozer device 7.

The left manual operator 45L and the right manual operator 45R each can operate two operation targets. For example, the manual operator 45L can perform a turn operation of the machine body 2 and a swing operation of the arm 13. The manual operator 45R can perform a swing operation of the boom 12 and a swing operation of the working tool 14.

As illustrated in FIG. 2, the operation section 41 includes two traveling levers 48L and 48R located forward of the seat 6. The two traveling levers 48L and 48R are arranged in the machine-body width direction K2. The left traveling lever 48L can operate the first crawler travel unit 3A, and the right traveling lever 48R can operate the second crawler travel unit 3B. A pedal member 50 that is depressed by the user seated on the seat 6 is provided rightward of the traveling levers 48L and 48R. In the first embodiment, the pedal member 50 is a swing pedal. The swing pedal 50 is an operation member that operates a hydraulic cylinder that swings the swing bracket 10.

As illustrated in FIG. 3, a meter 51 is provided at a front portion of the console 44R. The meter 51 is provided in an inclined manner such that the meter 51 extends diagonally forward and upward. The meter 51 includes a meter cover 51A and a display (including a liquid crystal screen or the like) 51B provided at a rear surface of the meter cover 51A. A duct portion 52 including a blowout portion 52a that blows out conditioned air of an air conditioner is provided at an upper portion of the meter cover 51A. The display 51B is provided so as to face the user seated on the seat 6. The display 51B can display, for example, basic information on the working machine 1, images of the surroundings of the working machine 1, information required for making various settings of the working machine 1, and the like.

As illustrated in FIG. 2, the console 44R includes a console frame 53 that supports the various switches provided at the console 44R, the manual operator 45R, the dozer lever 47, a console cover 54, and the meter 51. The console frame 53 is attached to the seat base 43. Thus, the console frame 53 (console 44R) is fixed to the machine body 2 via the seat base 43 and the floor portion 42. The console frame 53 includes a rear portion frame 55 defining a rear portion and a front portion frame 56 defining a front portion.

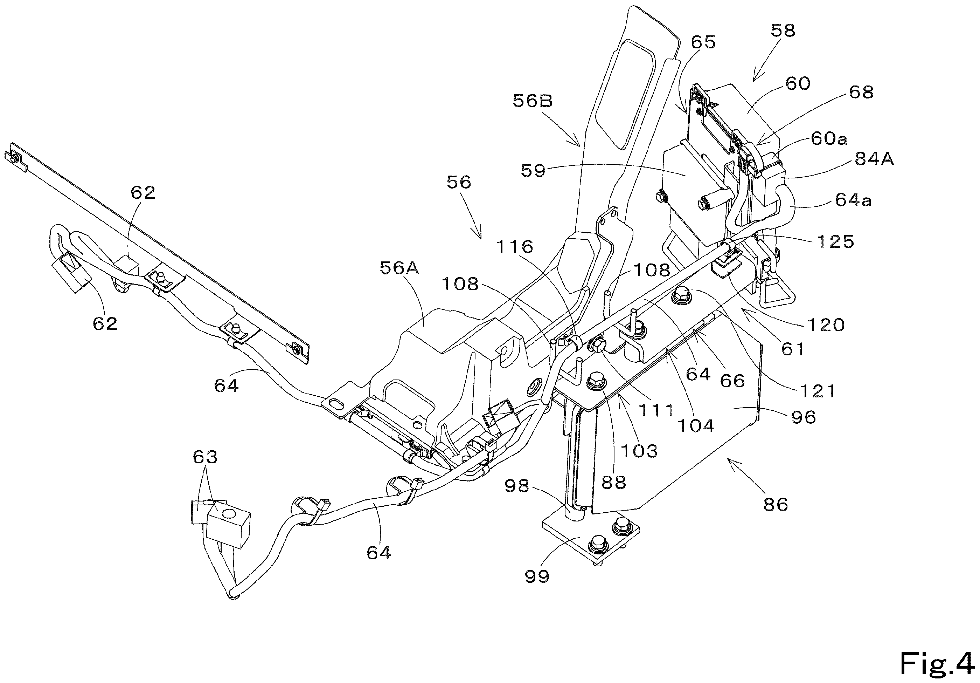

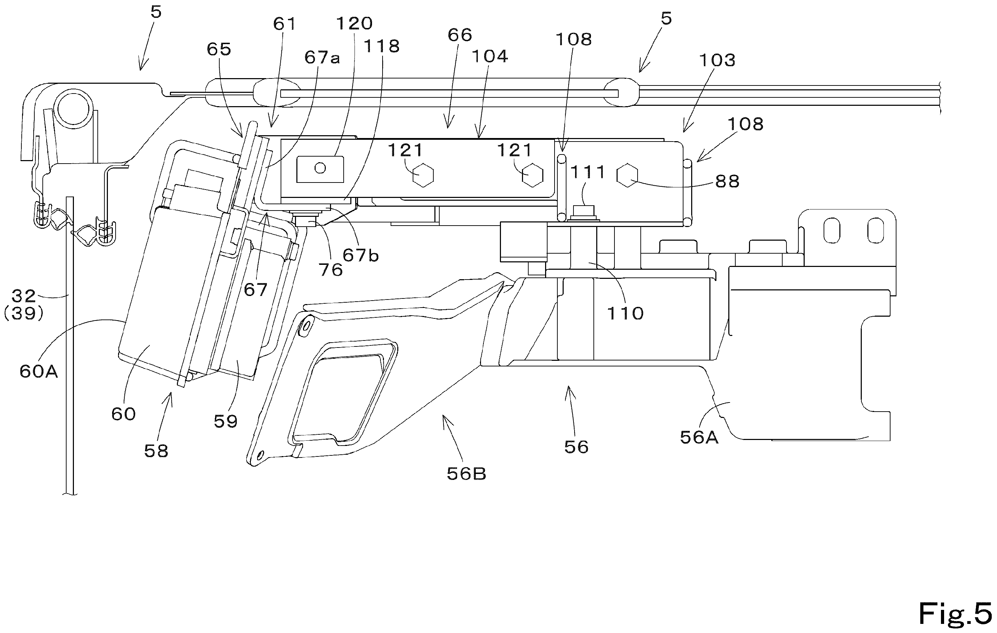

As illustrated in FIGS. 4 and 5, the front portion frame 56 includes a main frame 56A and a meter frame 56B attached to a front portion of the main frame 56A. The meter cover 51A and the display 51B are attached to the meter frame 56B.

As illustrated in FIGS. 2 and 3, an air conditioner duct 57 that circulates the conditioned air is located forward of the meter 51. The air conditioner duct 57 extends from an air conditioner body provided inside the seat base 43 toward a front surface of the meter 51. The air conditioner duct 57 is provided with blowout portion(s) 57A that blows out the conditioned air. The duct portion 52 communicates with the air conditioner duct 57.

In the working machine 1 in which the cabin 5 is not mounted, the air conditioner duct 57 and the duct portion 52 are not provided.

As illustrated in FIG. 2, the operation section 41 (working machine 1) is provided with the communication unit 58. The communication unit 58 is installed in the vicinity of an outer edge portion of the operation section 41. In the first embodiment, the communication unit 58 is provided inside the cabin 5, above a right and front portion of the machine body 2 (operation section 41).

As illustrated in FIGS. 4, 5, and 6, the communication unit 58 includes an information processing unit (IPU, information collection unit) 59 and a direct communication unit (DCU) 60.

The IPU 59 is an "information processing device" that temporarily stores information relating to the working machine 1 and performs predetermined processing (for example, compression processing and/or the like). As illustrated in FIG. 4, the IPU 59 is connected to a communication port of an on-board communication network, a communication port of on-board diagnostics (OBD), and the like (not illustrated) via a harness 64 and connector(s) 62, and receives information relating to the working machine 1 from the communication network or the on-board diagnostics. The harness 64 includes a plurality of (a large number of) bundled electric wires (wiring). The communication ports of the on-board communication network and the on-board diagnostics are located inside the seat base 43. One of the connectors 62 is connected to the communication port of the on-board communication network, and the other of the connectors 62 is connected to the communication port of the on-board diagnostics.

The on-board communication network includes a controller area network (CAN), a FlexRay, or the like mounted on the working machine 1. Also, the IPU 59 is connected to the DCU 60 via the harness 64, and transmits data to the DCU 60.

The DCU 60 is a "communication device" that performs communication using data with an external device (not illustrated). The DCU 60 receives data from and transmits data to the IPU 59. Also, the DCU 60 transmits data received from the IPU 59 and data such as position information to a server. Examples of the server include a server installed in a manufacturer (manufacturing company) that manufactures the working machine 1, a server installed in a dealer (sales and maintenance company) that sells and maintains the working machine 1, and the like.

The IPU 59 and the DCU 60 are connected to a power supply port (not illustrated) via a harness 64 and connectors 63. Power is supplied from the power supply port. Also, the IPU 59 is connected to a connection port of a harness (not illustrated) of the cabin 5 via the harness 64 and the connector 63. The communication ports, the power supply port, and the connection port are located in the operation section 41. One of the connectors 63 is connected to the power supply port, and the other of the connectors 63 is connected to the connection port of the harness of the cabin 5.

As illustrated in FIG. 1, the DCU 60 is located in the vicinity of the outer edge portion of the operation section 41 such that a device front surface 60A faces outward of the machine body 2 (machine-body outward side). In the first embodiment, as illustrated in FIG. 5 and the like, the DCU 60 is located such that the device front surface 60A faces forward.

As illustrated in FIGS. 2 and 3, in the first embodiment, the DCU 60 and the IPU 59 are located forward of the console 44R. Specifically, the DCU 60 and the IPU 59 are located forward of and lower than the meter 51 and the air conditioner duct 57. By providing the DCU 60 and the IPU 59 forward of and lower than the meter 51 and the air conditioner duct 57, it is possible to eliminate or reduce the likelihood that the DCU 60 and the IPU 59 will hinder the use's view. Also, as illustrated in FIGS. 1 and 5, the DCU 60 is located inside the cabin 5 such that the device front surface 60A faces a glass surface (front surface glass 32 or the like) provided in the cabin 5. Specifically, the DCU 60 is located inside the cabin 5 such that the device front surface 60A faces the lower portion glass 39 of the front window 22. Specifically, the DCU 60 is located in the vicinity of the lower portion glass 39 inside the cabin 5 such that the device front surface 60A faces forward and is located so as to protrude inward in the machine-body width direction from a right edge portion of the window opening 30 of the front window 22.

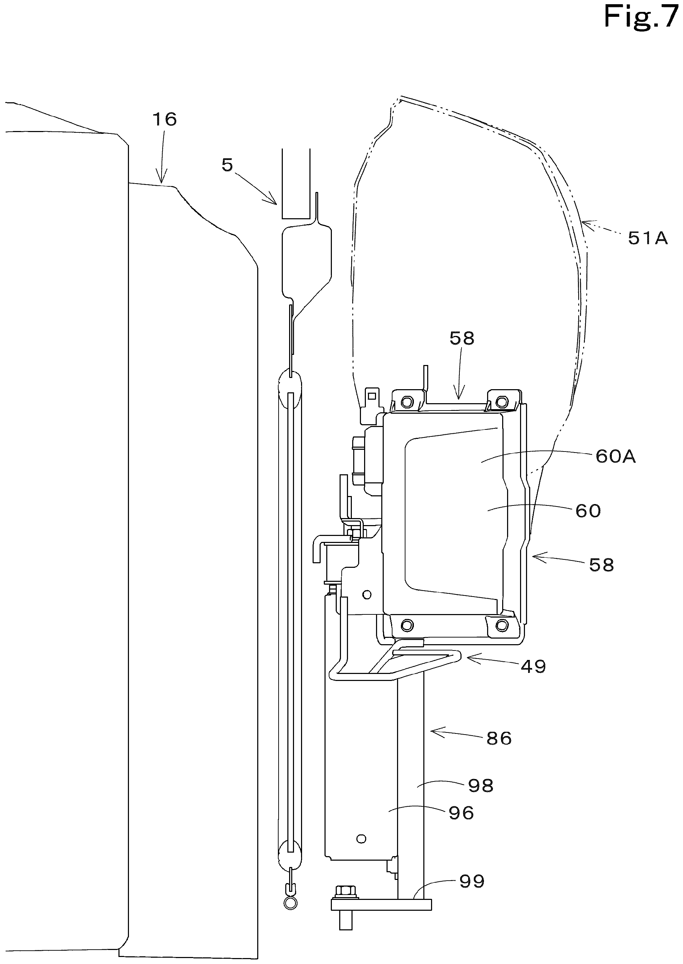

As illustrated in FIG. 7, the DCU 60 has a substantially rectangular parallelepiped shape in which the device front surface 60A is substantially rectangular and is located vertically such that the longitudinal direction of the rectangular parallelepiped coincides with the up-down direction. The DCU 60 is located above the floor portion 42 of the operation section 41 with a space therebetween as illustrated in FIG. 2 and is positioned in an inclined manner such that the DCU 60 extends diagonally forward and inward (leftward) along the machine-body width direction in plan view as illustrated in FIG. 5.

As illustrated in FIG. 2, the swing pedal 50 is provided on a front and right portion of the floor portion 42. The DCU 60 is located near the swing pedal 50. The DCU 60 is separated upward from the floor portion 42 and is located obliquely, so that the DCU 60 does not hinder a foot operation of the user who operates the swing pedal 50 with the foot.

As illustrated in FIGS. 4, 5, and 6, the IPU 59 is located at the same side of the DCU 60 as the device back surface of the DCU 60, i.e., located at the opposite side of the DCU 60 from the device front surface 60A (in the first embodiment, located rearward of the DCU 60).

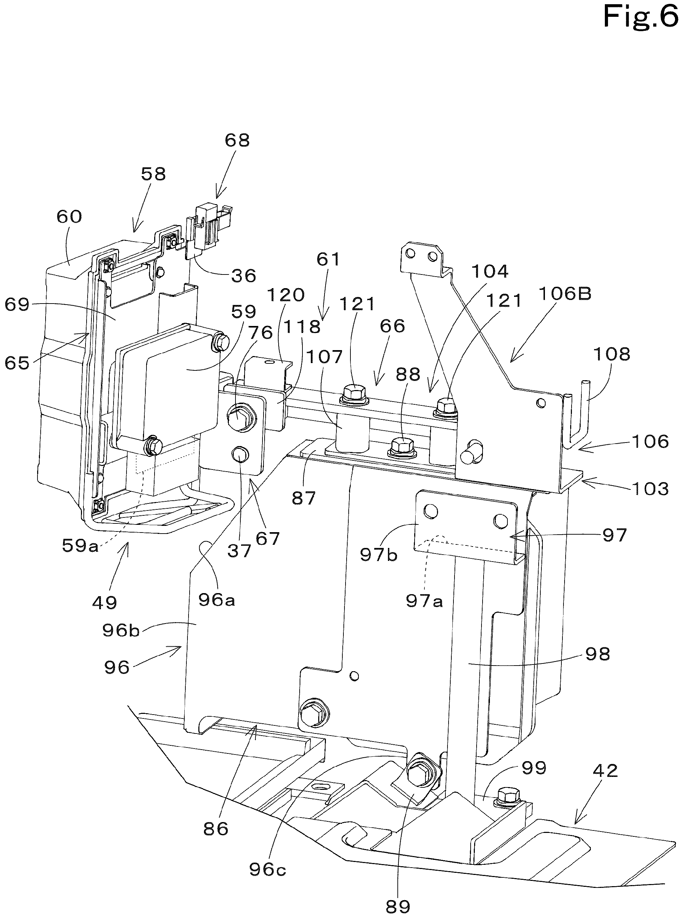

As illustrated in FIGS. 4 and 6, the working machine 1 includes a unit support 61 for attaching the communication unit 58 (IPU 59 and DCU 60) directly or indirectly to the machine body 2.

The unit support 61 includes a unit bracket 65 to which the communication unit 58 (DCU 60 and IPU 59) is attached, and a support bracket 66 to which the unit bracket 65 is attached.

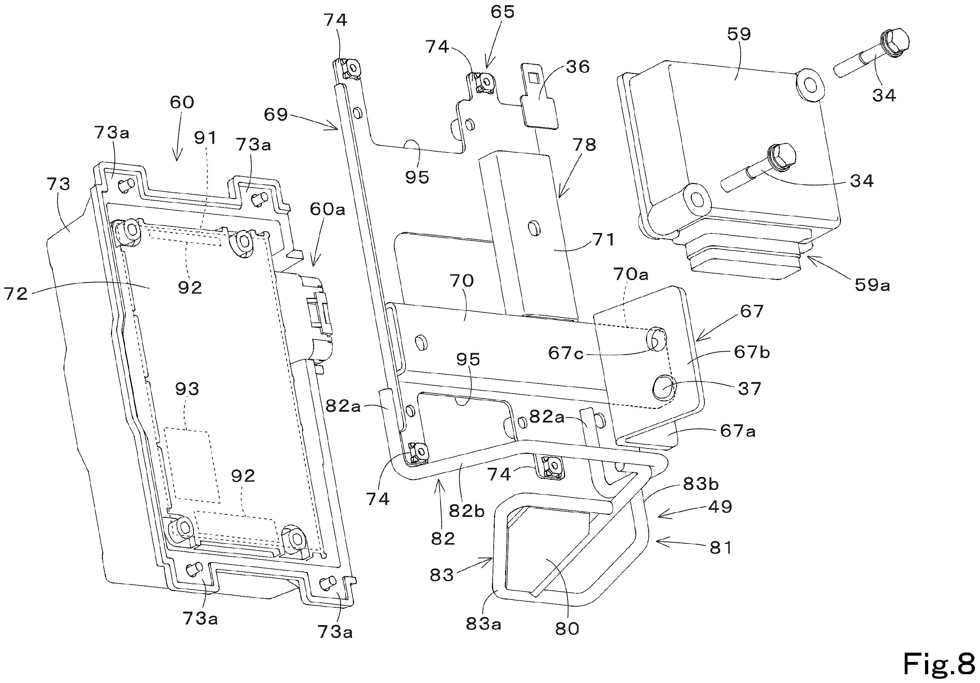

As illustrated in FIG. 8, the unit bracket 65 includes a first device attachment member 69 to which the DCU 60 is attached, a second device attachment member 78 to which the IPU 59 is attached, an attachment stay (attached section) 67 that is attached to the support bracket 66, and a guard member 49 that guards the harness 64.

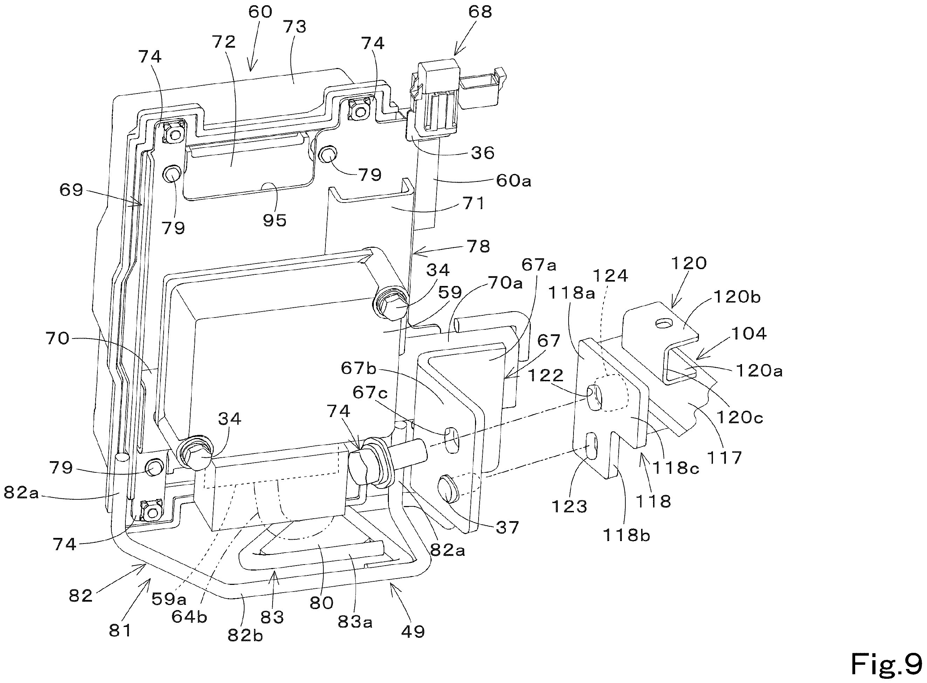

The first device attachment member 69 is, for example, a plate member made of a metal plate material. Hereinafter, the first device attachment member 69 is referred to as a plate member. The plate member 69 is attached to the device back surface of the DCU 60. Specifically, as illustrated in FIGS. 8 and 9, the DCU 60 includes a case 72 and a cover 73 that covers the case 72 from the device front surface 60A. The plate member 69 includes a plurality of cover attachment portions 74. Attachment pieces 73a at four corners of the cover 73 are attached to the cover attachment portions 74 by bolts or the like. The case 72 is also attached to the plate member 69 by screws 79 or the like.

As illustrated in FIG. 8, the DCU 60 includes an electronic substrate 91 housed in the case 72. The case 72 is in a substantially rectangular parallelepiped shape. The electronic substrate 91 has, attached on its front side (obverse side) on which electronic components are attached, communication antenna(s) (for example, a 3G antenna and/or the like) 92 and a positioning antenna (GPS antenna) 93. The electronic substrate 91 is housed in the case 72 such that the obverse side faces in the same direction as the device front surface 60A. The at least one communication antenna 92 is an antenna for communication with a server and includes communication antennas 92 provided at an upper portion and a lower portion of the electronic substrate 91. The communication antennas 92 are contained in the DCU 60. In the DCU 60 of the first embodiment, since the communication antennas 92 are contained in the DCU 60, when an illegal act such as theft (an act of removing the DCU 60, or the like) is being performed, a communicable state can be maintained and a report can be made to a predetermined report destination.

The positioning antenna 93 receives satellite signal(s) transmitted from positioning satellite(s). The positioning antenna 93 is provided at a lower right portion of the electronic substrate 91. The working machine 1 detects its own position (measured position information including latitude and longitude) by a positioning system based on the satellite signals received by the positioning antenna 93. Specifically, the working machine 1 determines the position and the orientation of the working machine 1 by using a known global positioning system (GPS) that is an example of a global navigation satellite system (GNSS) (for example, by an RTK-GPS suitable for position measurement of a moving body). That is, the working machine 1 communicates with a base station (reference station) installed at a known position, and the base station transmits measured position data (correction information) obtained by receiving radio waves from the positioning satellites to the working machine 1. The working machine 1 detects its own position (latitude and longitude) based on measured position data obtained by receiving the radio waves from the positioning satellites and the measured position data from the base station. The DCU 60 transmits and receives position information.

As illustrated in FIG. 8, the DCU 60 includes a connection portion 60a to have the harness 64 connected thereto. The connection portion 60a is provided rightward of an upper portion of the case 72. Additionally, the plate member 69 is provided with a stay member 36 to which a fuse 68 for the DCU 60 (see FIG. 9) is attached. The stay member 36 is fixed to a right and upper portion.

As illustrated in FIGS. 8 and 9, the plate member 69 covers a back surface of the case 72. Thus, the case 72 is housed between the cover 73 and the plate member 69.

As illustrated in FIG. 8, the plate member 69 has cutouts 95 corresponding to the communication antennas 92. The communication antennas 92 have directivity in the plate thickness direction of the electronic substrate 91. The cover 73 is made of resin, and the portions of the plate member 69 corresponding to the communication antennas 92 are cut out so as not to disturb radio wave directivity of the communication antennas 92. The IPU 59 is located on a back surface of the plate member 69 at a position shifted with respect to the cutouts 95. Accordingly, the IPU 59 does not disturb the radio wave directivity of the communication antennas 92.

As illustrated in FIGS. 8 and 9, the second device attachment member 78 includes a first member 70 and a second member 71. The first member 70 and the second member 71 are made of channel steels.

The first member 70 is positioned horizontally (to extend in the horizontal direction) with an opening facing the plate member 69 (forward) and is fixed to a lower portion of a rear surface of the plate member 69. Additionally, the first member 70 includes a protruding portion 70a protruding rightward from the plate member 69. The second member 71 is positioned vertically (to extend in the up-down direction) with an opening facing the plate member 69 (forward) and is fixed to a right and upper portion of the rear surface of the plate member 69. Also, a lower end of the second member 71 is fixed to the first member 70.

As illustrated in FIGS. 8 and 9, the IPU 59 is attached to a left portion of the first member 70 and a middle portion in the up-down direction of the second member 71 by fixing tools 34 such as bolts. The IPU 59 includes, at a lower side thereof, a connection portion 59a to have the harness 64 connected thereto.

As illustrated in FIGS. 8, 9 and 10, the attachment stay 67 is made of a plate material and includes a first wall 67a attached to the protruding portion 70a of the first member 70 and a second wall 67b extending from the first wall 67a.

The first wall 67a is provided such that a front surface faces a back surface of the protruding portion 70a of the first member 70, and is overlapped with the back surface of the protruding portion 70a and fixed by welding or the like.

The second wall 67b extends rearward from a left end of the first wall 67a such that plate surfaces face in the machine-body width direction K2 (see FIG. 5). Thus, the attachment stay 67 includes a wall portion (second wall 67b) with plate surfaces facing in the machine-body width direction K2.

As illustrated in FIG. 9, an insertion hole (bolt insertion hole) 67c in the form of a circular hole passes through an upper portion of the second wall 67b. An attachment tool 76 that attaches (fastens) the attachment stay 67 (attached section) to an attachment plate (attaching section) 118 (described later) is inserted through the insertion hole 67c (see FIG. 9). The attachment tool 76 includes a bolt.

The attachment stay (attached section) 67 is provided with a pin 37. The pin 37 is provided at a lower portion of the second wall 67b. Specifically, the pin 37 penetrates the second wall 67b from the left to the right, and protrudes outward from the second wall 67b in the machine-body width direction K2. The pin 37 is fixed to the second wall 67b by welding or the like.

As illustrated in FIGS. 8 and 9, the guard member 49 includes a guard plate 80 located below the connection portion 59a of the IPU 59, and a support member 81 that supports the guard plate 80 to the plate member 69. The support member 81 is made of a wire rod and includes a holding member 83 to which the guard plate 80 is fixed, and a support arm 82 that supports the holding member 83 to the plate member 69.

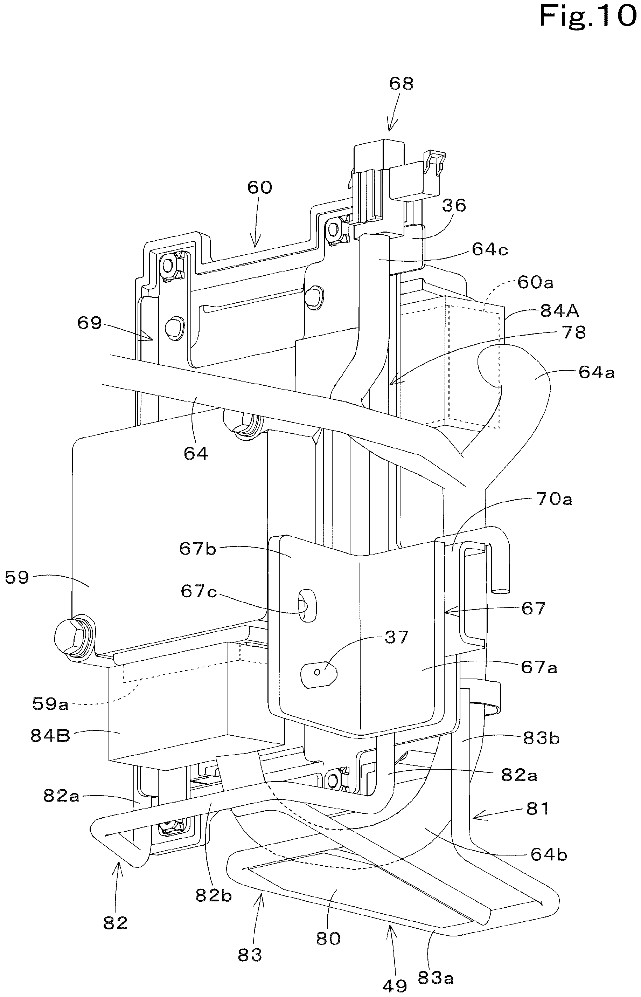

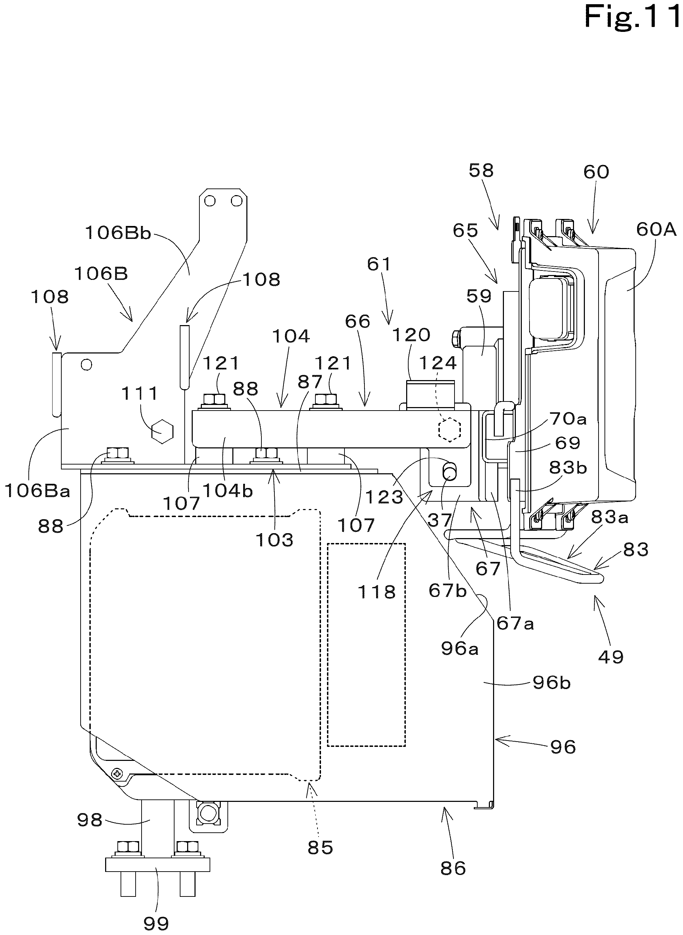

The holding member 83 includes a first section 83a that surrounds the guard plate 80 and to which the guard plate 80 is fixed, and a second section 83b (see FIGS. 10 and 11) that extends from the first section 83a and is fixed to the plate member 69.

The support arm 82 includes a pair of fixing portions 82a fixed to a left portion and a right portion of a lower portion of the plate member 69, and a coupling portion 82b coupling the pair of fixing portions 82a. The first section 83a of the holding member 83 is coupled to the coupling portion 82b.

As illustrated in FIG. 10, the harness 64 is branched into a branch portion 64a connected to the connection portion 60a via a connector 84A, a branch portion 64b connected to the connection portion 59a via a connector 84B, and a branch portion 64c connected to the fuse 68, in the vicinity of and rightward of the communication unit 58.

The guard member 49 is located below the branch portion 64b of the harness 64 connected to the connection portion 59a, and, for example, prevents the foot of the user who operates the swing pedal 50 from contacting the harness 64 (branch portion 64b).

As illustrated in FIG. 2, the support bracket 66 is located outward of the console 44R (meter 51) in the machine-body width direction K2 and is attached directly or indirectly to the machine body 2. Specifically, in the first embodiment, the support bracket 66 is located at the opposite side (rightward) of the console 44R from the seat 6. In other words, as illustrated in FIGS. 4 and 5, the support bracket 66 is located rightward of the front portion frame 56. Also, the support bracket 66 is provided along the meter frame 56B and the main frame 56A so as to extend rearward from the right of the communication unit 58, and such that a front portion is located rightward of the attachment stay 67 and a rear portion is located rightward of the main frame 56A.

As illustrated in FIG. 11, the support bracket 66 is attached to a controller support 86 that supports a controller 85 provided in the working machine 1. The support bracket 66 is attached directly or indirectly to the machine body 2 via the controller support 86. The controller 85 is, for example, a prime mover controller (engine electric control unit (ECU)) that controls a prime mover (engine).

The controller support 86 covers and supports the controller 85 and is attached directly or indirectly to the machine body 2.

As illustrated in FIGS. 6 and 11, the controller support 86 includes a cover member 96 that covers and attaches the controller 85, a stay member 97 fixed to the cover member 96, a pillar member 98 that supports the stay member 97, and a base member 99 fixed to a lower end portion of the pillar member 98.

As illustrated in FIG. 11, a reinforcing plate 87 is fixed to an upper surface of the cover member 96. Specifically, the reinforcing plate 87 is fixed to the upper surface of the cover member 96 by a pair of front and rear bolts (fixing tools) 88 provided apart from each other in the front-rear direction K1. The cover member 96 includes, in a front portion, a constituent portion 96b including an inclined upper surface (inclined surface) 96a that extends forward of the reinforcing plate 87 and that extends diagonally downward and forward.

As illustrated in FIG. 6, an attached piece 96c protruding downward is provided at a rear and lower portion of an inner surface in the machine-body width direction of the cover member 96. The attached piece 96c is fixed to an attaching piece 89 fixed to the floor portion 42 by a bolt or the like.

As illustrated in FIG. 6, the stay member 97 includes a lower wall 97a fixed to the inner surface (left surface) in the machine-body width direction of the cover member 96 and protruding inward (leftward) in the machine-body width direction from the cover member 96, and a vertical wall 97b extending upward from a protruding-side end portion (left end) of the lower wall 97a.

The pillar member 98 is located below the stay member 97 so as to extend in the up-down direction. An upper end of the pillar member 98 is fixed to the lower wall 97a.

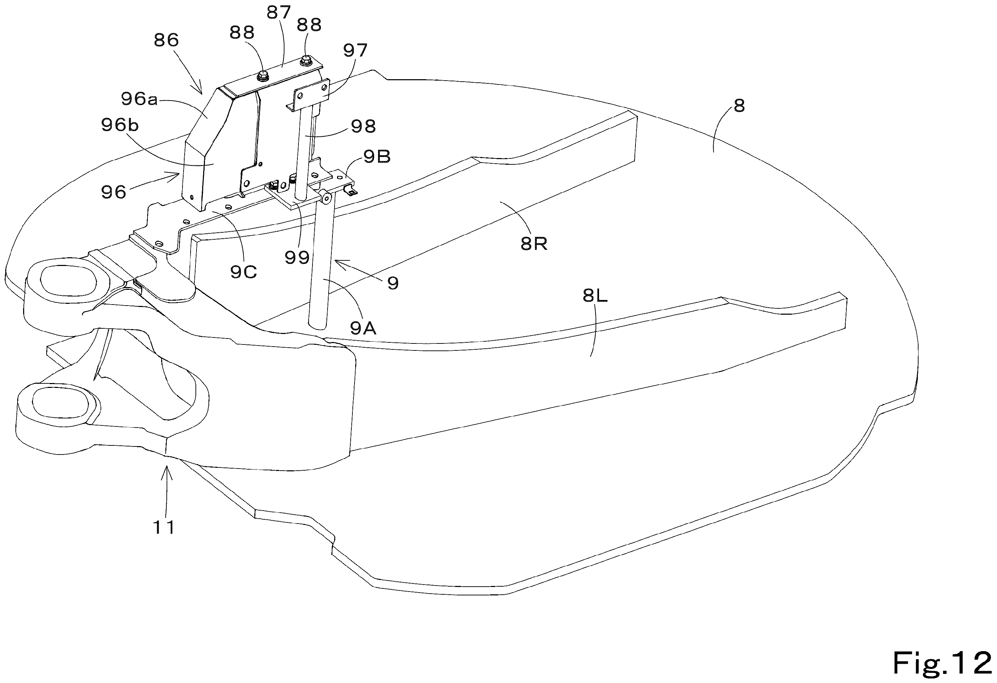

As illustrated in FIG. 12, the base member 99 is attached to a support member 9 fixed to a turning base plate 8. The turning base plate 8 is made of a thick plate material defining a bottom portion of the machine body (turning base) 2. The support bracket 11 is fixed to a front portion of the turning base plate 8. A left vertical rib 8L and a right vertical rib 8R extending rearward from the support bracket 11 are fixed to an upper surface of the turning base plate 8. The support member 9 includes a pillar member 9A vertically provided on the turning base plate 8, a stay member 9B fixed to an upper end of the pillar member 9A, and a plate member 9C provided to extend from the stay member 9B to the support bracket 11. The base member 99 is fixed to the plate member 9C by a bolt or the like. Thus, the controller support 86 is attached directly or indirectly to the machine body 2.

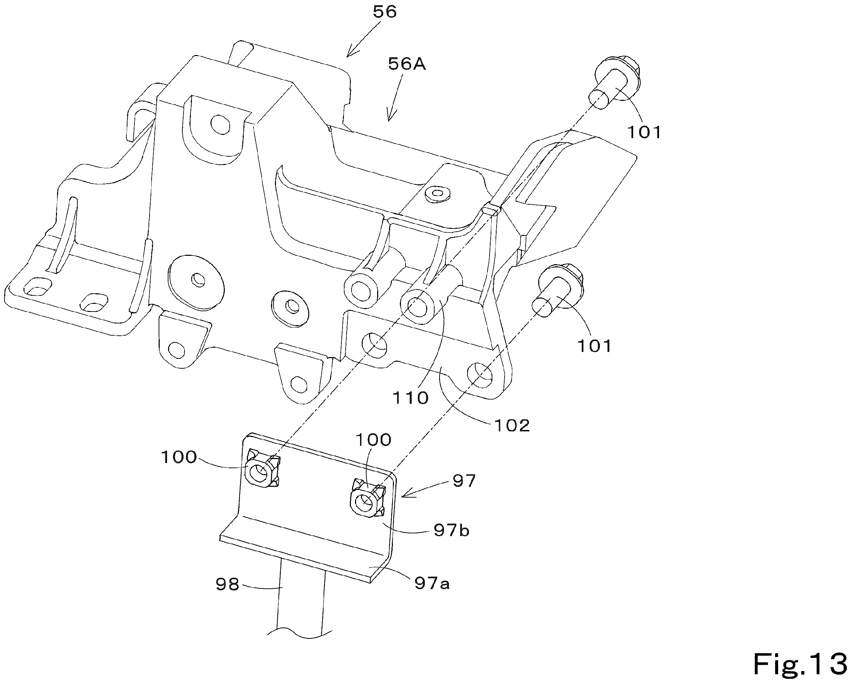

As illustrated in FIG. 13, a pair of front and rear nut members 100 are fixed to a right surface of the vertical wall 97b of the stay member 97. An attachment portion 102 is provided at a front and lower portion of the main frame 56A. The vertical wall 97b of the stay member 97 is overlapped with the attachment portion 102 from the right and is fixed by bolt members 101 that penetrate the attachment portion 102 and the vertical wall 97b and are screwed into the nut members 100. Accordingly, the front portion frame 56 is supported by the controller support 86.

As illustrated in FIGS. 6, 11, and 14, the support bracket 66 includes a first bracket 103 and a second bracket 104.

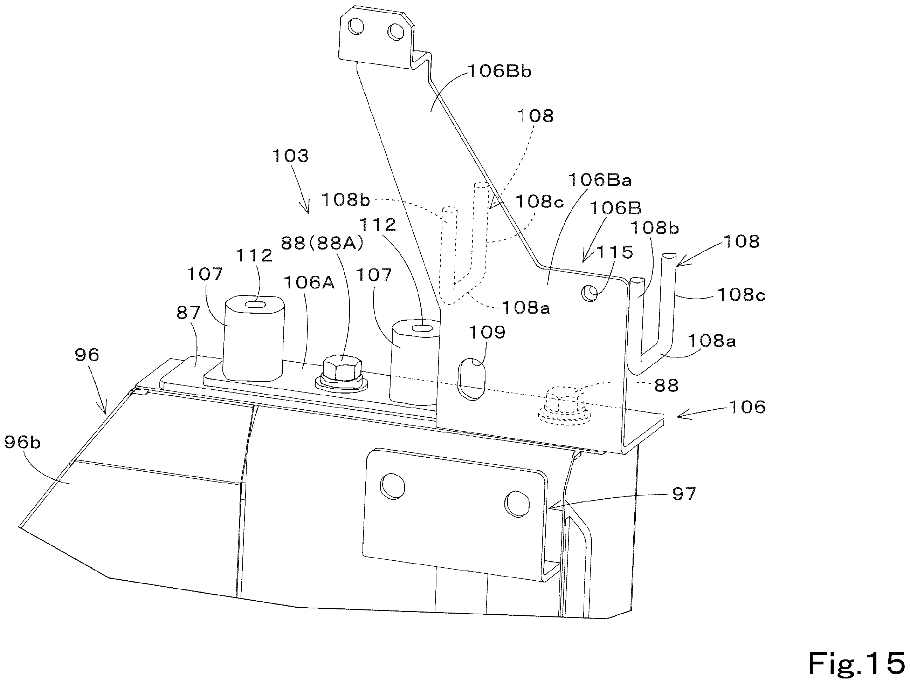

As illustrated in FIG. 15, the first bracket 103 includes a base member 106, a pair of front and rear bracket attachment portions 107, and a pair of front and rear harness guides 108.

The base member 106 is made of a plate material and includes a base body 106A and a vertical wall portion 106B.

The base body 106A is in a flat plate shape elongated in the front-rear direction with plate surfaces facing in the up-down direction. The base body 106A is overlapped with the reinforcing plate 87 and fixed to the cover member 96 of the controller support 86 by being fastened together by the bolts 88 that fix the reinforcing plate 87.

As illustrated in FIG. 15, the vertical wall portion 106B includes an attachment stay portion 106Ba extending upward from a left end of a rear portion of the base body 106A, and an attachment bracket portion 106Bb extending upward from the attachment stay portion 106Ba.

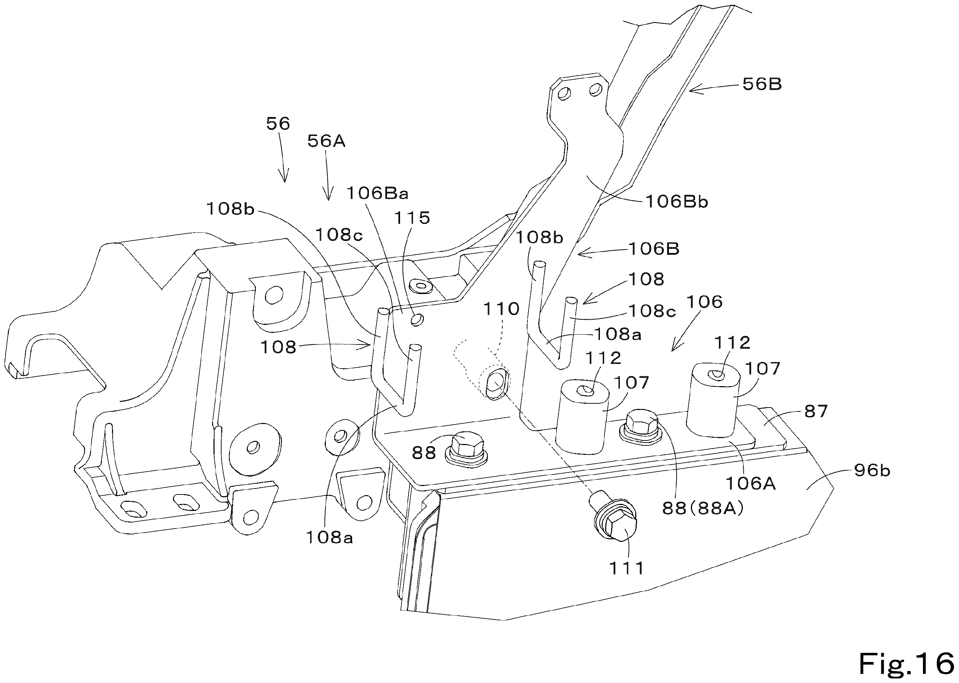

As illustrated in FIG. 15, the attachment stay portion 106Ba has an insertion hole 109 which is a long hole elongated in the up-down direction. In the first embodiment, the insertion hole 109 is in a front portion of the attachment stay portion 106Ba. However, this does not imply any limitation. As illustrated in FIG. 16, the attachment stay portion 106Ba is fixed to the front portion frame 56 by a bolt 111 that is inserted through the insertion hole 109 and screwed into an attachment portion 110 provided at the main frame 56A. As illustrated in FIG. 13, the attachment portion 110 includes a tubular boss and is provided higher than the attachment portion 102. A holding hole 115 to which a holding tool 116 (see FIG. 4) that holds the harness 64 is attached is in an upper and rear portion of the attachment stay portion 106Ba.

As illustrated in FIGS. 2 and 3, a stay 114 for attaching a level gauge (level) 113 is attached to an upper portion of the attachment bracket portion 106Bb.

Alternatively, the attachment bracket portion 106Bb may be provided separately from the attachment stay portion 106Ba and may be attached to the attachment portion 110 of the main frame 56A by being fastened together with the attachment stay portion 106Ba.

As illustrated in FIGS. 15 and 16, the bracket attachment portions 107 are in columnar shapes having axes extending in the up-down direction and have screw holes (holes with female screws) 112. The pair of front and rear bracket attachment portions 107 are provided, and are provided so as to interpose a front bolt 88A of the pair of front and rear bolts 88 in the front-rear direction K1. By providing the bracket attachment portions 107 in columnar shapes, a wide working space for screwing the bolt 111 into the attachment portion 110 can be ensured, and a tool for attaching the bolt 111 can be prevented from interfering with the bracket attachment portions 107.

As illustrated in FIGS. 15 and 16, the pair of front and rear harness guides 108 each are obtained by bending a rod material. The harness guides 108 are located at the front portion and the rear portion of the attachment stay portion 106Ba and are fixed to the attachment stay portion 106Ba. Specifically, the harness guides 108 each include a first section 108a extending in the machine-body width direction K2, a second section 108b extending upward from a left end of the first section 108a, and a third section 108c extending upward from a right end of the first section 108a. The second section 108b is fixed to the attachment stay portion 106Ba.

As illustrated in FIG. 4, the harness 64 passes above the support bracket 66 and is guided rearward from the communication unit 58. The harness 64 is guided such that a portion of the harness 64 guided above the support bracket 66 passes above the first sections 108a of the harness guides 108 and between the second sections 108b and the third sections 108c of the harness guides 108. Accordingly, a movement in the machine-body width direction K2 and a downward movement of the harness 64 are restricted. By restricting the movement in the machine-body width direction K2 of the harness 64, the harness 64 can be prevented from protruding outward (rightward) in the machine-body width direction from the controller support 86. For example, the harness 64 can be prevented from contacting the cabin 5 when the cabin 5 is lowered from above and assembled to the machine body 2 after the operation section 41 and components around the operation section 41 are assembled. Also, by restricting the downward movement of the harness 64, the harness 64 can be prevented from drooping. Accordingly, for example, the harness 64 can be prevented from contacting the bolts 88.

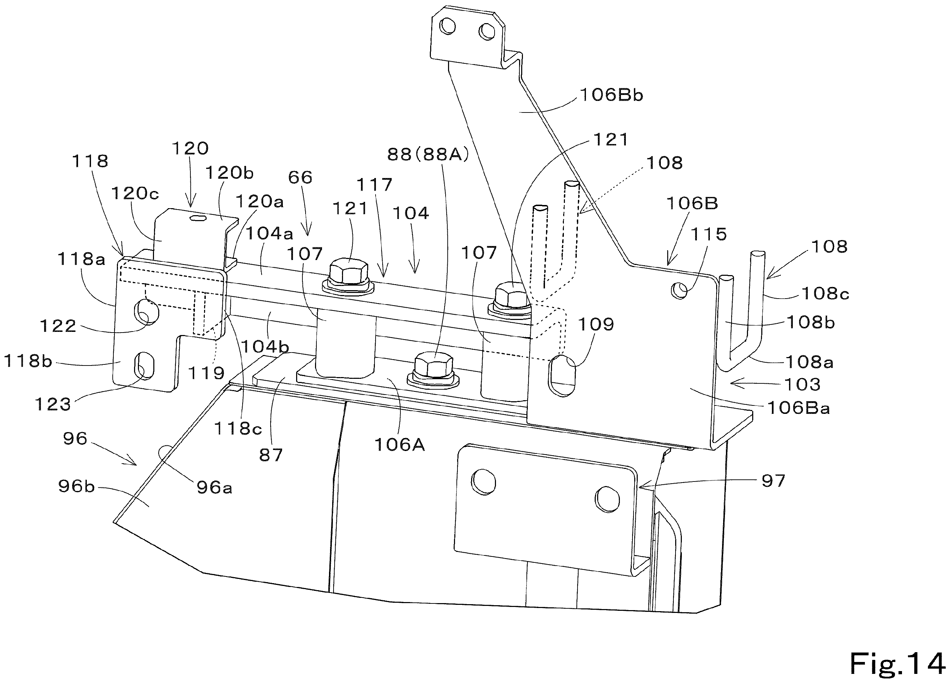

As illustrated in FIG. 14, the second bracket 104 includes a main bracket 117, an attachment plate (attaching section) 118, a reinforcing plate 119, and a holding bracket 120.

The main bracket 117 includes an upper wall portion 104a and a hanging wall portion 104b. The upper wall portion 104a is overlapped with the pair of bracket attachment portions 107 and attached by bolts 121 that penetrate the upper wall portion 104a and are screwed into the screw holes 112 of the bracket attachment portions 107. The hanging wall portion 104b extends downward from a right end of the upper wall portion 104a.

As illustrated in FIG. 4, the attachment plate (attaching section) 118 is made of a flat plate-shaped plate material and is fixed to a front portion of the main bracket 117. Specifically, the attachment plate 118 is located such that plate surfaces face in the machine-body width direction K2, is located at a front portion of a left surface of the upper wall portion 104a, and is fixed to the upper wall portion 104a. Also, the attachment plate 118 has a shape such that an upper portion 118a is wider than a lower portion 118b in the front-rear direction. In other words, the attachment plate 118 includes an extension portion 118c extending rearward from the upper portion 118a.

As illustrated in FIG. 14, the attachment plate 118 has an insertion hole (bolt insertion hole) 122 in the upper portion 118a, and a pin insertion hole 123 in the lower portion 118b. The bolt insertion hole 122 is a circular hole. The pin insertion hole 123 is a long hole elongated in the up-down direction. The bolt insertion hole 122 and the pin insertion hole 123 are arranged in the up-down direction.

As illustrated in FIGS. 9 and 11, a nut member 124 is fixed to a right surface of the upper portion 118a of the attachment plate 118, at a position corresponding to the bolt insertion hole 122.

As illustrated in FIG. 14, the reinforcing plate 119 is located between the hanging wall portion 104b and the extension portion 118c and is fixed to the upper wall portion 104a, the hanging wall portion 104b, and the extension portion 118c.

As illustrated in FIG. 6, the holding bracket 120 is located on a front portion of the upper wall portion 104a of the main bracket 117. As illustrated in FIG. 9, the holding bracket 120 includes a lower wall 120a fixed on the upper wall portion 104a, an upper wall 120b located above the lower wall 120a, and a side wall 120c coupling left end portions of the lower wall 120a and the upper wall 120b to each other. As illustrated in FIG. 4, a holding tool 125 that holds the harness 64 is attached to the holding bracket 120 (upper wall 120b).

As illustrated in FIGS. 5 and 6, the stay member (attached section) 67 is attached to the attachment plate (attaching section) 118 by the attachment tool 76. Specifically, the second wall 67b of the attachment stay 67 is overlapped with a left surface of the attachment plate 118. At this time, as illustrated in FIG. 9, the pin 37 is inserted through the pin insertion hole 123. Then, the attachment tool 76 is inserted through the insertion hole 67c and the insertion hole 122 and screwed into the nut member 124. Accordingly, the attachment stay (attached section) 67 is attached to the attachment plate (attaching section) 118. That is, the unit bracket 65 is assembled (attached) to the support bracket 66.

Since the pin insertion hole 123 is a long hole elongated in the up-down direction, the tolerance between the pin 37 and the attachment tool 76 can be accommodated.

The constituent portion 96b of the cover member 96 of the controller support 86 extends below the attachment stay (attached section) 67 and the attachment plate (attaching section) 118.

Thus, it is difficult to overlap the attached section of the unit bracket 65 with a lower surface of the attaching section of the support bracket 66 in the up-down direction and to fasten the overlapped portions by a bolt from below as in related art. Therefore, as in the first embodiment, by overlapping an attached section (attachment plate 118) of the unit bracket 65 with a side surface of an attaching section (attachment stay 67) of the support bracket 66 in the machine-body width direction K2, and fastening the overlapped portions by the bolt (attachment tool 76) from a side, the unit bracket 65 can be easily assembled to the support bracket 66 even though a member is located below the attaching section and the attached section.

Also, when the attachment stay 67 is attached to the attachment plate 118, by inserting the pin 37 through the pin insertion hole 123, the load of the unit bracket 65 can be applied to the support bracket 66, and the attachment stay 67 can be attached to the attachment plate 118 by the one attachment tool 76. Therefore, mountability of the unit bracket 65 and the support bracket 66 can be improved.

Alternatively, the pin 37 may be provided at the attachment plate 118. In this case, the pin insertion hole 123 is in the attachment stay 67. Also, the position at which the pin 37 is provided is not limited to the position illustrated in the drawings. It is enough that the pin 37 is provided at a position deviated from the insertion hole 67c (a position deviated from the nut member 124 when the pin 37 is provided at the attachment plate 118). That is, it is enough that the pin 37 is provided at a position deviated from the position at which the attachment tool 76 is attached. Still alternatively, the pin 37 may be omitted, and the attachment stay 67 may be attached to the attachment plate 118 by a plurality of attachment tools 76 (for example, two attachment tools 76).

Also, the constituent portion 96b of the cover member 96 includes the upper surface 96a that extends diagonally downward and forward. Therefore, the contact with the attachment stay (attached section) 67 and the attachment plate (attaching section) 118 can be prevented.

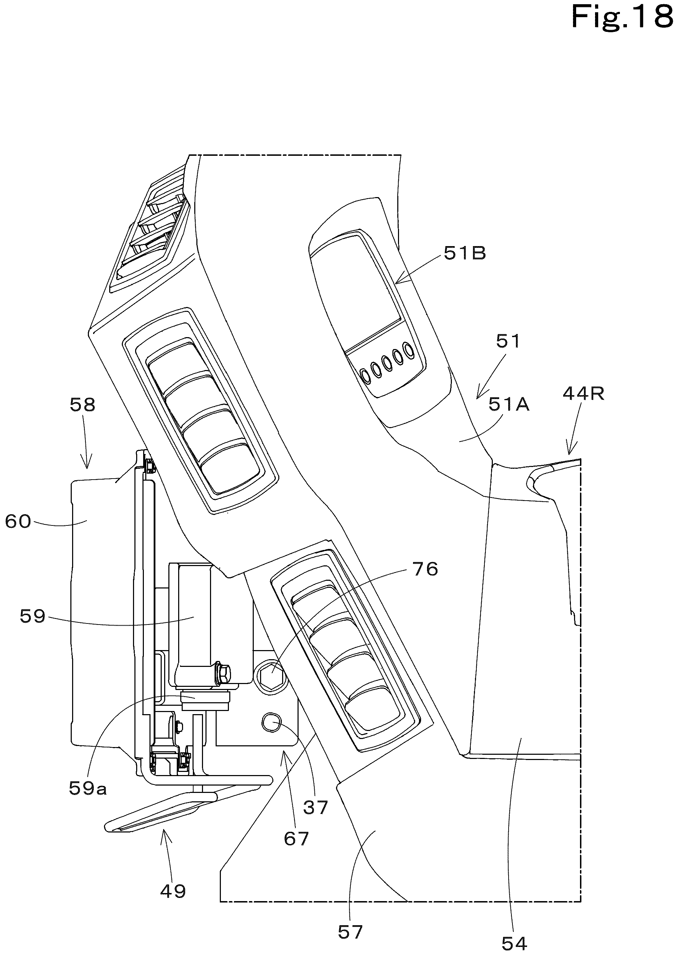

Also, while the unit bracket 65 and the support bracket 66 are assembled to each other in a state in which the meter 51 and the air conditioner duct 57 are assembled, as illustrated in FIG. 7, a cover body 16 that houses devices (for example, a hydraulic fluid tank, a control valve, a battery, and the like) mounted on the machine body 2 is located outward (rightward) of the communication unit 58 in the machine-body width direction K2. Therefore, it is difficult to attach the attachment stay 67 to the attachment plate 118 from an outer side (right) in the machine-body width direction K2. In contrast, in the first embodiment, as illustrated in FIG. 18, the attachment tool 76 can be accessed from an inner side of the attachment tool 76 in the machine-body width direction K2 through a space between the communication unit 58, and the meter 51 and the air conditioner duct 57. Accordingly, the unit bracket 65 can be attached to the support bracket 66 in the inward-to-outward direction along the machine-body width direction K2 through the space between the meter 51 and the communication unit 58.

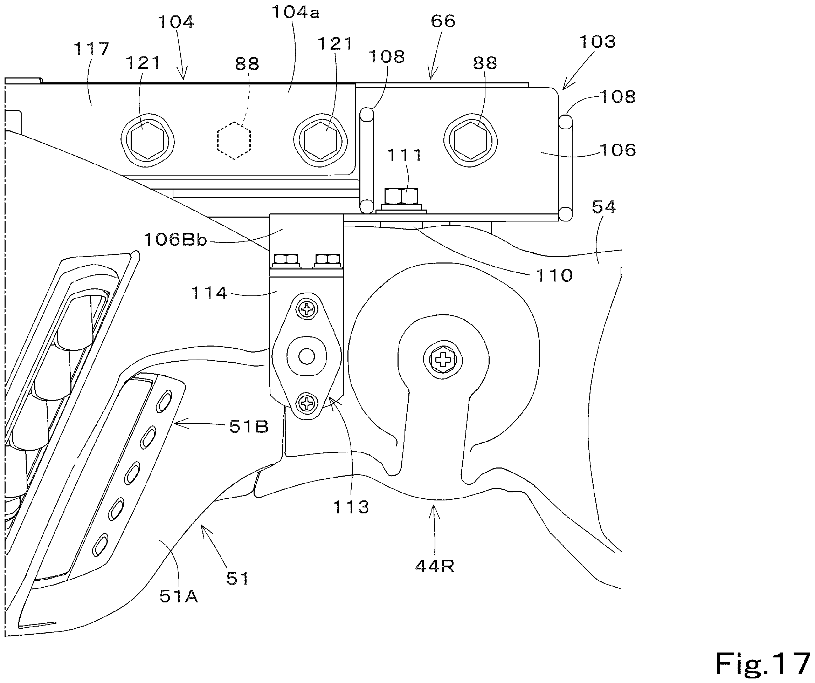

Also, as illustrated in FIG. 17, the bolts 88 and the bolts 121 can be accessed from above in the state in which the console 44R and the meter 51 are assembled.

A working machine 1 of the first embodiment includes a machine body 2; a seat 6 on the machine body 2; a console 44 located outward of the seat 6 in a machine-body width direction K2; a meter 51 provided at a front portion of the console 44; a communication unit 58 located forward of the meter 51; and a unit support 61 to support the communication unit 58. The unit support 61 includes a unit bracket 65 to which the communication unit 58 is attached, a support bracket 66 located outward of the meter 51 in the machine-body width direction K2 and attached directly or indirectly to the machine body 2, and an attachment tool 76 to attach the unit bracket 65 to the support bracket 66. The unit bracket 65 includes an attached section (attachment stay) 67. The support bracket 66 includes an attaching section (attachment plate) 118 with which the attached section 67 overlaps in the machine-body width direction K2. The attachment tool 76 attaches the attached section 67 to the attaching section 118 in the machine-body width direction K2.

With this configuration, by attaching the attached section 67 of the unit bracket 65 to the attaching section 118 of the support bracket 66 in the machine-body width direction K2, the unit bracket 65 can be easily attached to the support bracket 66.

The working machine 1 further includes a pin 37 provided at one of the attaching section 118 and the attached section 67 such that the pin 37 is deviated from a position at which the attachment tool 76; and a pin insertion hole 123 provided in the other of the attaching section 118 and the attached section 67. The attached section 67 is attached to the attaching section 118 via the attachment tool 76 with the pin 37 inserted through the pin insertion hole 123.

With this configuration, the unit bracket 65 can be easily attached to the support bracket 66.

The pin insertion hole 123 is a long hole elongated in an up-down direction. The attachment tool 76 fastens the attaching section 118 and the attached section 67 above the pin 37.

With this configuration, attachment accuracy of the attachment tool 76 can be improved.

The working machine 1 further includes a controller 85 located outward of the meter 51 in the machine-body width direction K2; and a controller support 86 attached directly or indirectly to the machine body 2 to support the controller 85. The support bracket 66 is attached on the controller support 86 along a front-rear direction K1. The controller support 86 includes a constituent portion 96b including an upper surface extending below the attaching section 118 and the attached section 67 and extending diagonally forward and downward.

With this configuration, the support bracket 66 can be attached on the controller support 86 at a low height.

The communication unit 58 includes an information processing device 59 and a communication device 60 to receive data from and transmit data to the information processing device 59, the communication device 60 containing a communication antenna 92 and configured to transmit data. The information processing device 59 is located on a back side of the communication device 60 and includes, at a lower side thereof, a connection portion 59a to have a harness 64 connected thereto. The unit bracket 65 includes a guard member 49 to guard the harness 64 connected to the connection portion 50a from below.

With this configuration, the harness 64 can be protected from below.

A pedal member 50 to be depressed by a user seated on the seat 6 is located below the guard member 49.

With this configuration, a foot of the user can be prevented from contacting the harness 64.

The attachment tool 76 is attached to the attached section 67 and the attaching section 118 through a space between the meter 51 and the communication unit 58 in an inward-to-outward direction along the machine-body width direction K2.

With this configuration, the attached section 67 can be attached to the attaching section 118 in the inward-to-outward direction along the machine-body width direction K2.

The support bracket 66 includes a harness guide 108 to restrict a movement in the machine-body width direction K2 and a downward movement of a harness 64 guided rearward from the communication unit 58 and extending above the support bracket 66.

With this configuration, the harness 64 can be prevented from contacting the support bracket 66 and members located sideward of the support bracket 66.

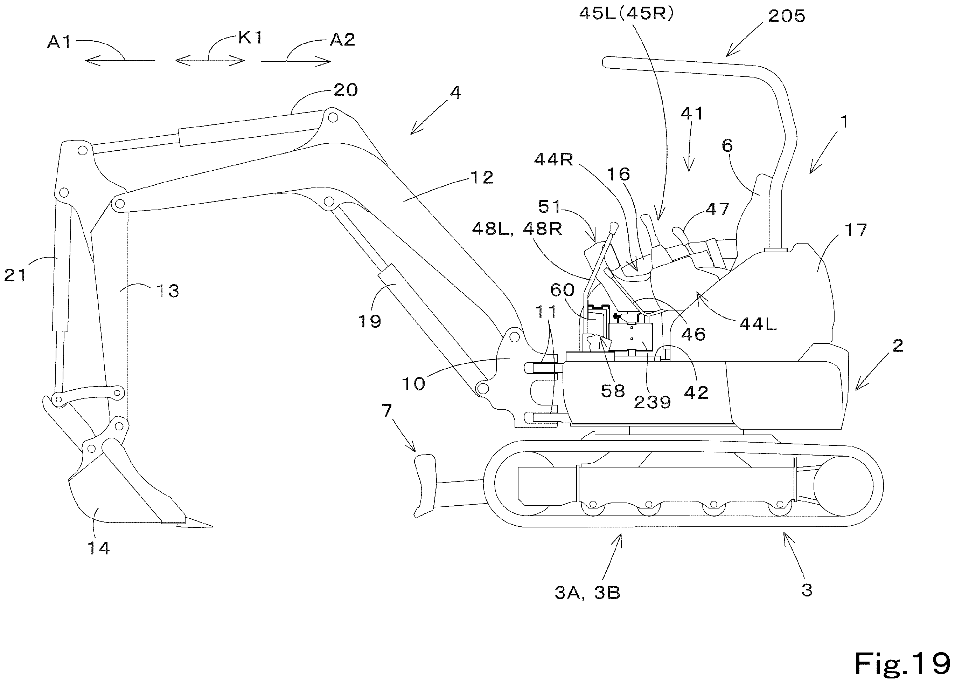

FIGS. 19 to 40 illustrate a second embodiment. In the second embodiment, similar reference numerals are given to points similar to those in the above-described first embodiment, and the description thereof will be omitted. Points different from those in the above-described first embodiment will be mainly described.

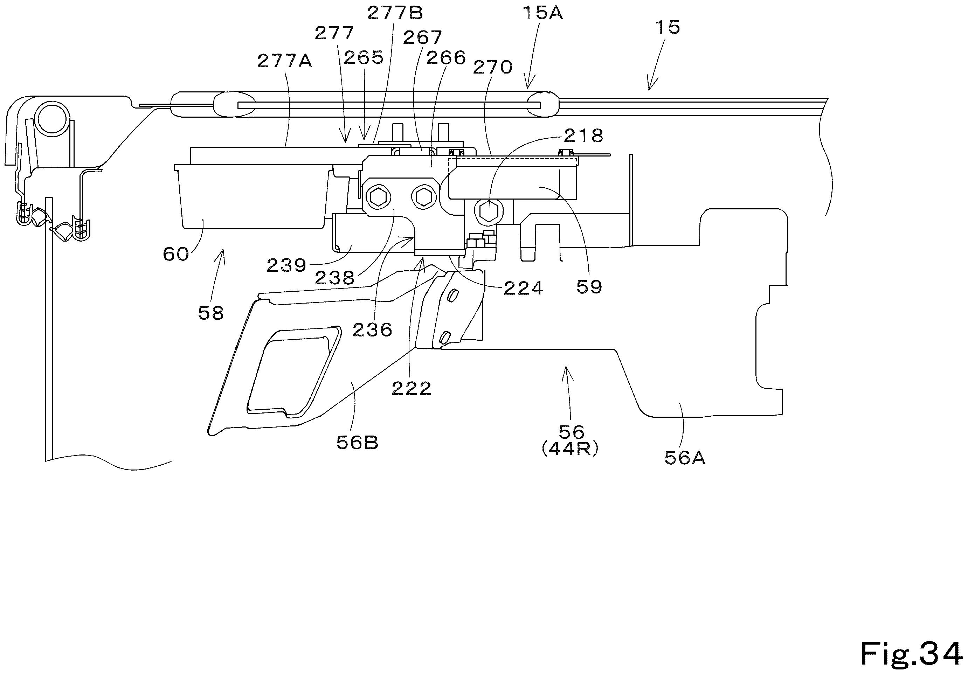

In the second embodiment, FIGS. 19 to 33 illustrate a main embodiment. FIG. 34; FIGS. 35 and 36; FIG. 37; and FIGS. 38, 39, and 40 illustrate embodiments according to variations.

FIG. 19 is a side view illustrating an overall configuration of a working machine 1 according to the second embodiment. Also in the second embodiment, a backhoe is exemplified as the working machine 1.

As illustrated in FIG. 19, the working machine 1 includes a machine body (turning base) 2, a traveling device 3, a front working device (working device) 4, and a canopy 205.

In the second embodiment, the working machine (canopy-equipped working machine) 1 in which the canopy 205 is mounted is exemplified, but a working machine (cabin-equipped working machine) 1 in which a cabin is mounted instead of the canopy 205 may be used, or a working machine 1 not including the canopy 205 or the cabin may be used.

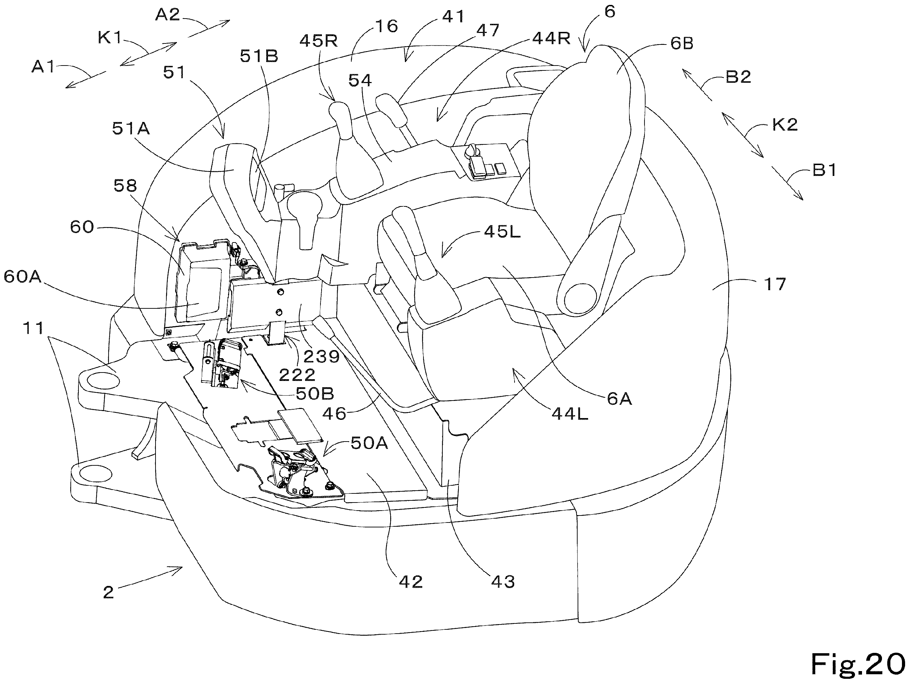

As illustrated in FIGS. 19 and 20, the working machine 1 includes an operation section 41 including a seat 6 on which a user is seated.

As illustrated in FIG. 20, a cover body 16 that houses devices (for example, a hydraulic fluid tank, a control valve, a battery, and the like) mounted on the machine body 2 is provided at a right portion of the machine body 2, i.e., provided at one of opposite side portions of the operation section 41 in the machine-body width direction K2. A hood 17 that houses a prime mover (engine) is provided rearward of the operation section 41.

As illustrated in FIG. 20, a pedal member 50A is provided on a left portion, and a pedal member 50B is provided on a right portion of the machine body 2 in an area located forward of the seat 6. The pedal member 50A and the pedal member 50B are members that are depressed by the user seated on the seat 6. The pedal member 50A is, for example, an auxiliary pedal. The auxiliary pedal is an operation member that operates a hydraulic attachment when the hydraulic attachment including a hydraulic actuator is attached as a working tool 14. The pedal member 50B is a swing pedal.

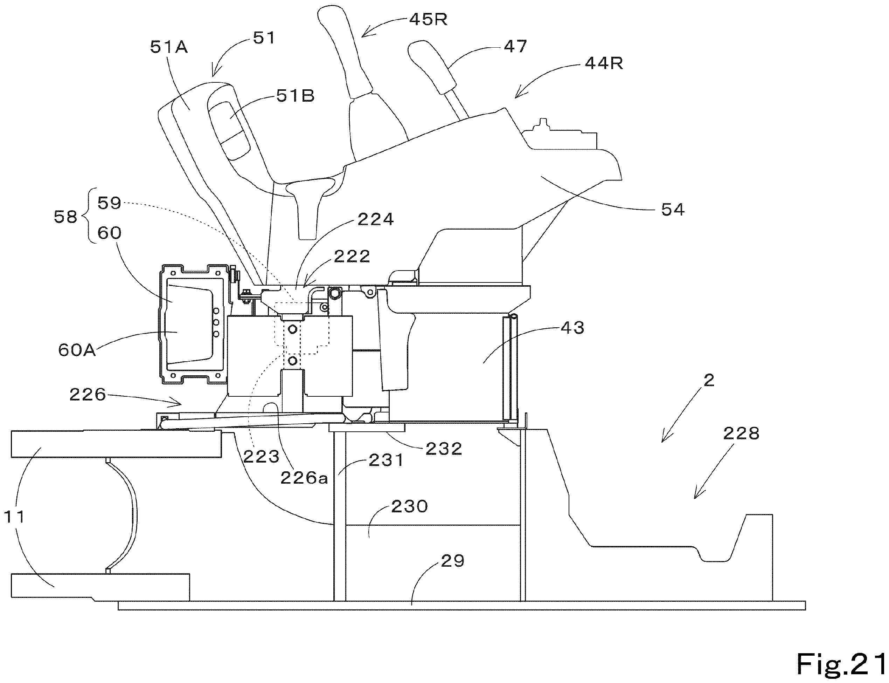

As illustrated in FIG. 21, a communication unit 58 is mounted on the working machine 1. As illustrated in FIGS. 19 and 20, the communication unit 58 is installed in the vicinity of an outer edge portion of the operation section 41. In the second embodiment, the communication unit 58 is provided at a right and front portion of the machine body 2 (operation section 41).

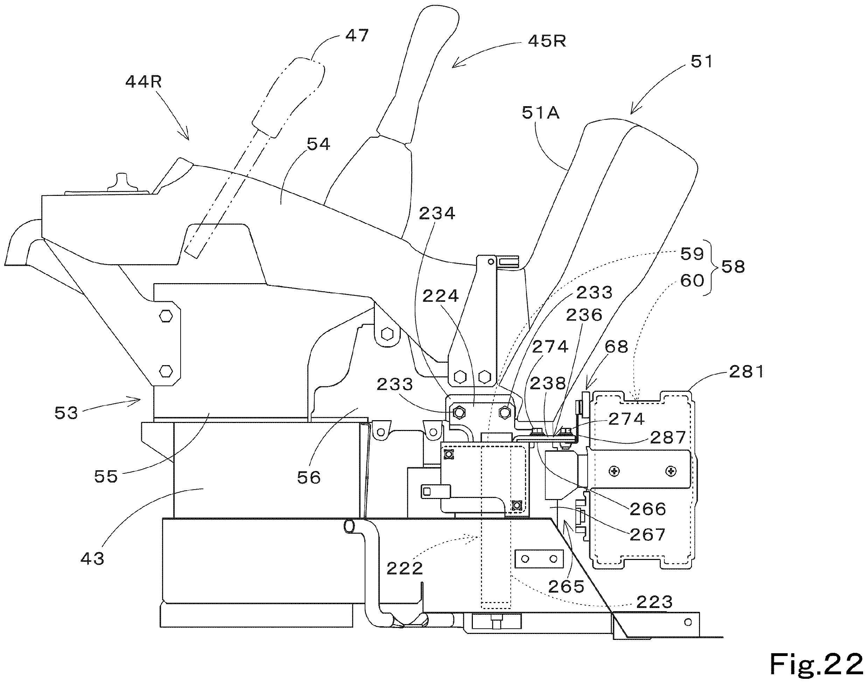

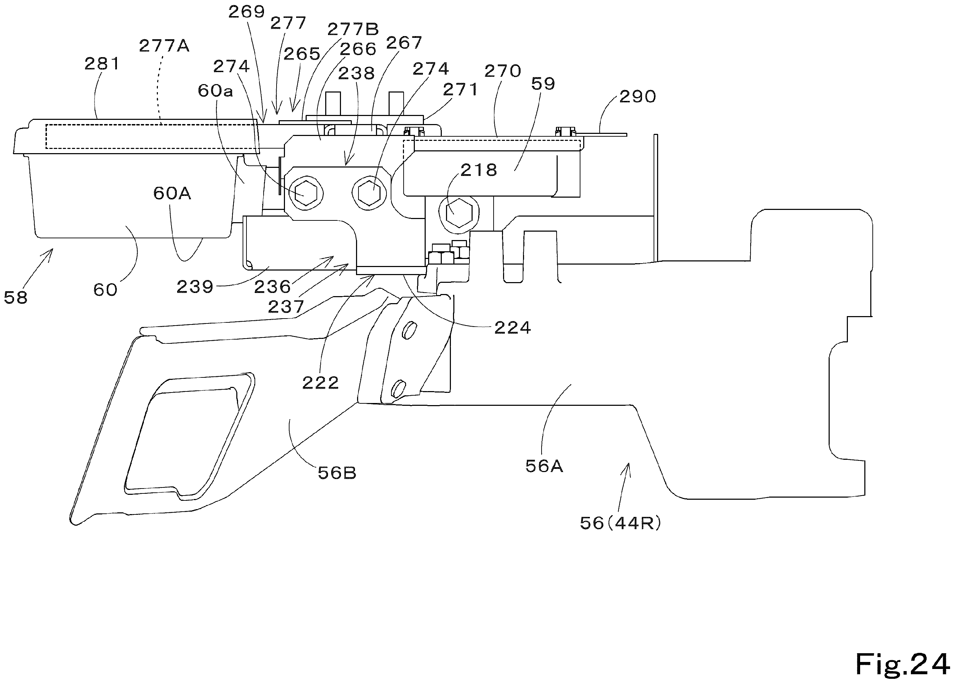

As illustrated in FIGS. 22 and 24, the communication unit 58 is located at one of opposite sides of a console 44R (console frame 53) in the machine-body width direction K2. Specifically, the communication unit 58 is located at the opposite side of the console 44R from the seat 6 (in the second embodiment, rightward of the console 44R). By providing the communication unit 58 (DCU 60 and IPU 59) at the opposite side of the console 44R from the seat 6, it is possible to eliminate or reduce the likelihood that the communication unit 58 will hinder the user's view.

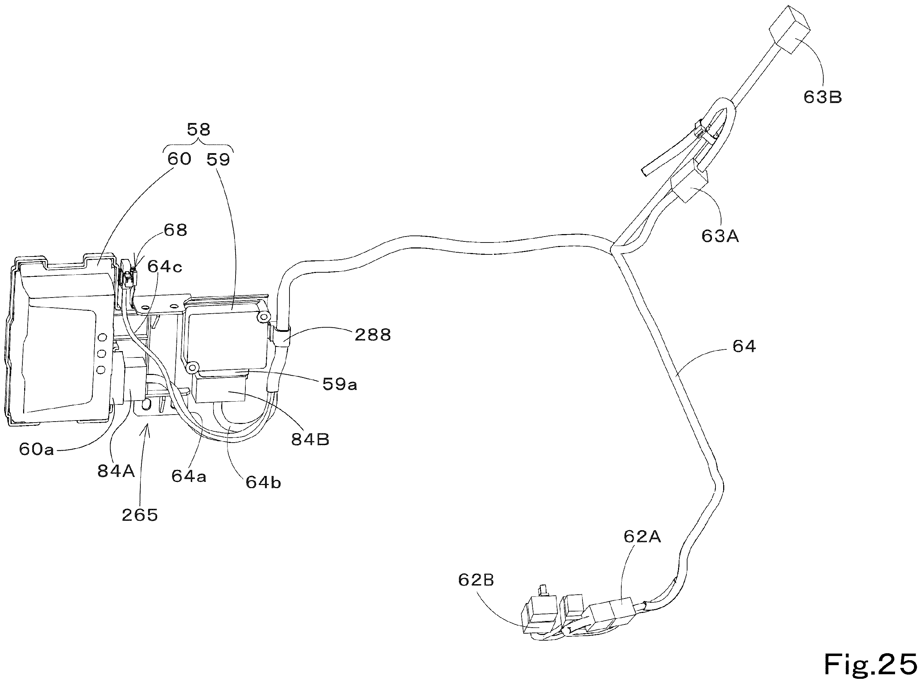

As illustrated in FIG. 25, the IPU 59 is connected to a communication port of an on-board communication network, a communication port of on-board diagnostics, and the like (not illustrated) via a harness 64. Specifically, the IPU 59 is connected to the communication port of the on-board communication network via the harness 64 and a connector 62A. Also, the IPU 59 is connected to the communication port of the on-board diagnostics via the harness 64 and a connector 62B.

Also, the IPU 59 and the DCU 60 are connected to a power supply port (not illustrated) via the harness 64 and a connector 63A. Power is supplied from the power supply port.

In the working machine 1 in which the cabin is not mounted, the communication ports of the on-board communication network and the on-board diagnostics are located inside a seat base 43 in the operation section 41. Alternatively, in the working machine 1 on which the cabin is mounted, the communication ports are provided at other positions of the operation section 41. The harness 64 extending from the communication unit 58 to the connectors 62A and 62B is long enough to be connected to the communication ports of the on-board communication network and the on-board diagnostics in any of the case where the communication unit 58 is mounted on the working machine 1 in which the cabin is not mounted and the case where the communication unit 58 is mounted on the working machine 1 in which the cabin is mounted. Additionally, the working machine 1 includes a harness 64d and a connector 63B that connect the IPU 59 to a connection port of a harness of the cabin (not illustrated) when the communication unit 58 is mounted on the working machine 1 in which the cabin is mounted.

In the second embodiment, the harness 64 is a harness 64 that is for use for both the case where the communication unit 58 is mounted on the working machine 1 in which the cabin is mounted and the case where the communication unit 58 is mounted on the working machine 1 in which the cabin is not mounted. That is, the harness 64 can be used for both the working machine 1 in which the cabin is mounted on the machine body 2 and the working machine 1 in which the cabin is not mounted on the machine body 2.

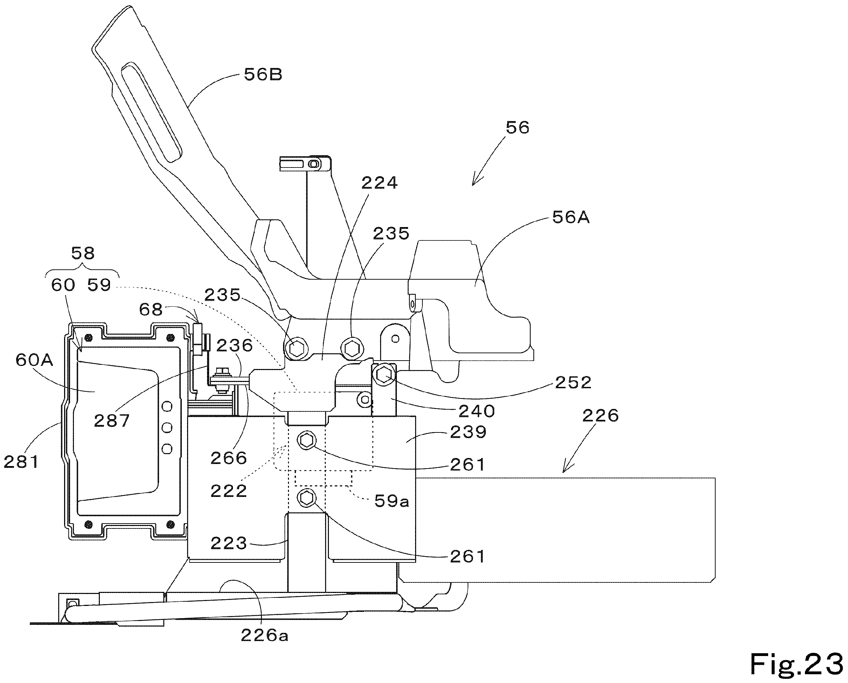

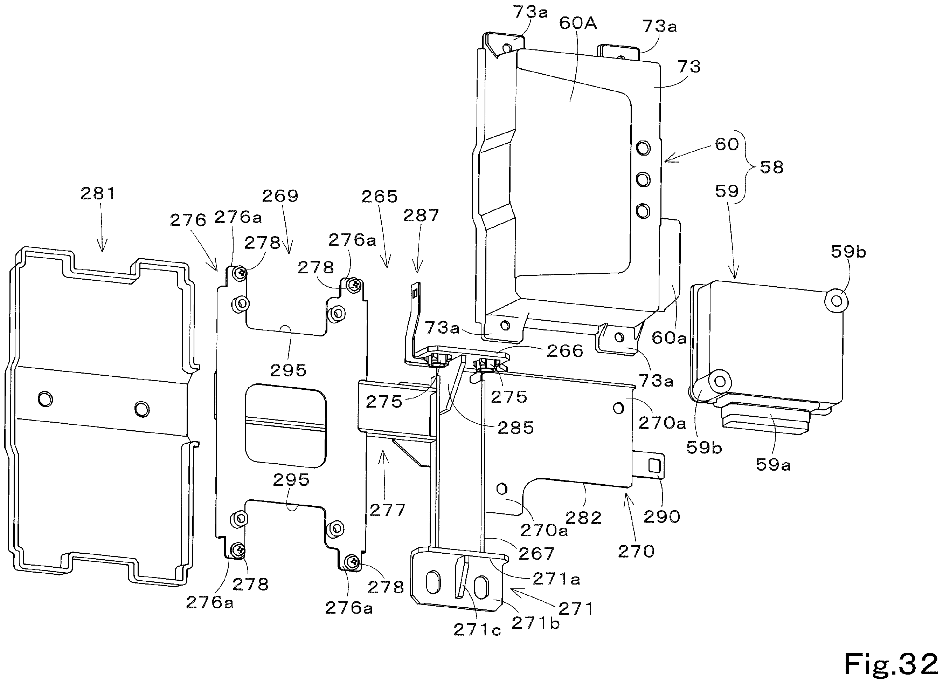

As illustrated in FIG. 23, the IPU 59 has a substantially rectangular parallelepiped shape in which surfaces facing in the machine-body width direction K2 are substantially rectangular, and is located horizontally such that the longitudinal direction of the rectangular parallelepiped coincides with the front-rear direction K1. Also, as illustrated in FIG. 32, the IPU 59 has a substantially rectangular parallelepiped shape in which the width in the machine-body width direction K2 (the width in the thickness direction) is narrower than the width in the up-down direction and the width in the front-rear direction K1. The IPU 59 includes, at a lower side thereof, a connection portion 59a to have the harness 64 connected thereto.

As illustrated in FIG. 23, the DCU 60 has a substantially rectangular parallelepiped shape in which a device front surface 60A is substantially rectangular and is located vertically such that the longitudinal direction of the rectangular parallelepiped coincides with the up-down direction. Also, as illustrated in FIG. 32, the DCU 60 has a substantially rectangular parallelepiped shape in which the width in the machine-body width direction K2 (the width in the thickness direction) is narrower than the width in the up-down direction and the width in the front-rear direction K1.

As illustrated in FIGS. 21 to 23, the DCU 60 and the IPU 59 are arranged in the front-rear direction K1. By arranging the DCU 60 and the IPU 59 in the front-rear direction K1, the DCU 60 and the IPU 59 can be compactly provided in a narrow space at the opposite side of the console 44R from the seat 6. In particular, as illustrated in FIG. 34, in a working machine 1 in which a cabin 15 is mounted, a left side panel 15A of the cabin 15 is located at the opposite side of a front portion frame 56 (console 44R) from the seat 6, and therefore a space at the opposite side of the console 44R from the seat 6 is narrow. However, by arranging the DCU 60 and the IPU 59 in the front-rear direction K1, the DCU 60 and the IPU 59 can be compactly located in the narrow space.

In the second embodiment, the DCU 60 is located forward of the IPU 59 with a space therebetween. Alternatively, the IPU 59 may be located on the front and the DCU 60 may be located on the rear.

As illustrated in FIG. 20, the DCU 60 is located above a floor portion 42 of the operation section 41 with a space therebetween such that the device front surface 60A of the DCU 60 faces in a sideward direction toward the seat 6 (leftward). In other words, the DCU 60 is located such that the device front surface 60A of the DCU 60 faces a space located above the floor portion 42 and forward of the seat 6. Also, the pedal member 50B is located at the same side of the DCU 60 as the seat 6. By providing the IPU 59 rearward of the DCU 60 (by not arranging the IPU 59 and the DCU 60 in the machine-body width direction K2), the DCU 60 can be spaced apart with respect to the pedal member 50B in the machine-body width direction K2, and contact of the foot of the user with the DCU 60 can be prevented or reduced.

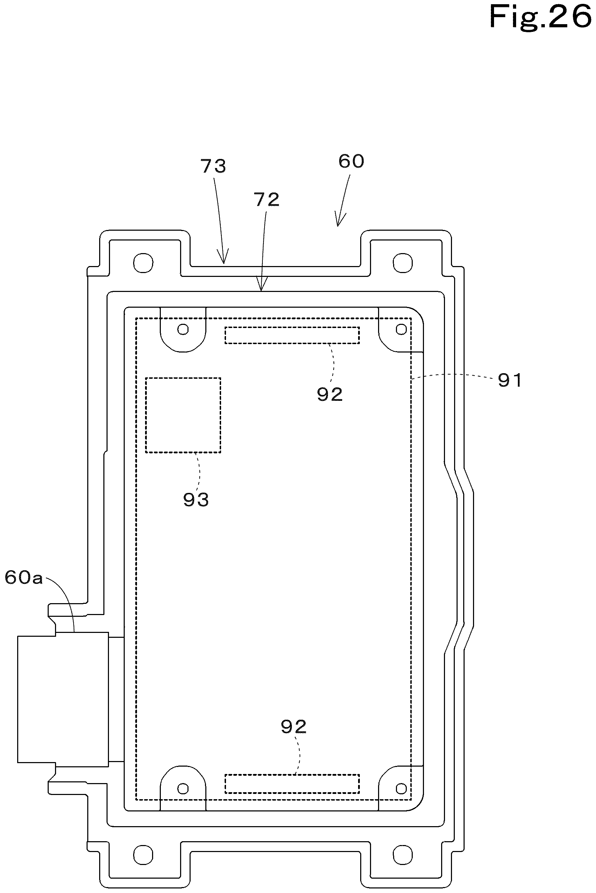

FIG. 26 is a view of the DCU 60 viewed from a device back surface of the DCU 60 (a side opposite to the device front surface 60A). The DCU 60 includes a case 72 and a cover 73 that covers the case 72 from the device front surface 60A. The DCU 60 includes a connection portion 60a to which the harness 64 is connected. The connection portion 60a is provided rearward of a lower portion of the case 72.

As illustrated in FIG. 21, the DCU 60 is located at a position at which the DCU 60 is exposed forward from the console 44R (meter 51) in a side view. Also, as illustrated in FIG. 20, the device front surface 60A faces a side opposite to the cover body 16 in the machine-body width direction K2. Accordingly, communication performance of the DCU 60 can be ensured.

As illustrated in FIG. 22, the working machine 1 includes a support bracket (console support bracket) 222 that supports the console 44R. The support bracket 222 is located at a front portion of the console 44R and supports the front portion of the console 44R (front portion frame 56). Specifically, the support bracket 222 is located rightward of the front portion of the console 44R (at the opposite side of the console 44R from the seat 6), and supports the front portion of the console 44R (front portion frame 56). Also, as illustrated in FIGS. 21 and 23, the support bracket 222 is vertically provided on the machine body 2 and located lower than the front portion frame 56. Further, as illustrated in FIGS. 23 and 24, the support bracket 222 is located near the right of the front portion frame 56.

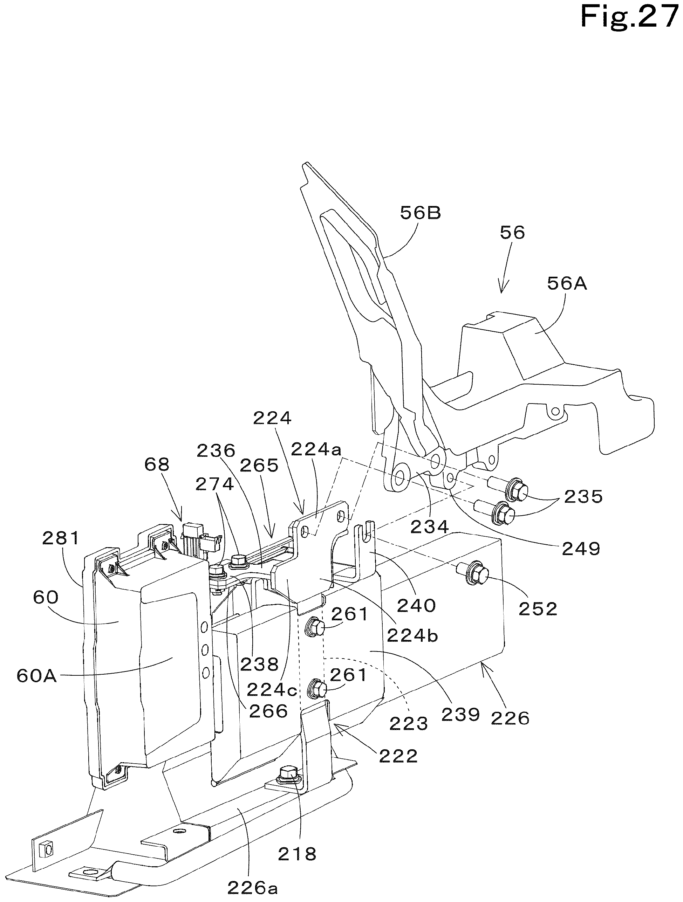

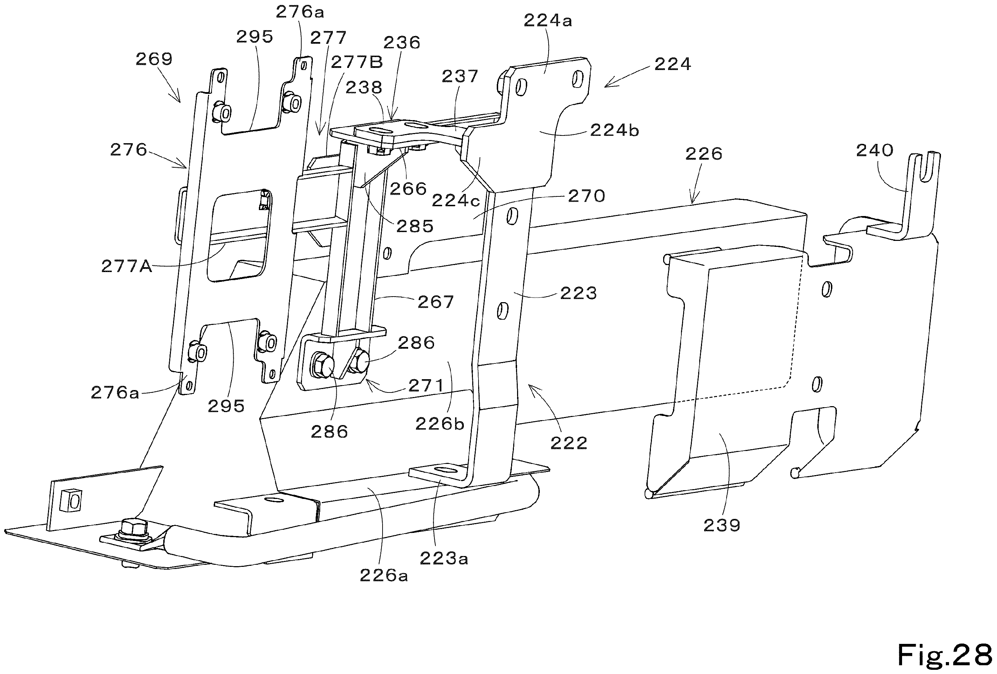

As illustrated in FIGS. 27 and 28, the support bracket 222 includes a pillar member 223 extending in the up-down direction and a bracket plate (bracket member) 224 fixed to an upper portion of the pillar member 223. The pillar member 223 is made of a band plate material having the longitudinal direction in the up-down direction. The pillar member 223 has, at a lower portion, a base portion 223a extending rightward from a lower end of the pillar member 223.

As illustrated in FIG. 27, the base portion 223a (the lower portion of the pillar member 223) is fixed to an attachment portion 226a provided at a fixing member 226 via a bolt member 218 or the like. That is, the pillar member 223 is vertically provided on the attachment portion 226a (fixing member 226). Further, as illustrated in FIG. 21, the fixing member 226 is attached to the machine body 2. Thus, the support bracket 222 is vertically provided on the machine body 2 via the fixing member 226.

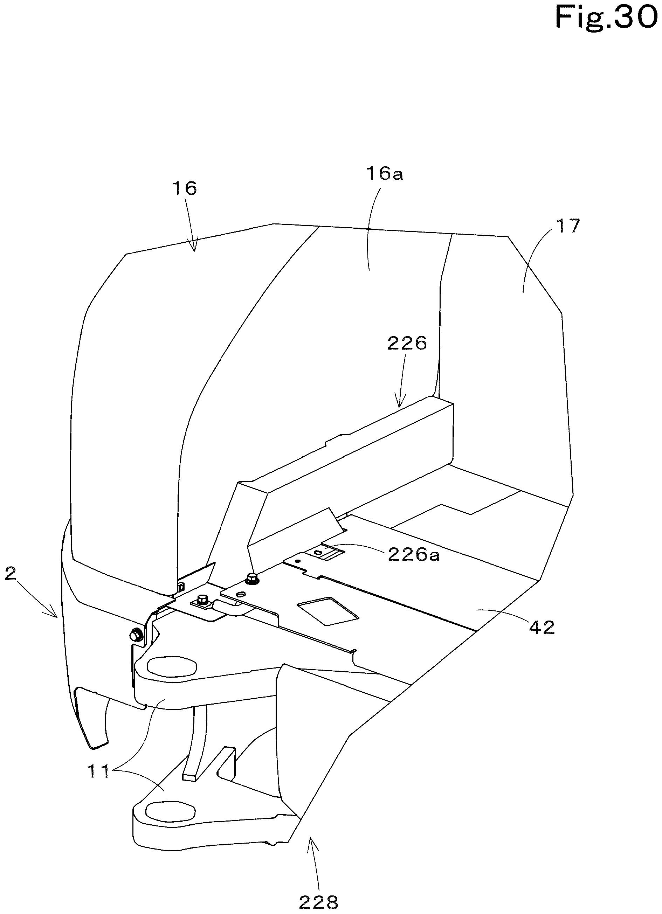

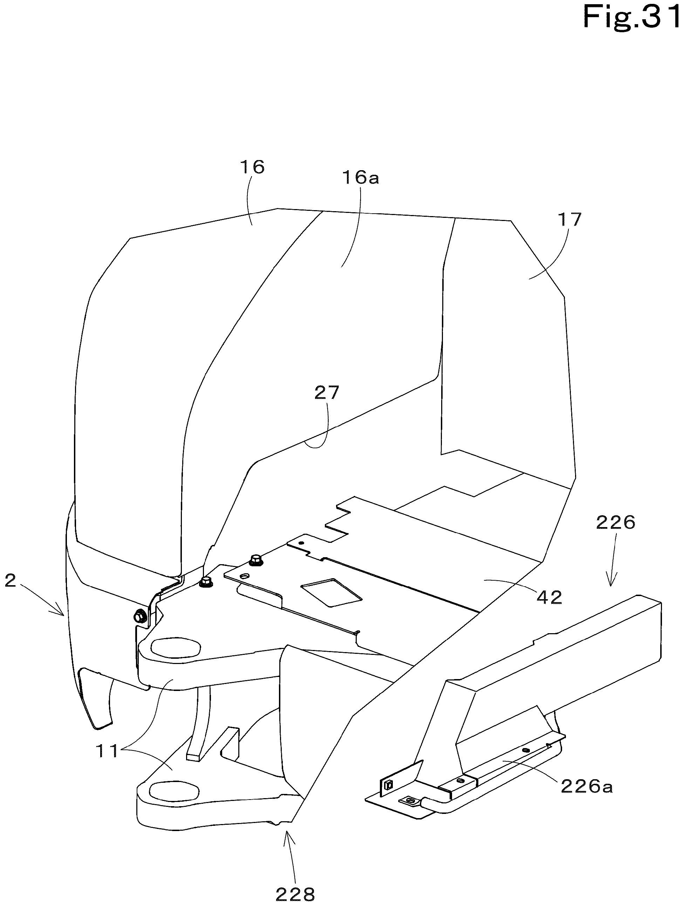

As illustrated in FIG. 30, the fixing member 226 is located at a lower portion of a surface (left surface) 16a located inward of the cover body 16 in the machine-body width direction K2. As illustrated in FIG. 31, a cutout opening 27 is in the lower portion of the left surface 16a of the cover body 16. The cutout opening 27 is provided, for example, to prevent contact with a hydraulic hose connected to a control valve housed in the cover body 16. As illustrated in FIG. 30, the fixing member 226 is a cover member provided to cover (close) the cutout opening 27 of the cover body 16.

As illustrated in FIG. 21, the fixing member 226 is attached to a turning frame 228 forming a framework of the machine body 2. The turning frame 228 includes a turning base plate 29 forming a bottom portion of the machine body 2, a vertical rib 230 fixed on the turning base plate 29, support brackets 11 fixed to a front portion of the vertical rib 230, and the like. Also, the fixing member 226 is fixed to a plate member 232 fixed to an upper portion of a support pillar 231 vertically provided on the turning base plate 29, and the upper support bracket 11 via a bolt or the like. Thus, the fixing member 226 is fixed to the machine body 2.

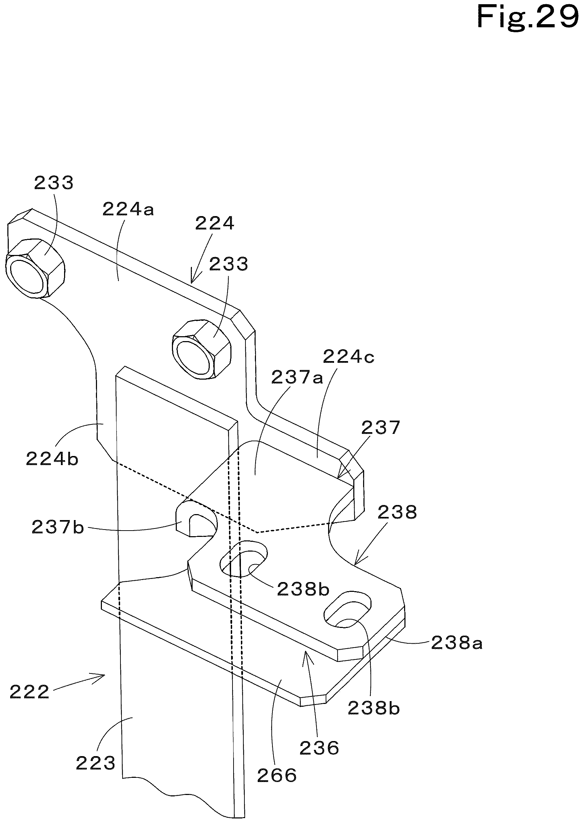

As illustrated in FIGS. 28 and 29, the bracket plate 224 is made of a plate material and is located at the upper portion and leftward of the pillar member 223 such that plate surfaces face in the machine-body width direction K2. The bracket plate 224 includes a first section 224a in an upper portion, a second section 224b extending downward from a front portion of the first section 224a, and a third section 224c extending forward from the second section 224b. As illustrated in FIG. 29, a pair of front and rear nut members 233 are fixed to a right surface of the first section 224a.

As illustrated in FIGS. 22 and 27, the front portion frame 56 is provided with a bracket attachment portion 234. Specifically, the bracket attachment portion 234 is provided at a front and lower portion of the front portion frame 56 (main frame 56A). A left surface of the first section 224a is overlapped with a right surface of the bracket attachment portion 234, and the first section 224a is attached to the bracket attachment portion 234 by bolt members 235 that penetrate the bracket attachment portion 234 and the first section 224a from the left and are screwed into the nut members 233.

As illustrated in FIG. 29, the upper portion of the pillar member 223 is fixed to the second section 224b. Specifically, the upper portion of the pillar member 223 is overlapped with a right surface of the second section 224b and fixed thereto by welding or the like. The third section 224c protrudes forward of the pillar member 223.

As illustrated in FIGS. 28 and 29, the support bracket 222 is provided with an attachment bracket 236 made of a plate material. Specifically, the attachment bracket 236 is provided at an upper portion of the support bracket 222. The attachment bracket 236 is a member for attaching a unit bracket 265 (described later). That is, the attachment bracket 236 for attaching the unit bracket 265 to the support bracket 222 is provided.

The attachment bracket 236 is provided to protrude sideways from the support bracket 222 away from the seat 6 (protrude rightward from the support bracket 222). In the example illustrated in FIGS. 28 and 29, the attachment bracket 236 is fixed to the third section 224c and is provided to protrude rightward from the third section 224c. Specifically, as illustrated in FIG. 29, the attachment bracket 236 includes a fixing portion 237 and an attachment wall 238. The fixing portion 237 includes a first wall portion 237a and a second wall portion 237b. The first wall portion 237a has a shape such that plate surfaces face in the up-down direction and is located forward of the upper portion of the pillar member 223 and rightward of an upper portion of the third section 224c. The second wall portion 237b extends downward from a rear end of the first wall portion 237a. The first wall portion 237a and the second wall portion 237b are fixed to a right surface of the third section 224c by welding or the like. Alternatively or additionally, the second wall portion 237b may be welded to the pillar member 223.

The attachment wall 238 extends rightward and forward from a right end of the first wall portion 237a of the fixing portion 237. Thus, the attachment wall 238 is located forward of the pillar member 223. Plate surfaces of the attachment wall 238 face in the up-down direction. A pair of front and rear insertion holes 238b are in the attachment wall 238 so as to penetrate in the up-down direction. The insertion holes 238b are long holes elongated in the machine-body width direction K2. A lower surface of the attachment wall 238 is an attachment surface 238a to which the unit bracket 265 is attached. Alternatively, an upper surface of the attachment wall 238 may be used as an attachment surface to which the unit bracket 265 is attached.

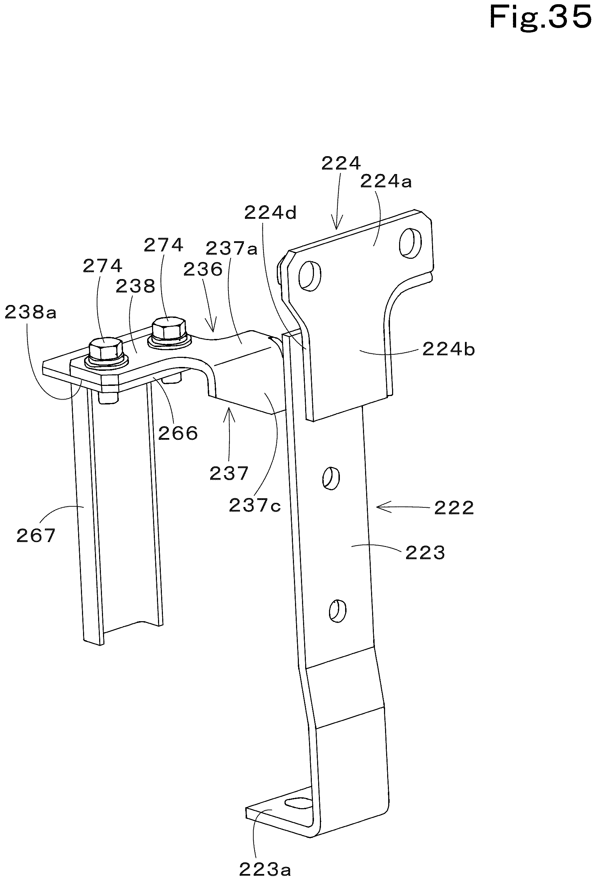

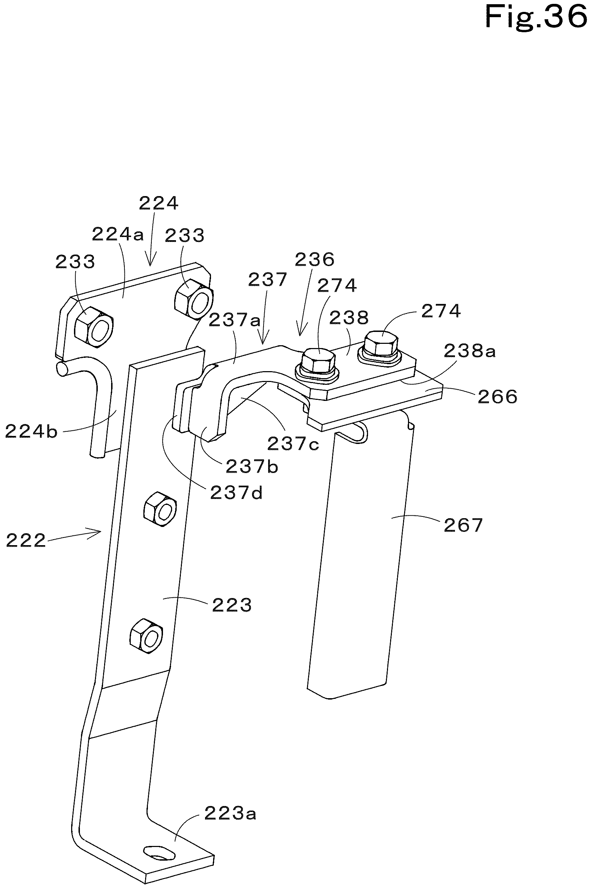

The shapes of the bracket plate 224 and the attachment bracket 236 are not limited to those illustrated in FIGS. 28, 29, and the like, and can be variously changed. For example, the bracket plate 224 and the attachment bracket 236 may be configured as in an embodiment according to a variation illustrated in FIGS. 35 and 36.

In the embodiment illustrated in FIGS. 35 and 36, a bracket plate 224 of a support bracket 222 includes a first section 224a and a second section 224b, but does not include the above-described third section 224c. Also, a pillar member 223 is exposed forward from a front end 224d of the second section 224b.

A fixing portion 237 of an attachment bracket 236 includes a first wall portion 237a, a second wall portion 237b, and a third wall portion 237c. The first wall portion 237a provided such that plate surfaces face in the up-down direction and is located forward and rightward of an upper portion of the pillar member 223. The second wall portion 237b extends downward from a rear end of the first wall portion 237a. The third wall portion 237c extends downward from a left end of the first wall portion 237a. Additionally, the third wall portion 237c includes an extension portion 237d extending rearward and located rightward of the pillar member 223. The extension portion 237d abuts on a right surface of the pillar member 223 and is fixed to the right surface by welding or the like. The second wall portion 237b is fixed to the extension portion 237d by welding or the like.

In the embodiment illustrated in FIGS. 35 and 36, the fixing portion 237 of the attachment bracket 236 is fixed to the pillar member 223, but this does not imply any limitation, and the fixing portion 237 may be provided such that the fixing portion 237 is fixed across the bracket plate 224 and the pillar member 223 (to both the bracket plate 224 and the pillar member 223). That is, it is enough that the fixing portion 237 of the attachment bracket 236 is fixed to an upper portion of the support bracket 222.

As illustrated in FIGS. 23 and 27, a cover member 239 is located at the same side of the support bracket 222 as the seat 6. As illustrated in FIG. 23, the cover member 239 extends rearward of the IPU 59 from a rear end of the DCU 60 and covers sides of a branch portion 64a, a branch portion 64b, and a branch portion 64c of the harness 64 that face the seat 6.

For example, there may be cases in which a component (for example, a tooth of the bucket 14) is placed on the floor portion 42 located leftward of the support bracket 222 (at the same side of the support bracket 222 as the seat 6). However, when a component is placed on the floor portion 42 located leftward of the support bracket 222, there is a concern that the component may contact the harness 64 due to vibration or the like of the machine body 2. In such a case, the harness 64 can be protected by the cover member 239.

As illustrated in FIG. 27, an intermediate portion (substantially central portion) in the front-rear direction K1 of the cover member 239 is attached to the pillar member 223 in the inward-to-outward direction (in the left-to-right direction) along the machine-body width direction K2 by bolt(s) 261 and/or the like. Also, a stay member 240 is fixed to an upper surface of a rear portion of the cover member 239. The stay member 240 is fixed to an attachment portion 249 provided at a lower portion of the front portion frame 56 from the left by a bolt 252.

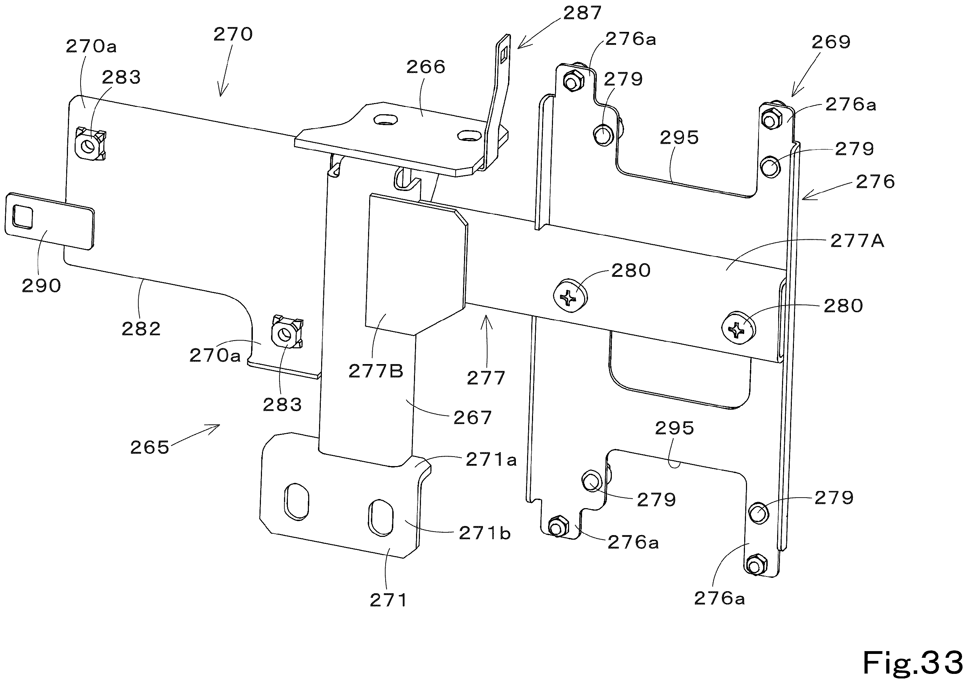

As illustrated in FIGS. 32 and 33, the working machine 1 includes a unit bracket 265 to which the communication unit 58 is attached. As illustrated in FIG. 24, the unit bracket 265 is provided along the front-rear direction K1 on the opposite side (rightward) of the front portion frame 56 (console 44R) from the seat 6.

As illustrated in FIGS. 32 and 33, the unit bracket 265 includes an attachment member 266, a vertical member 267, a first bracket member 269, a second bracket member 270, and an attachment stay 271.

As illustrated in FIG. 29, the attachment member 266 is made of a plate material, is positioned such that plate surfaces face in the up-down direction, and is overlapped with the lower surface (attachment surface 238a) of the attachment wall 238 of the attachment bracket 236. As illustrated in FIG. 32, a pair of front and rear nut members 275 are fixed to a lower surface of the attachment member 266. The attachment member 266 is attached to the attachment wall 238 (attachment bracket 236) by bolt members 274 that penetrate the insertion holes 238b of the attachment wall 238 and the attachment member 266 and are screwed into the nut members 275 from above (see FIGS. 22, 24, and 27). In this way, since the attachment member 266 of the unit bracket 265 can be attached to the attachment wall 238 of the attachment bracket 236 from above, attachment workability of the unit bracket 265 is good. Also, since the insertion holes 238b are long holes elongated in the machine-body width direction K2, the attachment position of the unit bracket 265 can be adjusted in the machine-body width direction K2.

As illustrated in FIGS. 28 and 32, the vertical member 267 is located below the attachment member 266 so as to extend in the up-down direction. Specifically, the vertical member 267 is made of a channel steel and is positioned such that an opening faces leftward and the longitudinal direction coincides with the up-down direction. The attachment member 266 is fixed to an upper portion of the vertical member 267 by welding or the like. As illustrated in FIG. 32, a reinforcing member 285 is fixed by welding or the like across the vertical member 267 and the attachment member 266. As illustrated in FIG. 22, the vertical member 267 is located forward of the pillar member 223.

As illustrated in FIGS. 32 and 33, the first bracket member 269 is fixed forward of the vertical member 267, and the second bracket member 270 is fixed rearward of the vertical member 267. One of the IPU 59 and the DCU 60 is attached to the first bracket member 269, and the other of the IPU 59 and the DCU 60 is attached to the second bracket member 270. In the second embodiment, since the DCU 60 is located forward of the IPU 59, the first bracket member 269 is structured to attach the DCU 60, and the DCU 60 is attached to the first bracket member 269. Also, the second bracket member 270 is structured to attach the IPU 59, and the IPU 59 is attached to the second bracket member 270.

Next, the structures of the first bracket member 269 and the second bracket member 270 according to the second embodiment will be described in detail.

As illustrated in FIGS. 32 and 33, the first bracket member 269 includes a bracket body 276 and a body support bracket 277. The bracket body 276 is a plate member made of a metal plate material. The bracket body 276 is located forward of the vertical member 267 with a space therebetween such that plate surfaces face in the machine-body width direction K2.

The body support bracket 277 supports the bracket body 276 with respect to the vertical member 267. The body support bracket 277 includes a support body 277A and a reinforcing plate 277B. The support body 277A is made of a channel steel and is located to extend from the upper portion of the vertical member 267 to a right surface of the bracket body 276 such that an opening faces leftward and extends in the front-rear direction K1. A rear portion of the support body 277A abuts on a front surface of the upper portion of the vertical member 267 and is fixed to the front surface by welding or the like. Thus, the support body 277A protrudes forward from the upper portion of the vertical member 267. A front portion of the support body 277A is fixed to a middle portion in the up-down direction of the right surface of the bracket body 276 by welding or the like. The reinforcing plate 277B is provided across the right surface of the vertical member 267 and a right surface of the support body 277A and is fixed to the vertical member 267 and the support body 277A by welding or the like.

The device back surface of the DCU 60 is attached to a left side of the bracket body 276. Specifically, as illustrated in FIG. 32, the bracket body 276 includes a plurality of cover attachment portions 276a. Attachment pieces 73a at four corners of the cover 73 are attached to the cover attachment portions 276a by screws 278 or the like. The case 72 is also attached to the bracket body 276 by screws 279 (see FIG. 33) or the like.

As illustrated in FIGS. 28, 32, and 33, the bracket body 276 has cutouts 295 corresponding to communication antennas 92. The communication antennas 92 have directivity in the plate thickness direction of the electronic substrate 91. The cover 73 is made of resin, and the portions of the bracket body 276 corresponding to the communication antennas 92 are cut out so as not to disturb radio wave directivity of the communication antennas 92.

As illustrated in FIG. 32, the working machine 1 includes a cover 281 that covers the right surface (a side opposite to a side on which the DCU 60 is attached) of the bracket body 276. The cover 281 is made of resin and in a shape that covers the bracket body 276, the front portion of the support body 277A, and a peripheral edge portion of the DCU 60 (cover 73) from the right. The cover 281 improves the appearance.

The cover 281 is attached to the support body 277A by screws 280 (see FIG. 33). Since the cover 281 is made of resin, the cover 281 does not disturb the radio wave directivity of the communication antennas 92.

In the case where the communication unit 58 is mounted on the cabin-equipped working machine 1, as illustrated in FIG. 34, the left side panel 15A of the cabin 15 is located at the opposite side of the console 44R from the seat 6 in the machine-body width direction K2, and therefore the above-described cover 281 that covers the right surface of the bracket body 276 can be omitted.

As illustrated in FIGS. 32 and 33, the second bracket member 270 is made of a plate material and is located rearward of the vertical member 267 such that plate surfaces face in the machine-body width direction K2. A front end of the second bracket member 270 abuts on a rear surface of the vertical member 267 and is fixed to the rear surface by welding or the like. A cutout 282 is in a lower portion of the second bracket member 270. The cutout 282 extends from a middle portion in the front-rear direction K1 of the second bracket member 270 to a rear end and is open downward and rearward. As illustrated in FIG. 33, the second bracket member 270 includes device attachment portions 270a at a front and lower portion and a rear and upper portion. Nut members 283 are fixed to right surfaces of the respective device attachment portions 270a. As illustrated in FIG. 32, attachment bosses 59b are provided at a front and lower portion and a rear and upper portion of the IPU 59. The IPU 59 is located on a left surface of the second bracket member 270 and is fixed to the second bracket member 270 by bolts (not illustrated) that penetrate the attachment bosses 59b and the device attachment portions 270a of the second bracket member 270 and are screwed into the nut members 283.

As described above, the first bracket member 269 is provided to extend forward in a plan view, and the second bracket member 270 is provided to extend rearward from the vertical member 267 in a plan view, from the vertical member 267 extending in the up-down direction. Therefore, the unit bracket 265 can be compactly located at the opposite side (rightward) of the console 44R from the seat 6.

Also, the bracket body 276 to which the DCU 60 is attached and the second bracket member 270 to which the IPU 59 is attached are arranged in the front-rear direction K1 such that the plate thickness directions coincide with the machine-body width direction K2, the DCU 60 is attached to the bracket body 276 such that the thickness direction coincides with the machine-body width direction K2, and the IPU 59 is attached to the second bracket member 270 such that the thickness direction coincides with the machine-body width direction K2. Therefore, the communication unit 58 and the unit bracket 265 can be compactly provided at the opposite side of the console 44R from the seat 6.

As illustrated in FIGS. 32 and 33, the attachment stay 271 is made of a plate material and includes an upper wall 271a fixed to a lower end of the vertical member 267 by welding or the like, a side wall 271b extending downward from a right end of the upper wall 271a, and a reinforcing plate 271c fixed across the upper wall 271a and the side wall 271b.

As illustrated in FIG. 28, the side wall 271b of the attachment stay 271 is fixed to a side wall portion 226b of the fixing member 226 by bolts 286 or the like. Accordingly, the support of the lower portion of the vertical member 267 (the support of the unit bracket 265) can be stable and the support of the upper portion of the attachment bracket 236 can be stable. Also, since the attachment stay 271 is fixed to the lower end of the vertical member 267 located forward of the pillar member 223 and is located forward of the pillar member 223 in a shifted manner, the pillar member 223 does not hinder attachment of the attachment stay 271 when the attachment stay 271 is fixed to the fixing member 226 by the bolts.

As illustrated in FIGS. 32 and 33, the attachment member 266 is provided with a fuse stay 287 to which a fuse 68 for the DCU 60 (see FIG. 25) is attached. The fuse stay 287 is structured such that a lower portion of the fuse stay 287 is fixed to a lower side of a front portion of the attachment member 266, and an intermediate portion of the fuse stay 287 in the up-down direction is inclined to extend diagonally leftward and upward such that that an upper portion is displaced leftward from the lower portion. The fuse 68 is attached to the upper portion of the fuse stay 287. Since the upper portion of the fuse stay 287 is shifted leftward with respect to the lower portion, the fuse 68 can be moved away leftward from the cover 281, and the fuse 68 can be easily attached and detached.

As illustrated in FIG. 33, a clamp stay 290 for attaching a clamp 288 (see FIG. 25) that holds the harness 64 is fixed to a rear portion of the second bracket member 270.

In the case of a working machine 1 provided with a support bracket that supports the console 44R as an existing member, the communication unit 58 can be easily mounted on the existing working machine 1 by retrofitting by replacing the support bracket with the support bracket 222 of the second embodiment.

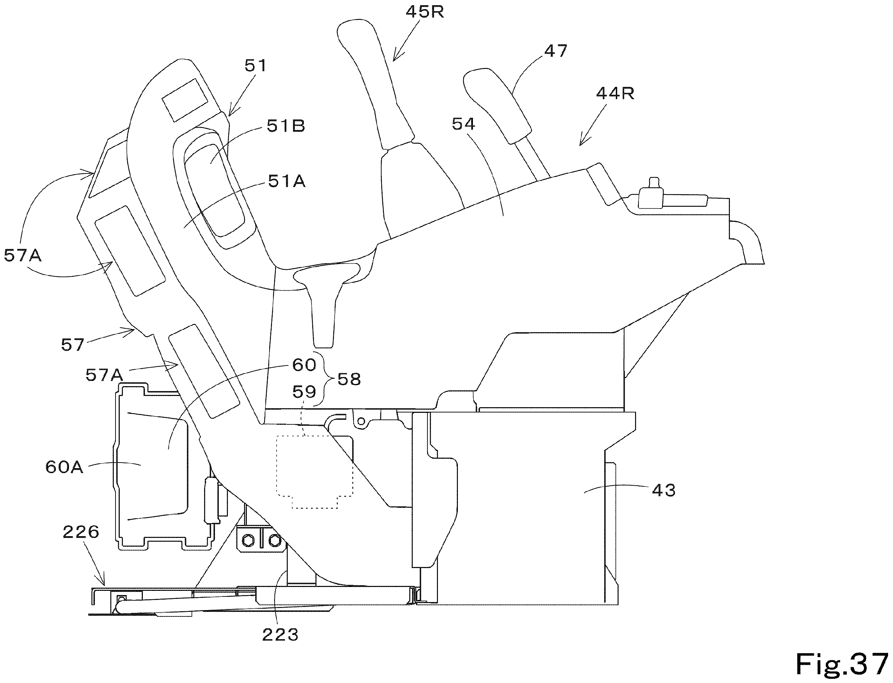

FIG. 37 illustrates an embodiment in which the communication unit 58 is mounted on a cabin-equipped working machine 1.

As illustrated in FIG. 37, an air conditioner duct 57 that circulates conditioned air is located forward of the meter 51. The air conditioner duct 57 extends from an air conditioner body provided inside the seat base 43 toward a front surface of the meter 51. The air conditioner duct 57 is provided with a blowout portion 57A that blows out the conditioned air.

Also in the case of this embodiment, the device front surface 60A of the DCU 60 faces inward in the machine-body width direction K2, and the device front surface 60A of the DCU 60 is positioned such that most of the device front surface 60A is exposed forward of the air conditioner duct 57. Accordingly, communication performance of the DCU 60 is ensured.

Also, in the case of the embodiment illustrated in FIG. 37, the harness 64 connected to the connection portion 60a of the DCU 60 and the harness 64 connected to the connection portion 59a of the IPU 59 and the fuse 68 are covered by the air conditioner duct 57 laterally from the seat 6 side, and therefore the cover member 239 in the above-described main embodiment can be omitted.

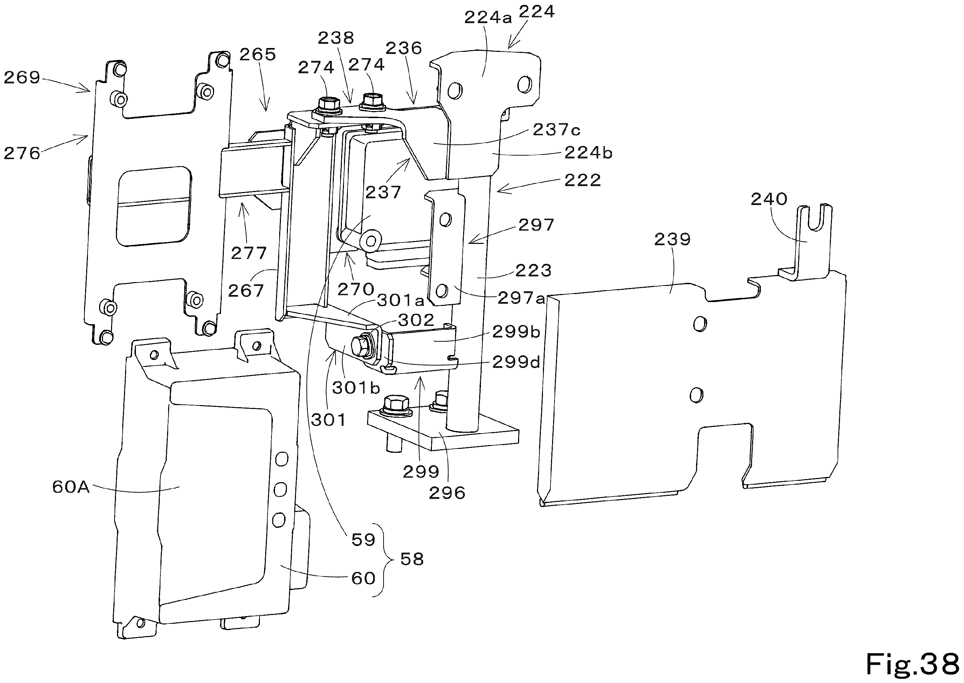

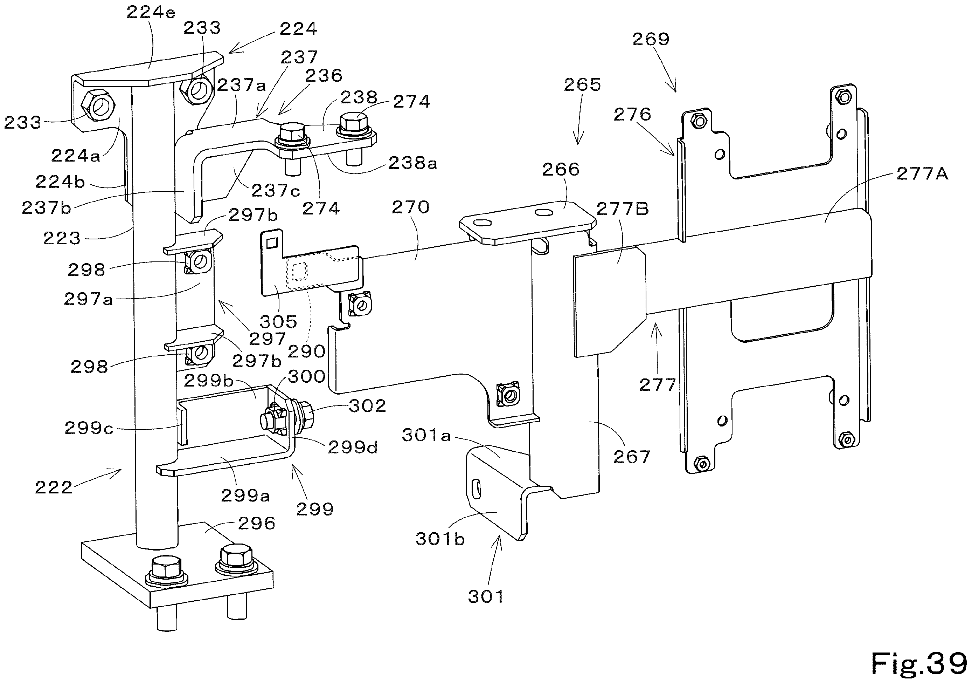

FIGS. 38 and 39 illustrate an attachment structure of the communication unit 58 according to another variation.

In the embodiment according to FIGS. 38 and 39, a pillar member 223 of a support bracket 222 is made of a columnar rod material having an axis extending in the up-down direction. A base plate 296 is fixed to a lower end of the pillar member 223.

A cover attachment bracket 297 for attaching a cover member 239 is fixed to a middle portion in the up-down direction of the pillar member 223. The cover attachment bracket 297 is made of a plate material and includes an attachment plate portion 297a positioned such that plate surfaces face in the machine-body width direction K2, and reinforcing plate portions 297b provided at an upper portion and a lower portion of the attachment plate portion 297a. The attachment plate portion 297a and the reinforcing plate portions 297b are fixed to the pillar member 223 by welding or the like. A pair of upper and lower nut members 298 are fixed to a right surface of the attachment plate portion 297a. The cover member 239 is fixed by bolts (not illustrated) that penetrate the cover member 239 and the attachment plate portion 297a and are screwed into the nut members 298.

A bracket plate 224 includes an upper wall 224e extending rightward from an upper end of a first section 224a. The upper wall 224e and a second section 224b are welded to the pillar member 223.

A fixing portion 237 of an attachment bracket 236 includes a first wall portion 237a, a second wall portion 237b, and a third wall portion 237c. The first wall portion 237a is provided such that plate surfaces face in the up-down direction and is located forward of an upper portion of the pillar member 223. The second wall portion 237b extends downward from a rear end of the first wall portion 237a. The third wall portion 237c extends downward from a left end of the first wall portion 237a. The second wall portion 237b of the fixing portion 237 is fixed to the pillar member 223 by welding or the like. The third wall portion 237c of the fixing portion 237 is fixed to the second section 224b of the bracket plate 224 by welding or the like.

A fixing bracket 299 is fixed to a lower portion of the support bracket 222. The fixing bracket 299 is provided to protrude forward from the lower portion of the pillar member 223. Specifically, the fixing bracket 299 includes a lower wall 299a protruding forward from the pillar member 223 and having a rear end fixed to the pillar member 223, a side wall 299b extending upward from a left end of the lower wall 299a, an extension wall 299c extending rightward from a rear end of the side wall 299b and fixed to the pillar member 223, and a front wall 299d extending upward from a front end of the lower wall 299a. A nut member 300 is fixed to a rear surface of the front wall 299d.

A unit bracket 265 includes a coupling stay 301 fixed to a lower portion of a vertical member 267. The coupling stay 301 is coupled to the fixing bracket 299. Specifically, the coupling stay 301 includes an upper wall 301a extending leftward from the lower portion of the vertical member 267, and a rear wall 301b extending downward from a rear end of the upper wall 301a.

The rear wall 301b of the coupling stay 301 is overlapped with the front wall 299d of the fixing bracket 299 and is fixed to the front wall 299d by a bolt member 302 that penetrates the rear wall 301b and the front wall 299d and is screwed into the nut member 300.

The working machine 1 in which the communication unit 58 of the embodiment according to FIGS. 38 and 39 is mounted is a backhoe provided with an offset type working device including a boom with a structure capable of offsetting an arm in the machine-body width direction K2.

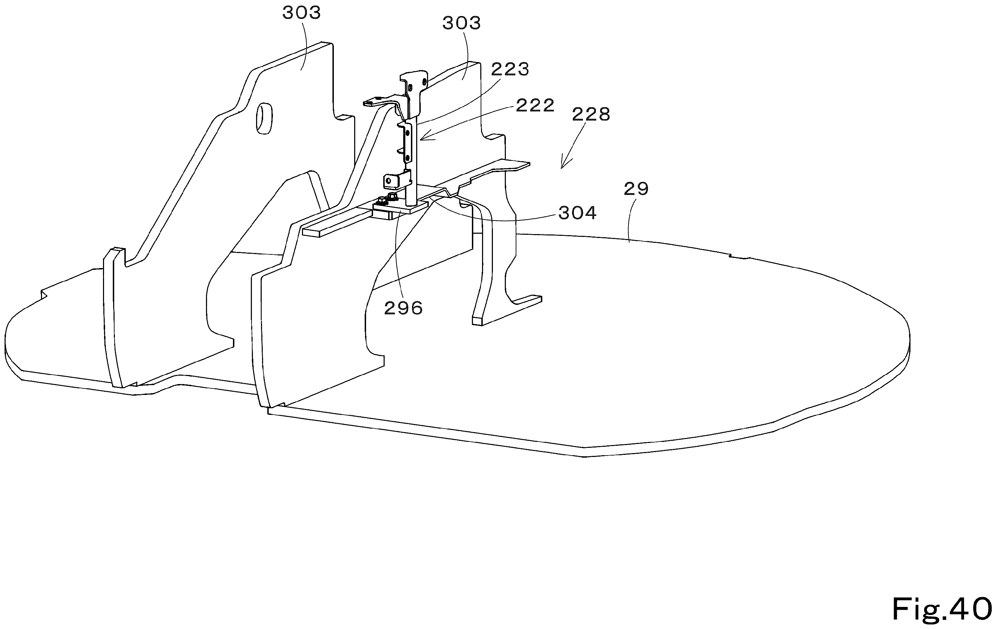

As illustrated in FIG. 40, in the backhoe including the offset type working device, a pair of support plates 303 arranged in the machine-body width direction K2 are fixed on a turning base plate 29. A proximal portion of the boom is pivotally supported between the pair of support plates 303. The base plate 296 of the support bracket 222 is fixed by bolts to a fixing plate 304 fixed to one of the support plates 303.

Thus, in the embodiment according to FIGS. 38 and 39, the above-described fixing member 226 is not provided on the machine body 2. Therefore, in the embodiment according to FIGS. 38 and 39, the fixing bracket 299 is fixed to the lower portion of the pillar member 223 of the support bracket 222, the coupling stay 301 is fixed to the lower portion of the vertical member 267 of the unit bracket 265, and the coupling stay 301 is coupled to the fixing bracket 299. Therefore, the support of a lower portion of the unit bracket 265 is stable.

Additionally, in this embodiment, as illustrated in FIG. 39, a fuse stay 305 to which the fuse 68 for the DCU 60 is attached is fixed to a second bracket member 270. A proximal portion of the fuse stay 305 is fixed to a proximal portion of a clamp stay 290.

The other configurations are substantially similar to those of the above-described main embodiment illustrated in FIGS. 19 to 33.

A working machine 1 according to the second embodiment includes a machine body 2; a seat 6 on the machine body 2; a console 44R located at one side of the seat 6; a communication unit 58; a unit bracket 265 to which the communication unit 58 is attached; a support bracket 222 vertically provided directly or indirectly on the machine body 2 to support the console 44R; and an attachment bracket 236 provided at the support bracket 222 to attach the unit bracket 265.

With this configuration, since the communication unit 58 and the unit bracket 265 to which the communication unit 58 is attached are attached, via the attachment bracket 236, to the support bracket 222 that is vertically provided directly or indirectly on the machine body 2 to support the console 44R, the structure for attaching the communication unit 58 can be made compact.

The communication unit 58 includes an information processing device (IPU 59) and a communication device (DCU 60) to receive data from and transmit data to the information processing device 59, the communication device 60 containing a communication antenna 92 and configured to transmit data. The information processing device 59 and the communication device 60 are arranged in a front-rear direction K1.

With this configuration, the information processing device 59 and the communication device 60 can be provided on the opposite side of the console 44R from the seat 6 in a compact manner.

The communication device 60 includes an electronic substrate 91 with the communication antenna 92 attached on an obverse side thereof, and a case 72 to house the electronic substrate 91 such that the obverse side faces in the same direction as a device front surface 60A of the communication device 60, and the device front surface 60A is positioned to face a space above a floor portion located forward of the seat 6.

With this configuration, communication performance of the communication device 60 can be ensured.

The unit bracket 265 includes an attachment member 266 attached to the attachment bracket 236, a vertical member 267 extending in an up-down direction and including an upper portion to which the attachment member 266 is fixed, a first bracket member 269 fixed forward of the vertical member 267, and a second bracket member 270 fixed rearward of the vertical member 267. One of the information processing device 59 and the communication device 60 is attached to the first bracket member 269, and the other of the information processing device 59 and the communication device 60 is attached to the second bracket member 270.

With this configuration, the information processing device 59, the communication device 60, and the unit bracket 265 can be provided on the opposite side of the console 44R from the seat 6 in a compact manner.

The attachment bracket 236 is provided at an upper portion of the support bracket 222 such that the attachment bracket 236 protrudes sideways from the support bracket 222 away from the seat 6, and includes an attachment wall 238 including an attachment surface 238a facing in the up-down direction. The attachment member 266 is attached to the attachment wall 238 such that the attachment member 266 and the attachment wall 238 overlap each other in the up-down direction.

With this configuration, the unit bracket 265 can be attached to the attachment bracket 236 from above, making it possible to improve the ease of attaching the unit bracket 265.

The working machine 1 further includes a fixing member 226 which is attached to the machine body 2 and to which a lower portion of the support bracket 222 is attached. The unit bracket 265 includes an attachment stay 271 fixed to a lower portion of the vertical member 267 and attached to the fixing member 226.

With this configuration, the unit bracket 265 can be supported stably.

The working machine 1 further includes a fixing bracket 299 fixed to a lower portion of the support bracket 222. The unit bracket 265 includes a coupling stay 301 fixed to a lower portion of the vertical member 267 and coupled to the fixing bracket 299.

Also with this configuration, the unit bracket 265 can be supported stably.

The working machine 1 further includes a harness 64 connected to the communication unit 58; and a cover member 239 attached to the support bracket 222 to cover a side of the harness 64 that faces inward along a machine-body width direction K2.

With this configuration, the harness 64 can be protected by the cover member 239.

The working machine 1 further includes a harness 64 connected to the communication unit 58, the harness 64 being for use for both working machines 1 including a cabin on the machine body 2 and working machines 1 including no cabins on the machine body 2.

With this configuration, when the communication unit 58 is provided on a working machine 1 in which the cabin is provided and when the communication unit 58 is provided in a working machine 1 in which the cabin is not mounted, the communication unit 58 can be mounted without having to replace the harness 64.

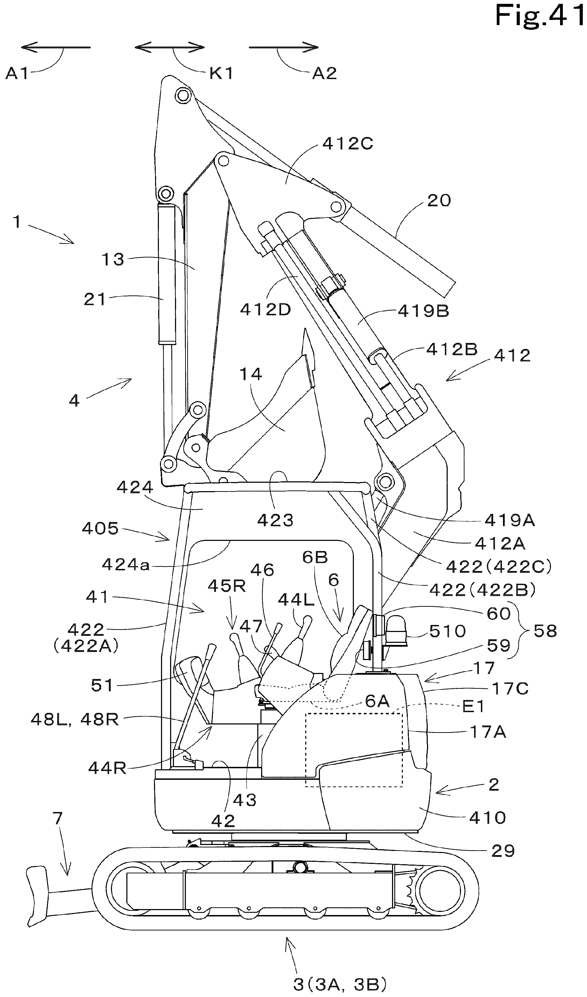

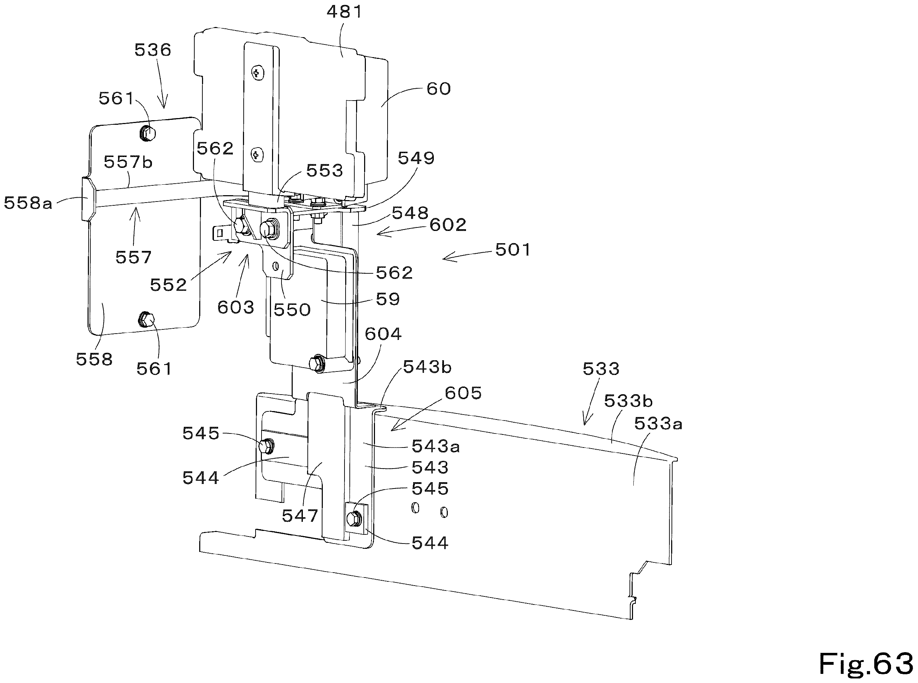

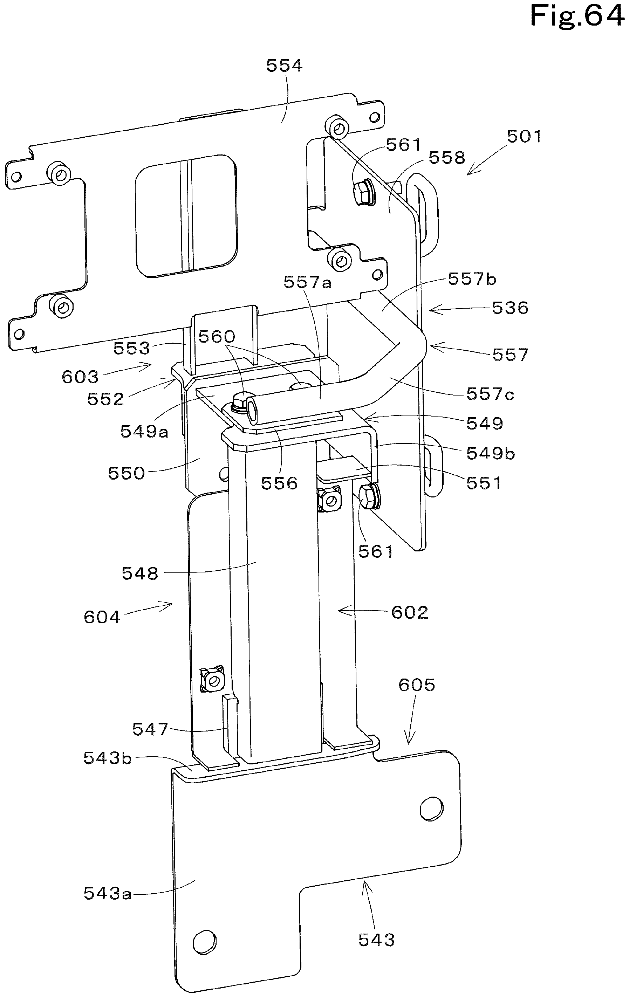

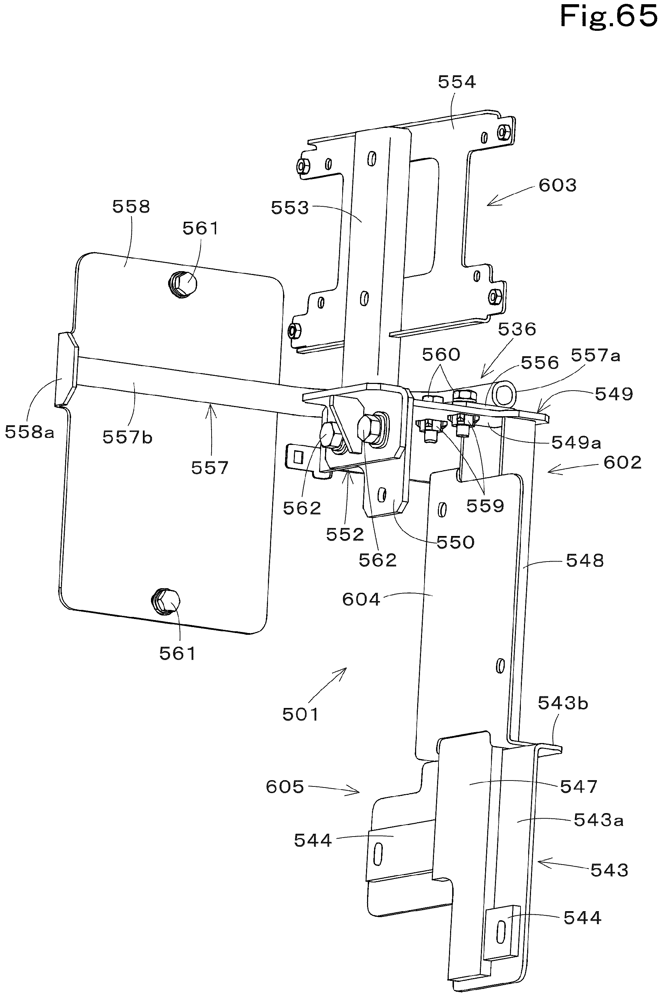

FIGS. 41 to 65 illustrate a third embodiment. In the third embodiment, similar reference numerals are given to points similar to those in the above-described first and second embodiments, and the description thereof will be omitted. Points different from those in the above-described first and second embodiments will be mainly described.

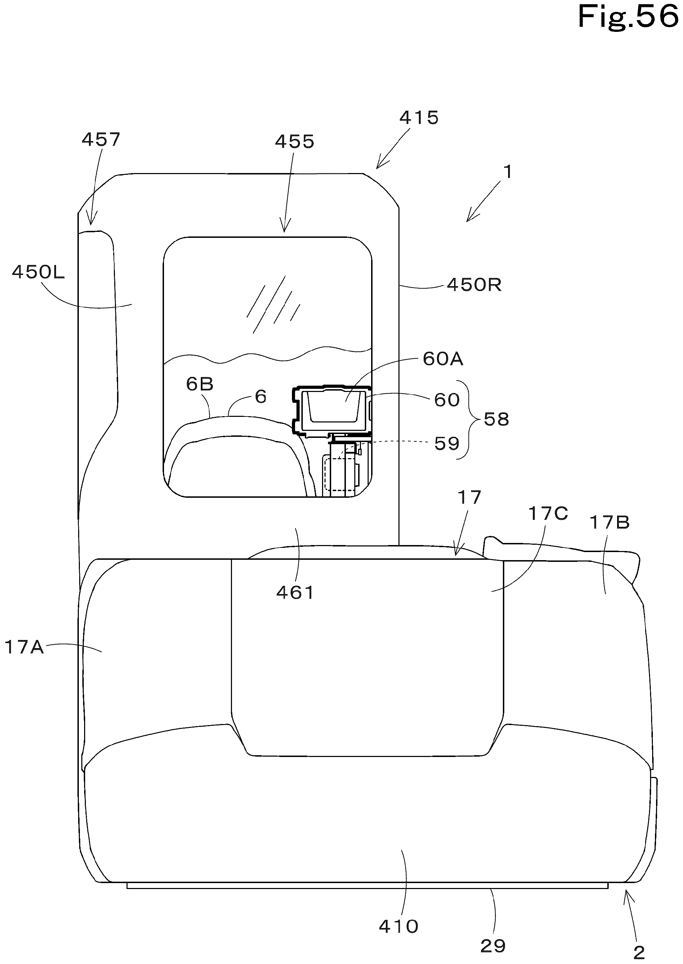

In the third embodiment, FIGS. 41 to 55 illustrate a main embodiment. FIGS. 56 to 65 illustrate an embodiment according to a variation.

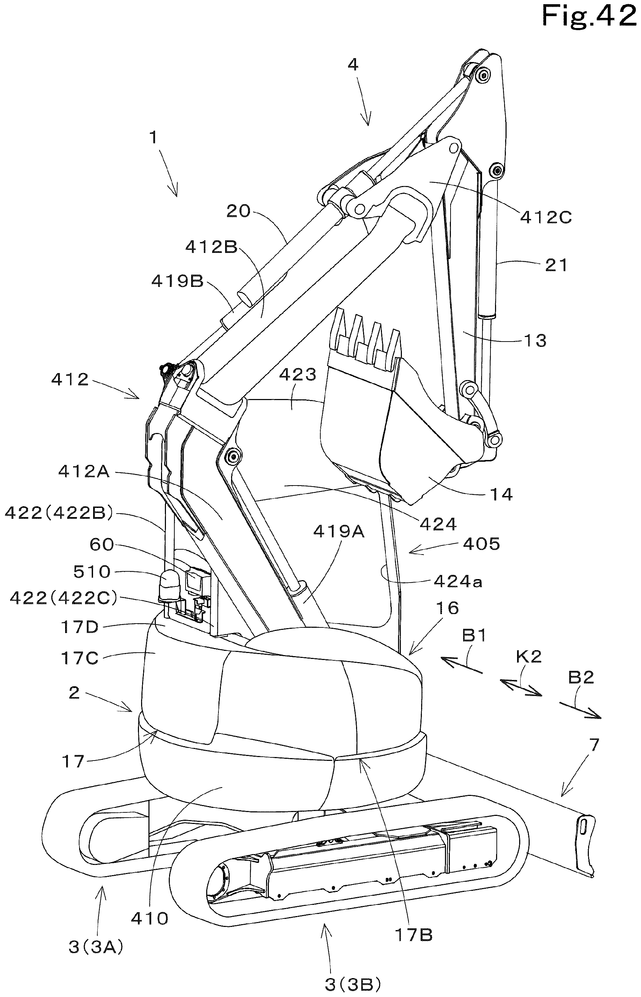

FIG. 41 is a side view illustrating an overall configuration of a working machine 1 according to the third embodiment. FIG. 42 is a perspective view illustrating the overall configuration of the working machine 1. Also in the third embodiment, a backhoe (ultrasmall radius turning backhoe) is exemplified as the working machine 1.

As illustrated in FIGS. 41 and 42, the working machine 1 includes a machine body (turning base) 2, a traveling device 3, a front working device (working device) 4, and a canopy 405. The canopy 405 is a seat protector that protects a seat 6 mounted on the machine body 2.

The working machine 1 exemplified in FIGS. 41 and 42 is the working machine (canopy-equipped working machine) 1 in which the canopy 405 is mounted, but a working machine (cabin-equipped working machine) 1 in which a cabin surrounding and protecting the seat 6 is mounted as a seat protector instead of the canopy 405 may be used, or a working machine 1 not including the canopy 405 or the cabin may be used.

As illustrated in FIGS. 41 and 42, the front working device 4 is attached to a front portion of the machine body 2. The front working device 4 includes an offset boom 412, an arm 13, and a working tool (bucket) 14. The offset boom 412 includes a first boom 412A, a second boom 412B, and a third boom 412C. The first boom 412A has a proximal portion pivotally supported by the machine body 2 and is swingable in the up-down direction. The second boom 412B has a proximal portion pivotally supported by a distal end portion of the first boom 412A and is swingable in the machine-body width direction K2. The third boom 412C has a proximal portion pivotally supported by a distal end portion of the second boom 412B and is swingable in the machine-body width direction K2. The first boom 412A is driven by a boom cylinder 419A. The second boom 412B is driven by an offset cylinder 419B. An offset link 412D is located lower than the offset cylinder 419B. The offset link 412D is provided across the first boom 412A and the third boom 412C.

The arm 13 has a proximal portion pivotally supported by a distal end portion of the third boom 412C and is swingable. The working tool 14 is swingably pivotally supported by a distal end portion of the arm 13. The arm 13 is driven by an arm cylinder 20. The working tool 14 is driven by a working tool cylinder (bucket cylinder) 21. The boom cylinder 419A, the offset cylinder 419B, the arm cylinder 20, and the working tool cylinder 21 include hydraulic cylinders.

In such a front working device 4, the distal end portion of the first boom 412A, the second boom 412B, the proximal portion of the third boom 412C, and the offset link 412D define a four-joint link. The second boom 412B and the offset link 412D swing in the machine-body width direction K2 by extending or retracting the offset cylinder 419B. Therefore, the third boom 412C, the arm 13, the working tool (bucket) 14, and the like are offset to one side or another side in the machine-body width direction K2 with respect to the first boom 412A.

As illustrated in FIGS. 41 and 42, the canopy 405 includes a plurality of pillar members 422, a roof 423, and a side surface panel portion 424. The plurality of pillar members 422 include a front pillar 422A located rightward and forward of the seat 6, and a first rear pillar 422B and a second rear pillar 422C arranged in the machine-body width direction K2 near a rear portion of the machine body 2. The roof 423 covers a space above an operation section 41 (described later). The side surface panel portion 424 extends downward from a right portion of the roof 423. The side surface panel portion 424 has a window opening 424a in which a transparent panel (glass panel) is fitted.

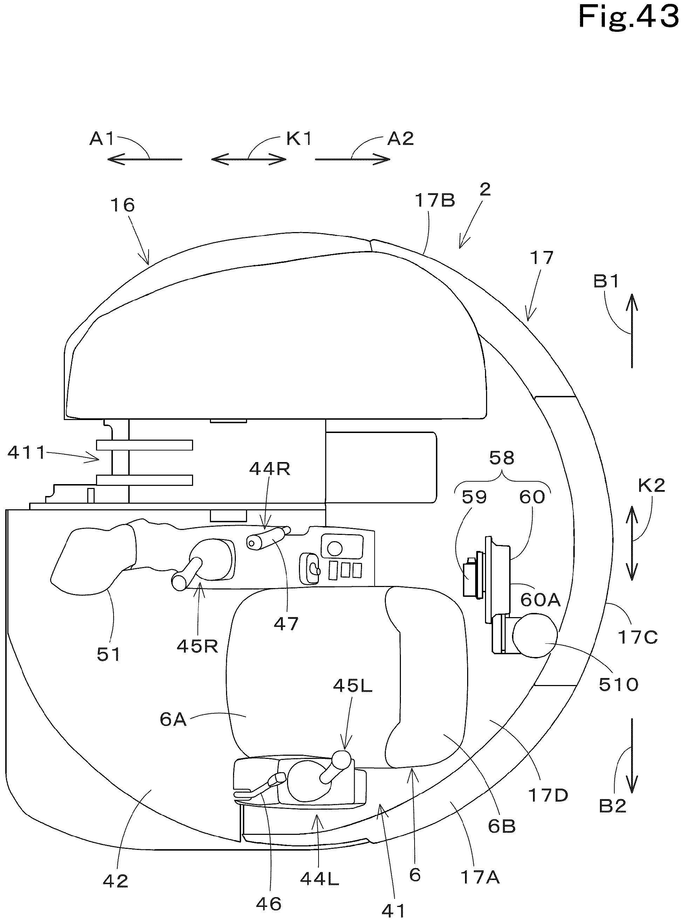

As illustrated in FIG. 43, the rear portion of the machine body 2 is in a curved shape (arc shape) that is convex rearward in a plan view. Specifically, the rear portion of the machine body 2 is in a convex curved shape in which a central portion in the machine-body width direction K2 protrudes most rearward.

As illustrated in FIG. 43, an operation section 41 is located on one side portion (left portion) of the machine body 2 in the machine-body width direction K2. A cover body 16 that houses devices (for example, a hydraulic fluid tank, a control valve, a battery, and the like) mounted on the machine body 2 is provided on another side portion (right portion) of the machine body 2 in the machine-body width direction K2. An attachment portion 411 is provided between the operation section 41 and the cover body 16 in the machine body 2. The front working device 4 is attached to the attachment portion 411.

As illustrated in FIG. 43, the seat 6 is provided at a position deviated in a first direction (leftward) along the machine-body width direction K2 from the central portion of the machine body 2 in the machine-body width direction K2. As illustrated in FIGS. 41 and 43, the seat 6 includes a seat portion 6A and a backrest portion 6B. The backrest portion 6B is provided at a rear portion of the seat portion 6A such that the backrest portion is reclineable.

As illustrated in FIGS. 42 and 43, the operation section 41 includes a console (operator base) 44L located at one of opposite sides (one side) of the seat 6 in the machine-body width direction K2, and a console (operator base) 44R located at the other of the opposite sides (the other side) of the seat 6 in the machine-body width direction K2. Specifically, the console 44L is located leftward of the seat 6, and the console 44R is located rightward of the seat 6.

The console 44L is provided with an unloading lever 46 and a manual operator 45L. A state of the console 44L illustrated in FIG. 41 indicates a state in which the unloading lever 46 is swung upward.

The left manual operator 45L and the right manual operator 45R each can operate two operation targets. For example, the manual operator 45L can perform a turn operation of the machine body 2 and a swing operation of the arm 13. The manual operator 45R can perform a swing operation of the first boom 412A and a swing operation of the working tool 14.

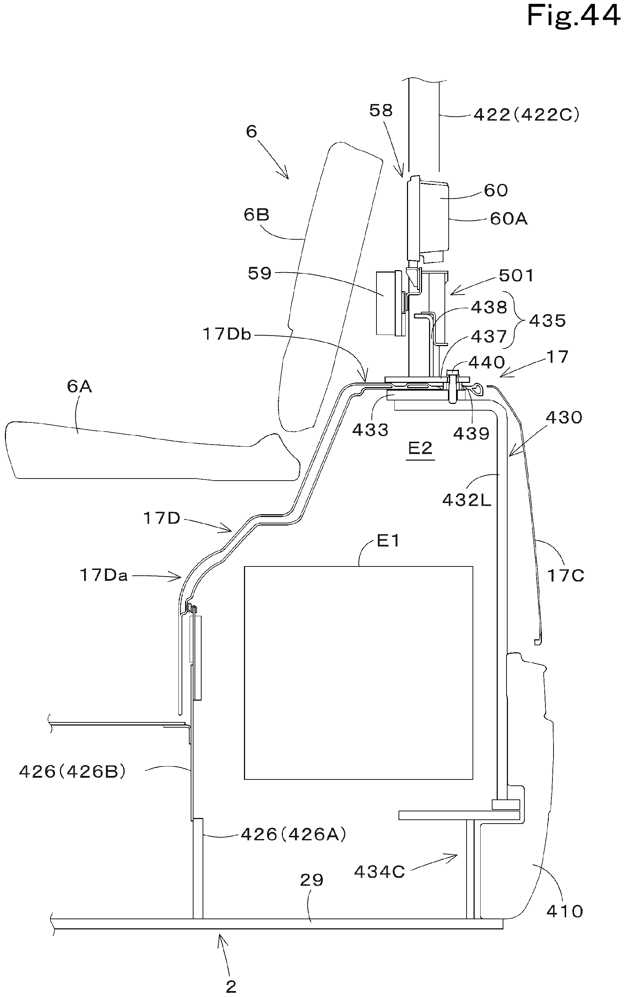

As illustrated in FIGS. 41, 42, 43, and 44, a prime mover (engine) E1 is mounted on the rear portion of the machine body 2. Additionally, a hood 17 defining a prime mover chamber E2 that houses the prime mover E1 is provided on the rear portion of the machine body 2. The hood 17 includes a first side portion cover 17A, a second side portion cover 17B, a rear portion cover 17C, a partition wall member 17D, and the like. As illustrated in FIG. 41, the first side portion cover 17A covers the left of the prime mover E1. As illustrated in FIG. 42, the second side portion cover 17B covers the right of the prime mover E1. The rear portion cover 17C covers the rear of the prime mover E1. The rear portion cover 17C has an upper portion that is rotatable about an axis extending in the machine-body width direction K2 by a hinge. The rear portion cover 17C is swingable in the up-down direction. That is, the rear portion cover 17C swings in the up-down direction to open and close the prime mover chamber E2. As illustrated in FIG. 44, the partition wall member 17D includes a partition wall body 17Da that covers the front of the prime mover E1 and separates the prime mover chamber E2 from the operation section 41 (area where the seat 6 is), and an upper wall portion 17Db that covers the upper side of the prime mover E1.

As illustrated in FIG. 44, the prime mover chamber E2 is defined by the above-described hood 17, a turning base plate (base plate) 29, a plurality of partition plates 426 (first partition plate 426A, second partition plate 426B, and third partition plate 426C), a weight 410, and the like.

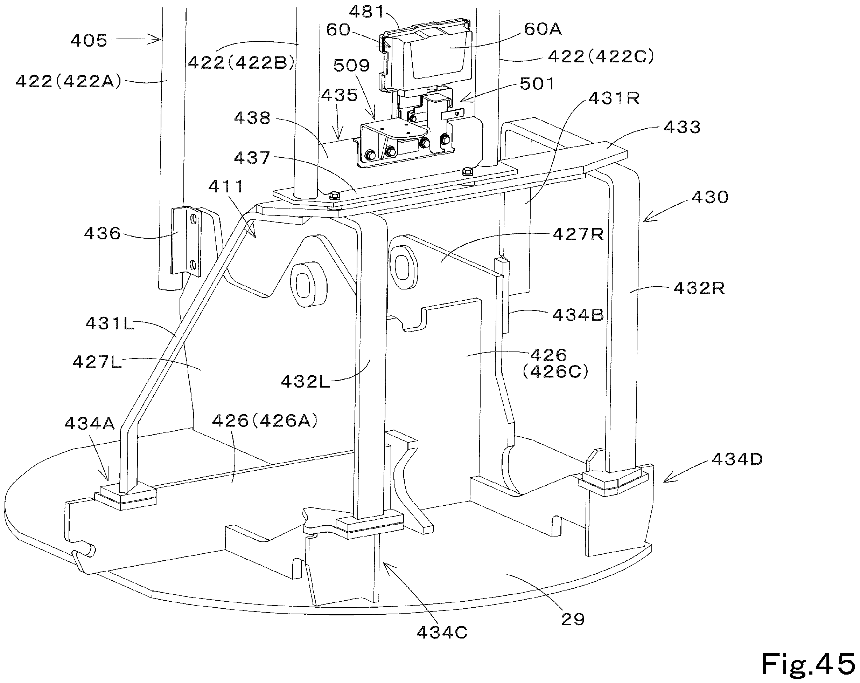

As illustrated in FIG. 45, the turning base plate 29 is made of a thick plate material and defines a bottom portion of the machine body 2. The first partition plate 426A is located such that plate surfaces face in the front-rear direction and is vertically provided on a left portion of the turning base plate 29. As illustrated in FIG. 44, the second partition plate 426B is fixed to an upper portion of the first partition plate 426A. A lower portion of the partition wall body 17Da of the partition wall member 17D is attached to the second partition plate 426B. The third partition plate 426C is located at a rear portion of the attachment portion 411. Specifically, the attachment portion 411 includes a left support plate 427L located at a left end portion of the attachment portion 411 and vertically provided on the turning base plate 29, and a right support plate 427R located at a right end portion of the attachment portion 411 and vertically provided on the turning base plate 29. The third partition plate 426C is provided at rear portions of the left support plate 427L and the right support plate 427R across the support plates 427L and 427R. The first partition plate 426A and the second partition plate 426B are located leftward of the support plate 427L. The proximal portion of the first boom 412A and a lower end portion of the boom cylinder 419A are pivotally supported between the support plate 427L and the support plate 427R.

As illustrated in FIGS. 41, 42, and 44, the weight 410 defines the rear portion of the machine body 2. The weight 410 is attached to a rear portion of the turning base plate 29.

As illustrated in FIGS. 44 and 45, a support frame 430 that supports the hood 17 and devices and components in the prime mover chamber E2 is provided inside the prime mover chamber E2. The support frame 430 is mounted on the machine body 2. Specifically, the support frame 430 includes a left front leg 431L, a right front leg 431R, a left rear leg 432L, a right rear leg 432R, and a top plate 433. The left front leg 431L is attached to a fixing member 434A fixed to the first partition plate 426A. The right front leg 431R is attached to the support plate 427R via an attachment member 434B. The left rear leg 432L is attached to a fixing member 434C fixed to the turning base plate 29. The right rear leg 432R is attached to a fixing member 434D fixed to the turning base plate 29. The top plate 433 is located such that plate surfaces face in the up-down direction and is located across upper portions of the right front leg 431R and the right rear leg 432R, and upper portions of the left front leg 431L and the left rear leg 432L. Also, the top plate 433 is fixed to the upper portions of the left front leg 431L, the right front leg 431R, the left rear leg 432L, and the right rear leg 432R by welding or the like.

As illustrated in FIG. 45, the canopy 405 includes an attachment frame 435 provided across a lower portion of the first rear pillar 422B and a lower portion of the second rear pillar 422C. The attachment frame 435 is attached to the support frame 430. Accordingly, a rear portion of the canopy 405 is supported. A lower portion of the front pillar 422A is attached to the support plate 427L via a stay 436. Accordingly, a front portion of the canopy 405 is supported.

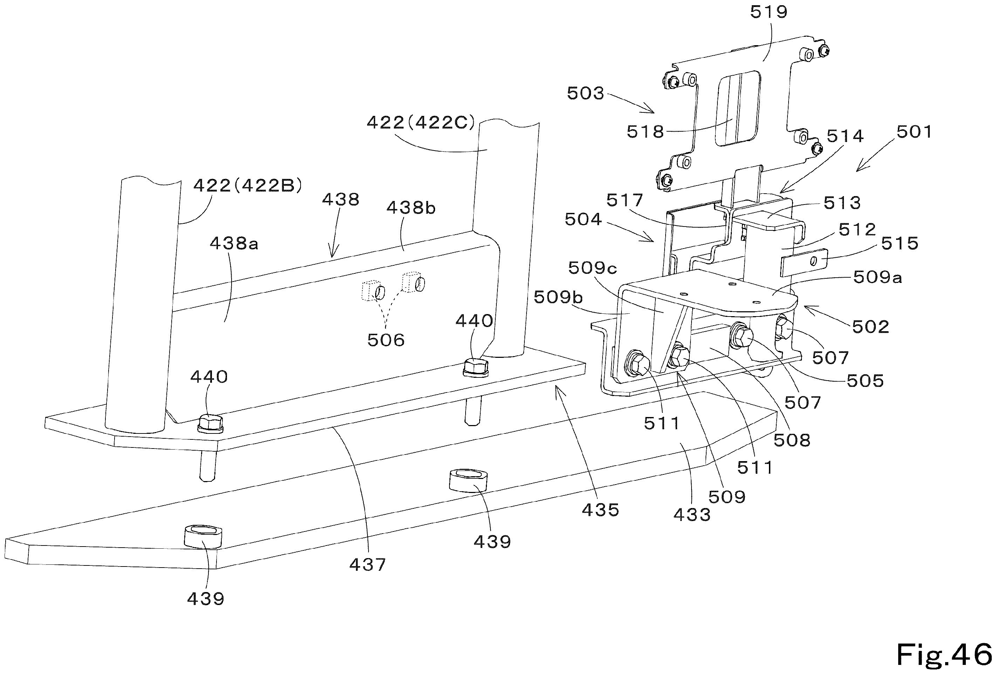

As illustrated in FIGS. 45 and 46, the attachment frame 435 includes a base member 437 and a vertical plate 438. The base member 437 is made of a plate material and is located across a lower end of the first rear pillar 422B and the second rear pillar 422C such that plate surfaces face in the up-down direction. The lower end of the first rear pillar 422B is fixed to an upper surface of a left portion of the base member 437 by welding or the like. A lower end of the second rear pillar 422C is fixed to an upper surface of a right portion of the base member 437 by welding or the like.

The base member 437 is attached to the top plate 433 of the support frame 430 via vibration isolation members 439. Specifically, as illustrated in FIG. 44, the base member 437 is located above the upper wall portion 17Db of the partition wall member 17D, and the vibration isolation members 439 are placed on the top plate 433 and penetrate the upper wall portion 17Db to abut on a lower surface of the base member 437. Thus, the base member 437 is supported by the top plate 433 in a vibration-isolating manner. The base member 437 is fixed to the top plate 433 by bolt members 440 that penetrate the base member 437 and the vibration isolation members 439 and are screwed into the top plate 433 from above.

As illustrated in FIG. 46, the vertical plate 438 is located between the lower portions of the first rear pillar 422B and the second rear pillar 422C such that plate surfaces face in the front-rear direction K1 and is vertically provided on the base member 437. The vertical plate 438 is fixed to the base member 437, the first rear pillar 422B, and the second rear pillar 422C by welding or the like. The vertical plate 438 includes a main plate portion 438a vertically provided on the base member 437 and an upper wall portion 438b extending forward from an upper end of the main plate portion 438a.

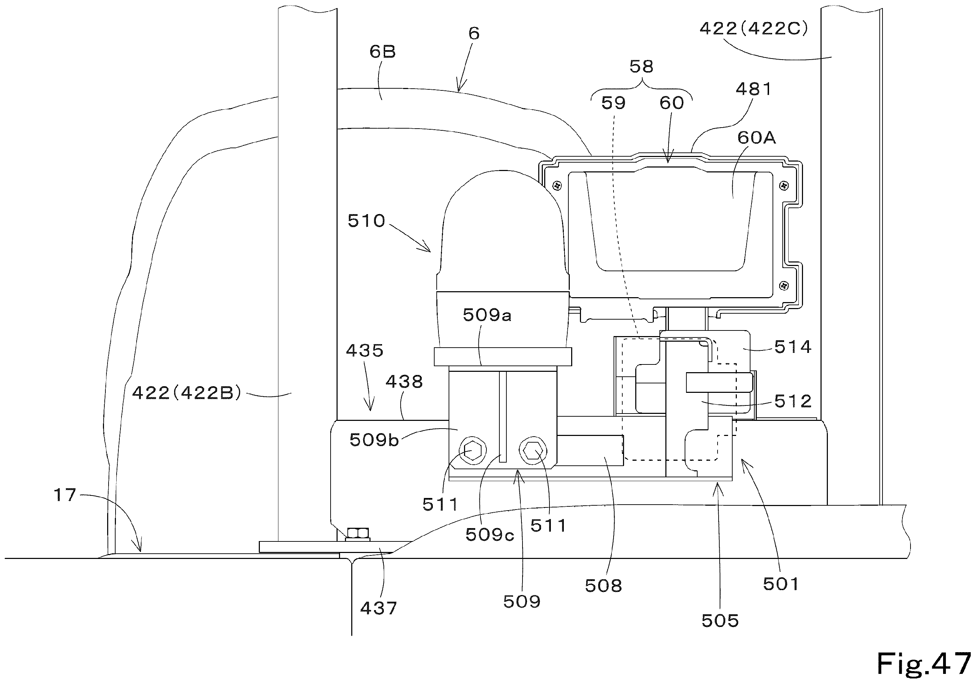

As illustrated in FIG. 43, a communication unit 58 is mounted on the working machine 1. The communication unit 58 is located rearward of the console 44R. Specifically, the communication unit 58 is located rearward of the seat 6 at the other side (right) of the seat 6 in the machine-body width direction K2. In other words, the communication unit 58 is located rightward of a central portion of the seat 6 in the machine-body width direction K2 and rearward of the seat 6, and partially overlaps a right portion of the seat 6 in a back view (see FIG. 47). Also, the communication unit 58 is located above the hood 17.

By providing the communication unit 58 rearward of the console 44R, it is possible to eliminate or reduce the likelihood that the communication unit 58 will hinder the user's view. Also, since the communication unit 58 is located rearward of the seat 6, the communication unit 58 does not hinder operations with the manual operator 45R, the dozer lever 47, and various switches. That is, the communication unit 58 is located at a position at which an arm or the like of a user does not touch the communication unit 58 when the user operates the manual operator 45R, the dozer lever 47, and various switches. That is, the communication unit 58 is located at a mounting position with proper layout with which communication performance can be ensured and operability of the manual operator 45R and the like can be ensured.

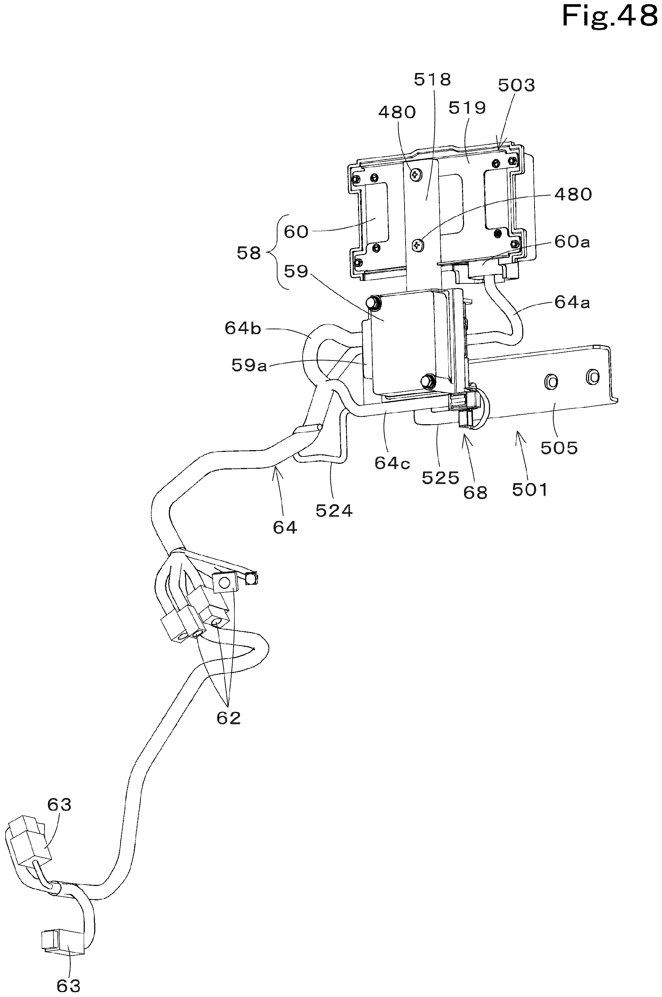

As illustrated in FIG. 48, an IPU 59 is connected to a communication port of an on-board communication network, a communication port of on-board diagnostics, and the like (not illustrated) via a harness 64 and connector(s) 62. Additionally, the harness 64 is provided with connectors 63 that connect the IPU 59 to a connection port of a harness (not illustrated) of a cabin when the communication unit 58 is provided in the working machine 1 in which the cabin is mounted. One of the connectors 63 is connected to a power supply port, and another one of the connectors 63 is connected to the connection port of the harness of the cabin.

The positions at which the communication ports of the on-board communication network and the on-board diagnostics are provided differ between the working machine 1 in which the cabin is not mounted and the working machine 1 in which the cabin is mounted. However, the harness 64 extending from the communication unit 58 to the connectors 62 is long enough to be connected to the communication ports of the on-board communication network and the on-board diagnostics in any of the case where the communication unit 58 is mounted on the working machine 1 in which the cabin is not mounted and the case where the communication unit 58 is mounted on the working machine 1 in which the cabin is mounted. Also, when the communication unit 58 is mounted on the working machine 1 in which the cabin is mounted, the connector that connects the IPU 59 to the connection port of the harness of the cabin is provided. Therefore, the harness 64 is a harness 64 that is used for both the case where the communication unit 58 is mounted on the working machine 1 in which the cabin is mounted and the case where the communication unit 58 is mounted on the working machine 1 in which the cabin is not mounted. That is, the harness 64 can be used for both the working machine 1 in which the cabin is mounted on the machine body 2 and the working machine 1 in which the cabin is not mounted on the machine body 2.

As illustrated in FIGS. 47 and 48, the IPU 59 has a substantially rectangular parallelepiped shape in which surfaces facing in the front-rear direction K1 are substantially rectangular, and is positioned vertically such that the longitudinal direction of the rectangular parallelepiped coincides with the up-down direction. Also, the IPU 59 has a substantially rectangular parallelepiped shape in which the width in the front-rear direction K1 (the width in the thickness direction) is narrower than the width in the up-down direction and the width in the machine-body width direction K2. The IPU 59 includes, at a right side thereof, a connection portion 59a to have the harness 64 connected thereto.

As illustrated in FIGS. 47 and 48, a DCU 60 has a substantially rectangular parallelepiped shape in which a device front surface 60A is substantially rectangular and is located horizontally such that the longitudinal direction of the rectangular parallelepiped coincides with the machine-body width direction K2. Also, as illustrated in FIG. 48, the DCU 60 has a substantially rectangular parallelepiped shape in which the width in the front-rear direction K1 (the width in the thickness direction) is narrower than the width in the up-down direction and the width in the machine-body width direction K2.

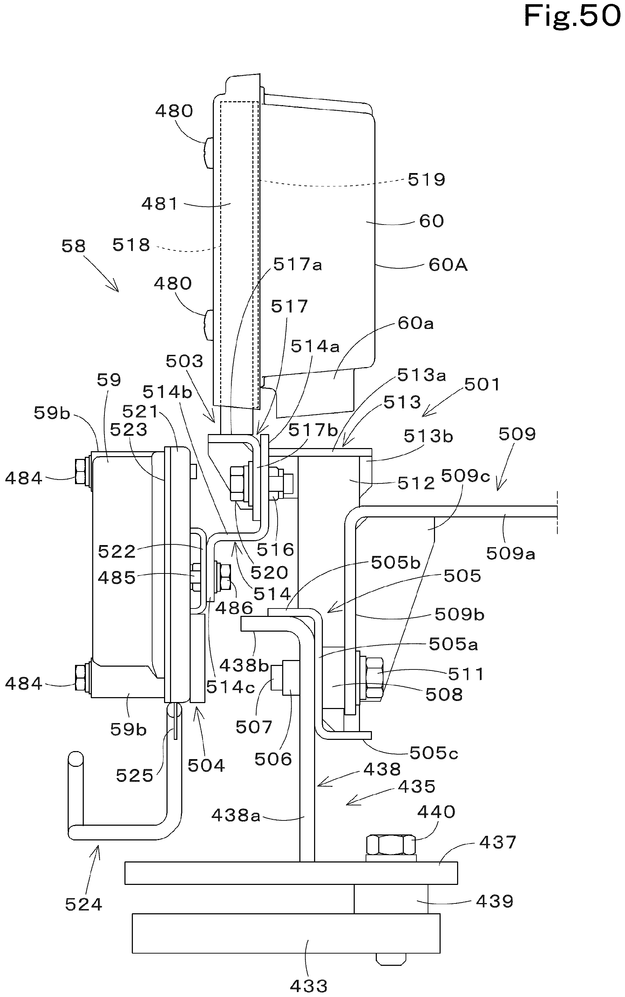

As illustrated in FIGS. 44 and 47, the DCU 60 is located at a position between the first rear pillar 422B and the second rear pillar 422C and at a position slightly lower than the backrest portion 6B of the seat 6. As illustrated in FIG. 50, the IPU 59 is located lower than the DCU 60. Specifically, the IPU 59 is located lower than the DCU 60 and forward of the DCU 60.

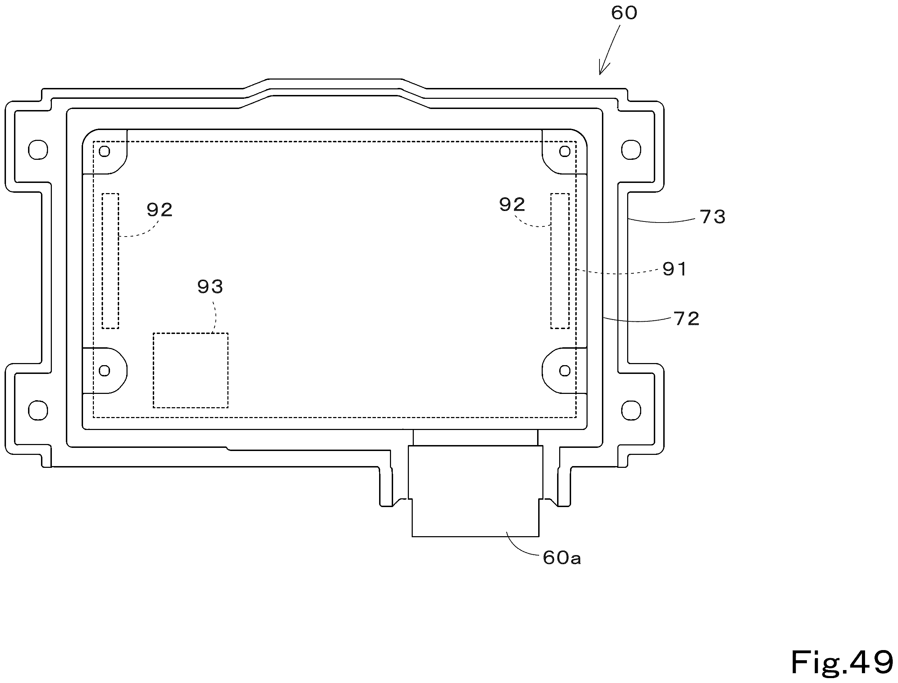

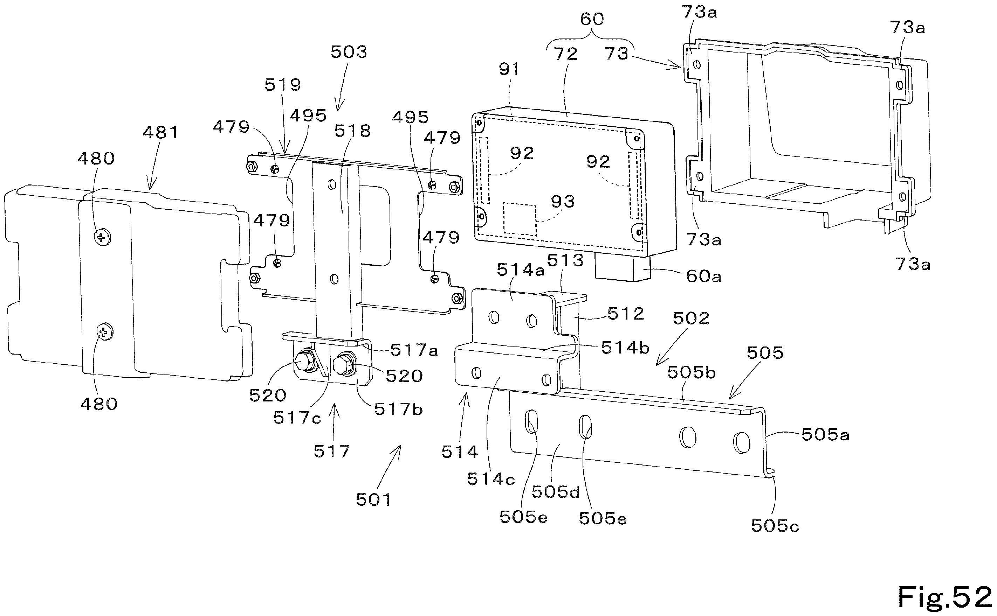

FIG. 49 is a view of the DCU 60 viewed from a device back surface of the DCU 60 (a side opposite to the device front surface 60A). As illustrated in FIGS. 49 and 52, the DCU 60 includes a case 72 and a cover 73 that covers the case 72 from the device front surface 60A. The DCU 60 includes a connection portion 60a to which the harness 64 is connected. The connection portion 60a is provided at a left portion of a lower portion of the case 72.

As illustrated in FIG. 49, the DCU 60 includes an electronic substrate 91 housed in the case 72. The case 72 is in a substantially rectangular parallelepiped shape. The electronic substrate 91 has, attached on its front side (obverse side) on which electronic components are attached, communication antenna(s) (for example, a 3G antenna and/or the like) 92 and a positioning antenna (GPS antenna) 93. The electronic substrate 91 is housed in the case 72 such that the obverse side faces in the same direction as the device front surface 60A. The at least one communication antenna 92 is an antenna for communication with a server, and includes communication antennas 92 provided at a left portion and a right portion of the electronic substrate 91. The communication antennas 92 are contained in the DCU 60.

As illustrated in FIGS. 46, 47, and 50, the working machine 1 includes a unit support 501 that supports the communication unit 58. Specifically, the unit support 501 is attached to the attachment frame 435, and the communication unit 58 (DCU 60 and IPU 59) is attached to the unit support 501.

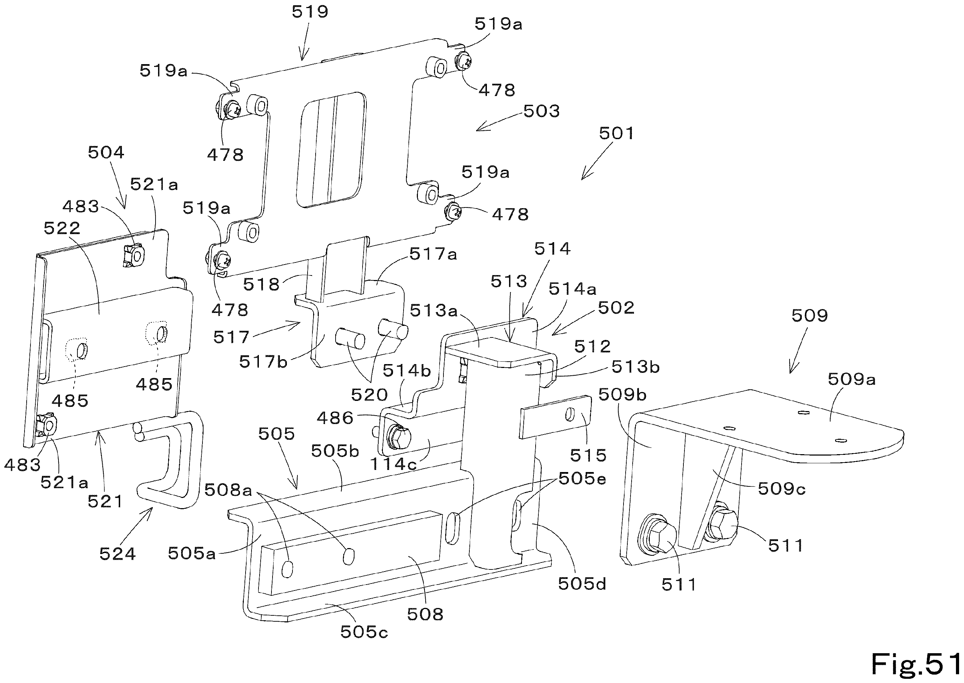

As illustrated in FIG. 51, the unit support 501 includes a base bracket 502, a first device bracket 503, and a second device bracket 504. As illustrated in FIG. 50, the base bracket 502 is attached to the attachment frame 435. The DCU 60 is attached to the first device bracket 503 with the device front surface 60A facing rearward. The IPU 59 is located lower than the DCU 60 and attached to the second device bracket 504.

As illustrated in FIGS. 50 and 51, the base bracket 502 includes an attachment member 505 attached to the attachment frame 435 (vertical plate 438). The attachment member 505 is made of a plate material and is elongated in the machine-body width direction K2. The attachment member 505 includes a first section 505a, a second section 505b, and a third section 505c. The first section 505a is located on an upper portion of a rear surface of the main plate portion 438a of the vertical plate 438 such that plate surfaces face in the front-rear direction K1, and abuts on the rear surface of the main plate portion 438a. The second section 505b extends forward from an upper end of the first section 505a and abuts on an upper surface of the upper wall portion 438b of the vertical plate 438. The third section 505c extends rearward from a lower end of the first section 505a.

As illustrated in FIG. 51, a right portion of the first section 505a is an attached portion 505d that is attached to the vertical plate 438 of the attachment frame 435. The attached portion 505d has a pair of insertion holes 505e arranged in the machine-body width direction K2. The pair of insertion holes 505e are long holes elongated in the up-down direction. The attachment member 505 is fixed to the attachment frame 435 by bolt members 507 (see FIG. 46) that penetrate the insertion holes 505e and the main plate portion 438a and are screwed into nut members 506 (see FIG. 46) fixed to a front surface of the main plate portion 438a.

As illustrated in FIG. 51, a lamp stay attachment portion 508 in a form of a horizontally long block elongated in the machine-body width direction K2 is fixed to a left portion of the first section 505a by welding or the like. A lamp stay 509 is attached to the lamp stay attachment portion 508. The lamp stay 509 includes an upper wall 509a, a front wall 509b extending downward from a front end of the upper wall 509a, and a reinforcing plate 509c fixed across the upper wall 509a and the front wall 509b. The lamp stay 509 is fixed to the lamp stay attachment portion 508 (attachment member 505) by bolt members 511 that penetrate the front wall 509b and are screwed into screw holes 508a (holes each having an internal thread in the inner peripheral surface) formed in the lamp stay attachment portion 508.

As illustrated in FIG. 47, a lamp member 510 is attached to the upper wall 509a of the lamp stay 509. The lamp member 510 includes, for example, a rotating lamp, and is turned on and rotated when crane work is performed.

The lamp stay 509 is located higher than the rear portion cover 17C. The lamp stay 509 is set at a position at which the lamp stay 509 does not contact the rear portion cover 17C even when the rear portion cover 17C is swung upward.

The lamp stay 509 can be attached to a portion of the attachment frame 435 to which the attached portion 505d is attached. That is, in the third embodiment, the unit support 501 is attached to the attachment frame 435 of the canopy 405 by using the portion to which the lamp stay 509 is attached. Accordingly, the communication unit 58 can be mounted on the working machine 1 by retrofitting. However, this does not imply any limitation. The unit support 501 may be configured to be attachable to the attachment frame 435 or another section irrespective of the lamp stay 509.

As illustrated in FIGS. 50 and 51, the base bracket 502 includes a vertical member 512 protruding upward from the attachment member 505, a fixing plate 513 fixed to an upper end portion of the vertical member 512, and an attachment plate 514 fixed to a front portion of the fixing plate 513.

The vertical member 512 is made of a channel steel and is positioned to extend in the up-down direction such that an opening faces forward. A lower portion of the vertical member 512 is fixed to a rear surface of the first section 505a and an upper surface of the second section 505b of the attachment member 505 by welding or the like. An upper portion of the vertical member 512 protrudes upward from the attachment member 505. A clamp stay 515 to which a clamping member that holds the harness 64 (branch portion 64a) is attached is fixed to a middle portion in the up-down direction of a rear surface of the vertical member 512.

The fixing plate 513 is made of a plate material and includes an upper wall 513a with plate surfaces facing in the up-down direction, and a side wall 513b extending downward from a right end of the upper wall 513a. The upper wall 513a is located at an upper end of the vertical member 512 and is fixed to the upper end by welding or the like. The side wall 513b is fixed to a right surface of the upper portion of the vertical member 512. The fixing plate 513 protrudes forward from the vertical member 512.

The attachment plate 514 is made of a plate material and includes a first wall portion 514a located forward of the fixing plate 513 such that plate surfaces face in the front-rear direction K1, a second wall portion 514b extending forward from a lower end of the first wall portion 514a, and a third wall portion 514c extending downward from a front end of the second wall portion 514b. An upper portion of the first wall portion 514a is fixed to a front end of the fixing plate 513 by welding or the like. Nut members 516 are fixed to a rear surface of the first wall portion 514a (see FIG. 50). The first wall portion 514a is a section to which the first device bracket 503 is attached. The third wall portion 514c is a section to which the second device bracket 504 is attached.

As illustrated in FIGS. 51 and 52, the first device bracket 503 includes an attachment stay 517, a vertical member 518, and a bracket body 519.

The attachment stay 517 is made of a plate material and includes an upper wall 517a with plate surfaces facing in the up-down direction, a rear wall 517b extending downward from a rear end of the upper wall 517a, and a reinforcing plate 517c fixed across the upper wall 517a and the rear wall 517b. The attachment stay 517 is fixed to the first wall portion 514a of the attachment plate 514 (base bracket 502) by bolt members 520 that penetrate the rear wall 517b and the first wall portion 514a and are screwed into the nut members 516.

The vertical member 518 is made of a channel steel and is located above the attachment stay 517 to extend in the up-down direction such that an opening faces rearward. A lower end of the vertical member 518 is fixed to the upper wall 517a of the attachment stay 517 by welding or the like.

The bracket body 519 is made of a plate material and is located rearward of the vertical member 518 such that plate surfaces face in the front-rear direction K1. A middle portion in the machine-body width direction K2 of the bracket body 519 is fixed to the vertical member 518 by welding or the like.

The bracket body 519 includes a plurality of cover attachment portions 519a. Attachment pieces 73a at four corners of the cover 73 are attached to the cover attachment portions 519a by screws 478 or the like. The case 72 is also attached to the bracket body 519 by screws 479 or the like.

As illustrated in FIGS. 51 and 52, the bracket body 519 has cutouts 495 corresponding to the communication antennas 92. The communication antennas 92 have directivity in the plate thickness direction of the electronic substrate 91. The cover 73 is made of resin, and the portions of the bracket body 519 corresponding to the communication antennas 92 are cut out so as not to disturb radio wave directivity of the communication antennas 92.

As illustrated in FIGS. 50 and 52, the working machine 1 includes a cover 481 that covers a front surface (a side opposite to a side on which the DCU 60 is attached) of the bracket body 519. The cover 481 is made of resin and in a shape that covers the bracket body 519, the vertical member 518, and a peripheral edge portion of the DCU 60 (cover 73) from the front. The cover 481 improves the appearance.

The cover 481 is attached to the vertical member 518 by screws 480. Since the cover 481 is made of resin, the cover 481 does not disturb the radio wave directivity of the communication antennas 92.

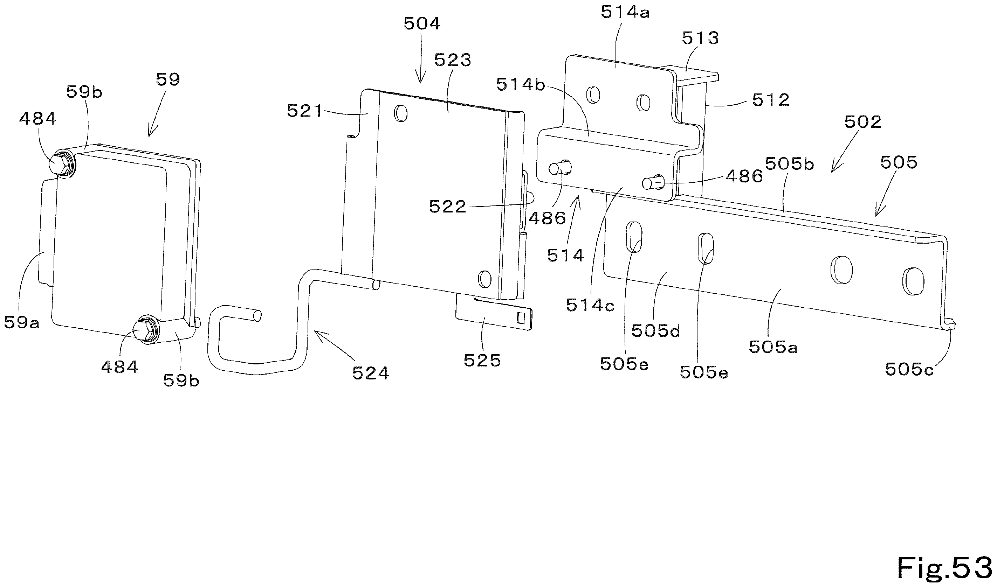

As illustrated in FIGS. 51 and 53, the second device bracket 504 includes a bracket body 521, an attachment bracket 522, and a backing plate 523.

The bracket body 521 is made of a plate material and is located forward of the third wall portion 514c of the attachment plate 514 such that plate surfaces face in the front-rear direction K1. The bracket body 521 includes device attachment portions 521a at an upper and right portion and a lower and left portion. Nut members 483 are fixed to rear surfaces of the respective device attachment portions 521a. Attachment bosses 59b are provided at an upper and right portion and a lower and left portion of the IPU 59. The IPU 59 is located on a front surface of the bracket body 521 and is fixed to the bracket body 521 (second device bracket 504) by bolt members 484 that penetrate the attachment bosses 59b and the device attachment portions 521a of the bracket body 521 and are screwed into the nut members 483.

The attachment bracket 522 is made of a channel steel and is located rearward of the bracket body 521 to extend in the machine-body width direction K2 such that an opening faces forward. The attachment bracket 522 is fixed to a middle portion in the up-down direction of a rear surface of the bracket body 521 by welding or the like. A pair of nut members 485 arranged in the machine-body width direction K2 are fixed to a front surface of the attachment bracket 522. The attachment bracket 522 (second device bracket 504) is fixed to the third wall portion 514c (base bracket 502) by bolt members 486 that penetrate the third wall portion 514c of the attachment plate 514 and the attachment bracket 522 and are screwed into the nut members 485.

The backing plate 523 is made of, for example, a member having a cushioning property and is interposed between the bracket body 521 and the IPU 59.

As illustrated in FIGS. 48 and 53, a harness guide 524 that guides a harness is fixed to a lower and right portion of the bracket body 521. Also, a fuse stay 525 to which a fuse 68 is attached is fixed to a lower and left portion of the bracket body 521.

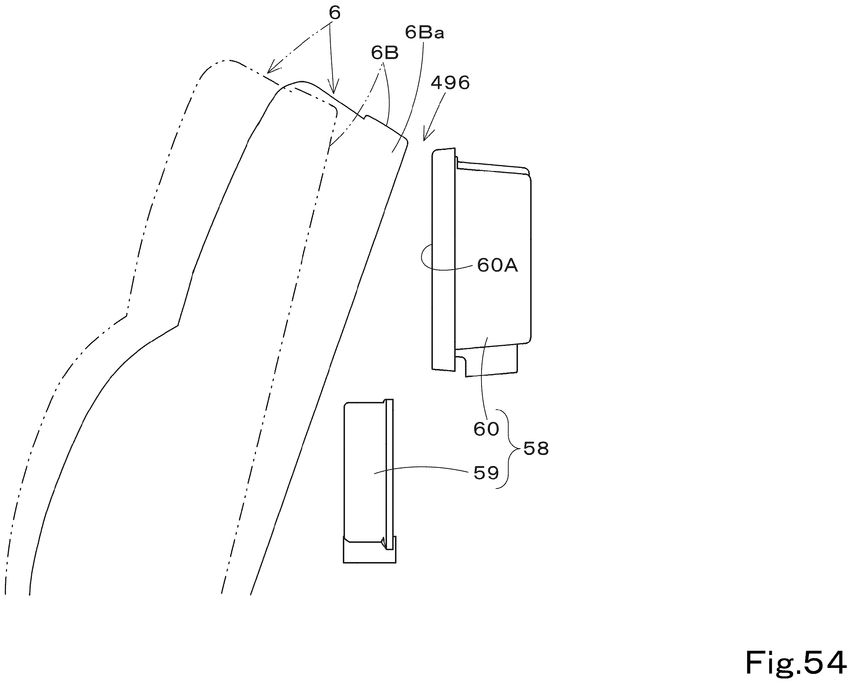

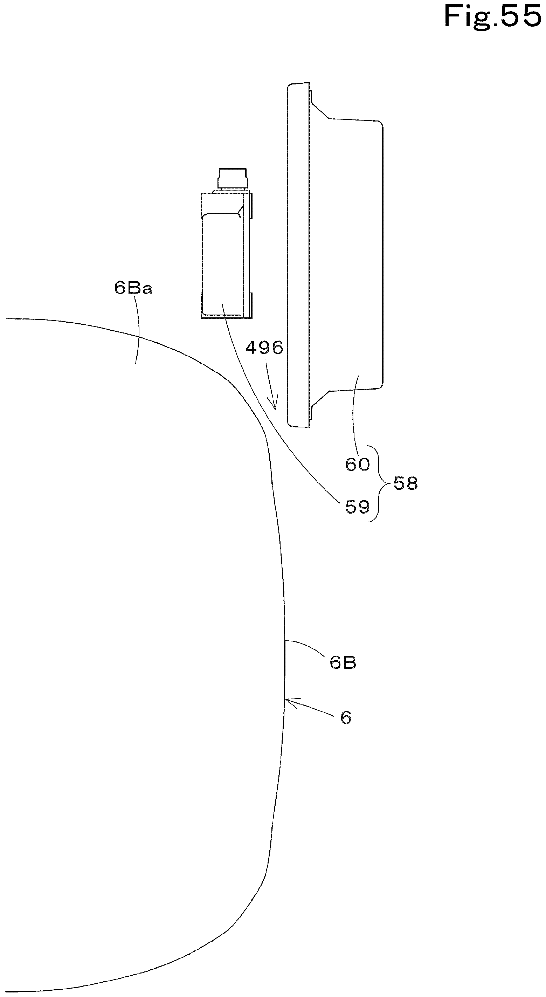

FIGS. 54 and 55 illustrate the positional relationship between the seat 6 and the communication unit 58 (DCU 60 and IPU 59). FIG. 54 is a left side view, and FIG. 55 is a plan view. In FIG. 54, a position of the seat 6 indicated by a solid line indicates a position in which the seat 6 is reclined to the maximum. In FIG. 55, the seat 6 indicates the position in which the seat 6 is reclined to the maximum. As illustrated in FIGS. 54 and 55, the communication unit 58 is provided such that a gap 496 is formed between the seat 6 and the communication unit 58 (DCU 60 and IPU 59) even when the seat 6 is reclined to the maximum. That is, the communication unit 58 is located at a position at which the seat 6 does not contact the communication unit 58 (DCU 60 and IPU 59) even when the seat 6 is fully reclined.

FIGS. 56 to 65 illustrate an embodiment according to a variation in which the communication unit 58 is mounted on a working machine 1 on which a cabin 415 is mounted. The communication unit 58 is located in the cabin 415.

In the embodiment according to this variation, as illustrated in FIG. 56, the communication unit 58 is located at a slightly higher position than in the above-described main embodiment according to FIGS. 41 to 55. Specifically, an upper end of the DCU 60 of the communication unit 58 is located at a position higher than an upper end of the backrest portion 6B of the seat 6. The device front surface 60A of the DCU 60 faces rearward as in the above-described main embodiment. That is, in the embodiment according to this variation, the device front surface 60A of the DCU 60 faces a glass surface of a rear window 455 of the cabin 415.

In the embodiment according to this variation, the other positional relationship between the communication unit 58 and the seat 6 and the positional relationship between the communication unit 58 and the console 44R are established substantially similarly to those in the above-described main embodiment.

Also, in the embodiment according to this variation, the attachment structure of the communication unit 58 is different from that of the main embodiment, and the structures other than the attachment structure of the communication unit 58, that is, the structures of the machine body 2, the working device 4, the hood 17, and the like are configured similarly to those of the above-described main embodiment.

As illustrated in FIGS. 56, 57 and 58, the cabin 415 includes a pair of front pillars 449L and 449R provided in the machine-body width direction K2, a front window 454 provided between the left front pillar 449L and the right front pillar 449R, a pair of rear pillars 450L and 450R provided in the machine-body width direction K2, a rear window 455 provided between the left rear pillar 450L and the right rear pillar 450R, a quarter pillar 452 provided between the left front pillar 449L and the left rear pillar 450L, a door 456 provided between the left front pillar 449L and the quarter pillar 452, a side window 457 provided between the quarter pillar 452 and the left rear pillar 450R, a roof 453 defining a top portion, and the like.

The front window 454, the rear window 455, and the side window 457 have window openings and glasses that close the window openings. Each of the glasses has light transmissivity.

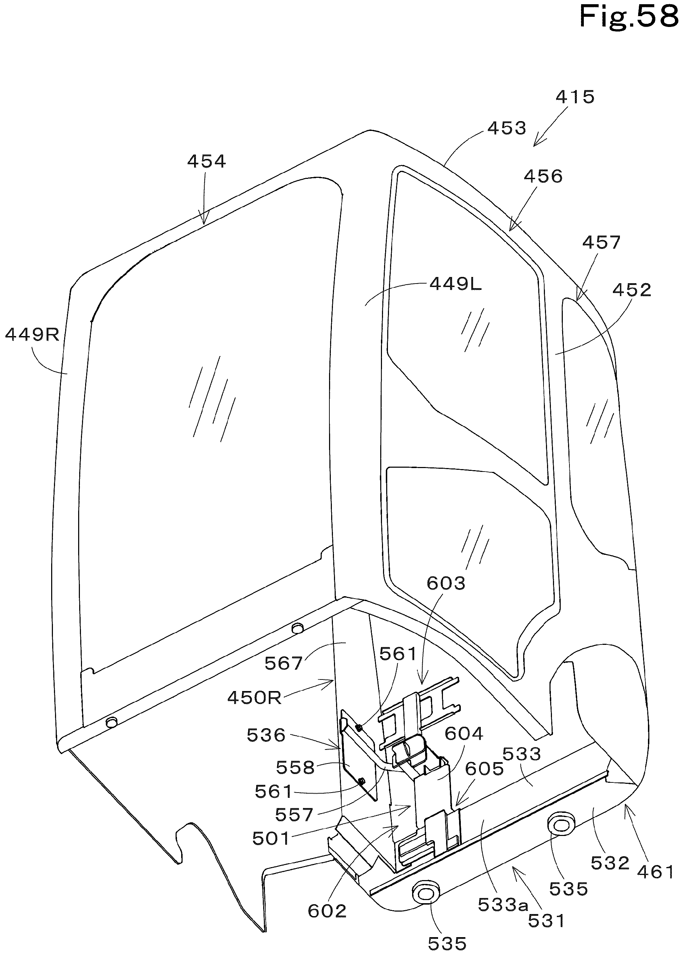

As illustrated in FIG. 58, the cabin 415 includes an attachment frame 531 on a coupling portion 461 coupling lower portions of the left rear pillar 450L and the right rear pillar 450R, on the interior side of the cabin. The attachment frame 531 is attached to the above-described support frame 430.

As illustrated in FIG. 58, the attachment frame 531 includes a base member 532 and a vertical plate 533. The base member 532 is in a quadrangular tubular shape having an axis extending in the machine-body width direction K2 and is provided across the lower portion of the left rear pillar 450L and the lower portion of the right rear pillar 450R.

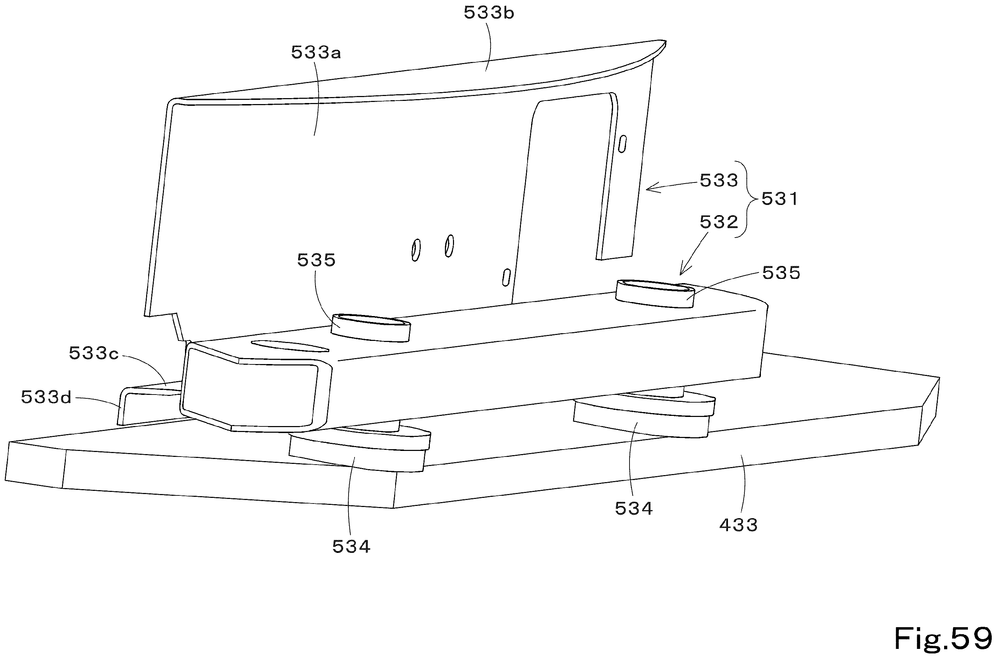

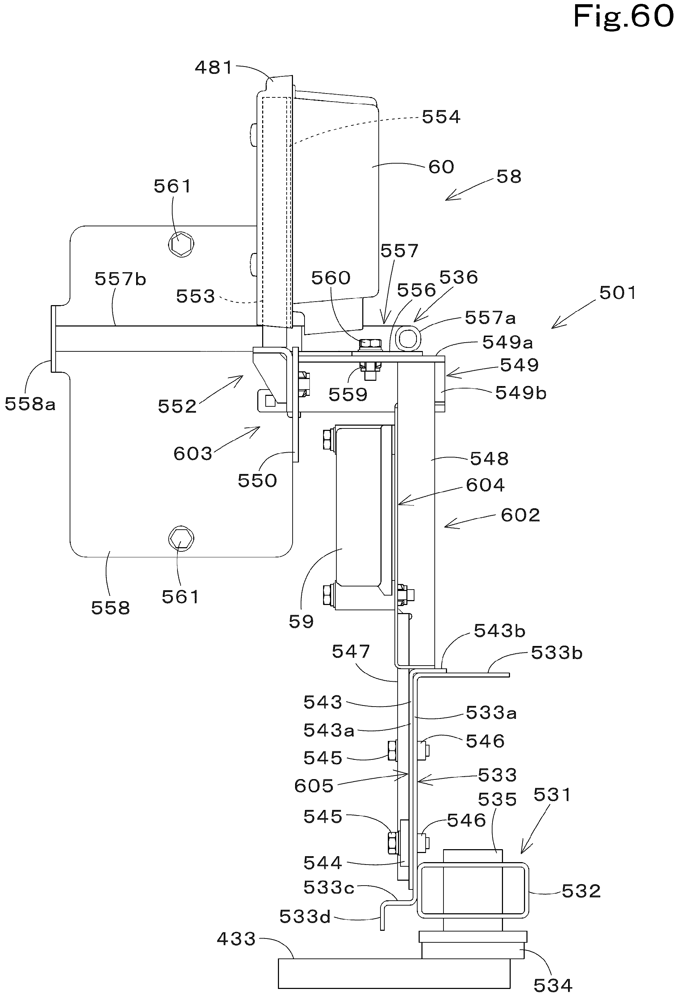

As illustrated in FIGS. 59 and 60, the base member 532 is supported in a vibration-isolating manner by the top plate 433 of the support frame 430 via a pair of vibration isolation members 534 arranged in the machine-body width direction K2. Specifically, tube members 535 that penetrate the base member 532 in the up-down direction and are inserted through upper portions of the vibration isolation members 534 are fixed to a left portion and a right portion of the base member 532. The base member 532 is fixed to the top plate 433 by bolt members (not illustrated) that are inserted through the tube members 535 and the vibration isolation members 534 and screwed into the top plate 433.

As illustrated in FIG. 60, the vertical plate 533 includes a main plate portion 533a positioned such that plate surfaces face in the front-rear direction K1 and having a lower portion fixed to a front surface of the base member 532, an upper wall portion 533b extending rearward from an upper end of the main plate portion 533a, a lower wall 533c extending forward from a lower end of the main plate portion 533a, and an extension wall 533d extending downward from a front end of the lower wall 533c.

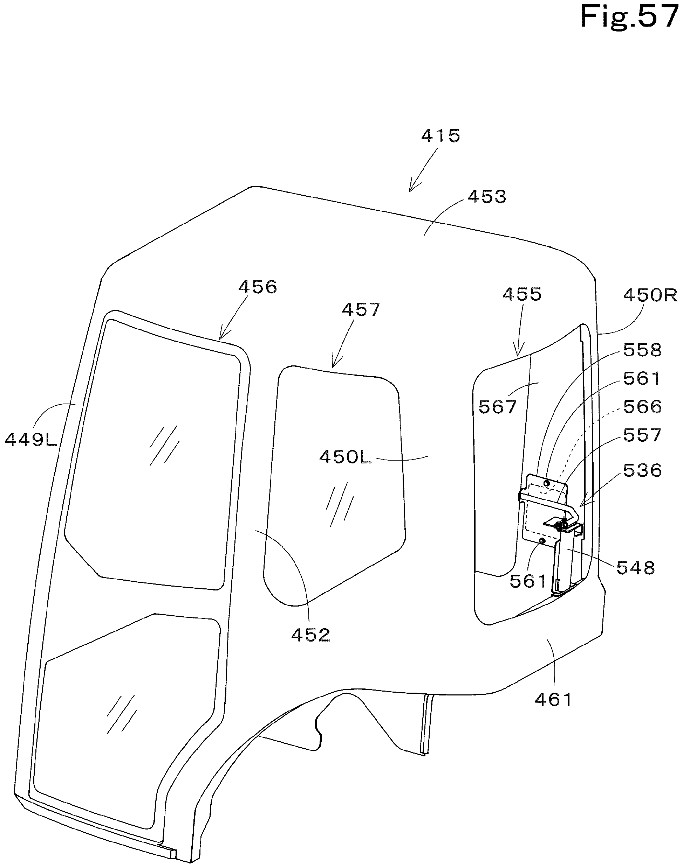

As illustrated in FIG. 60, the unit support 501 that supports the communication unit 58 includes a base bracket 602, a support member 536, a first device bracket 603, and a second device bracket 604. The base bracket 602 is attached to the attachment frame 531. The support member 536 is attached to the right rear pillar 450R (pillar) of the cabin 415 (see FIGS. 57 and 58). The DCU 60 is positioned with the device front surface 60A facing rearward and attached to the first device bracket 603. The IPU 59 is located lower than the DCU 60 and attached to the second device bracket 604.

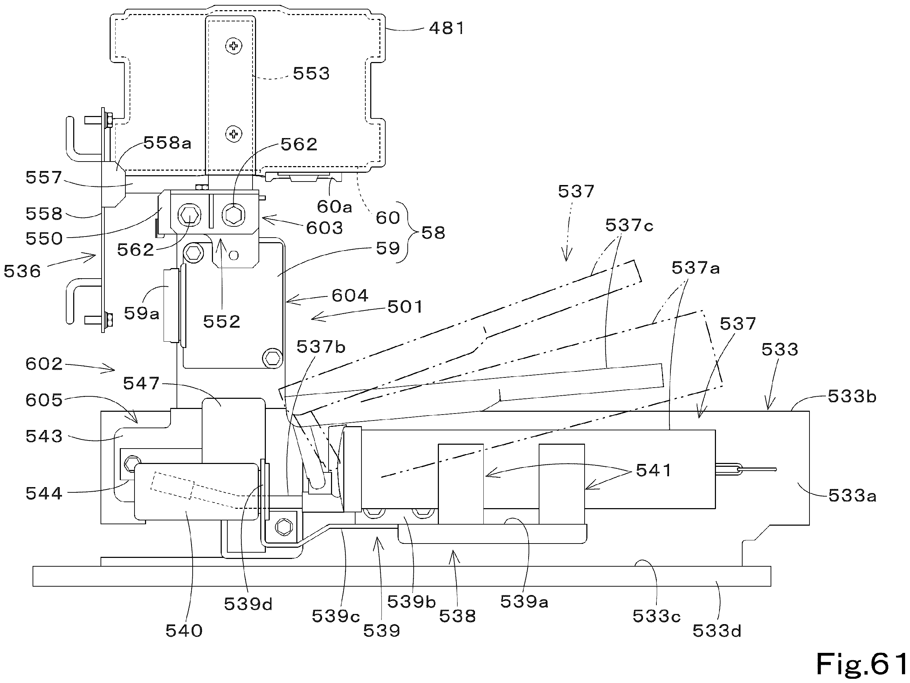

As illustrated in FIG. 61, a grease gun 537 and a grease gun holder 538 that holds the grease gun 537 are located forward of the vertical plate 533.

The grease gun 537 includes a grease tank 537a that stores grease, a discharge pipe 537b that discharges the grease from the grease tank 537a, and an operation handle 537c that performs an operation of discharging the grease from the discharge pipe 537b.

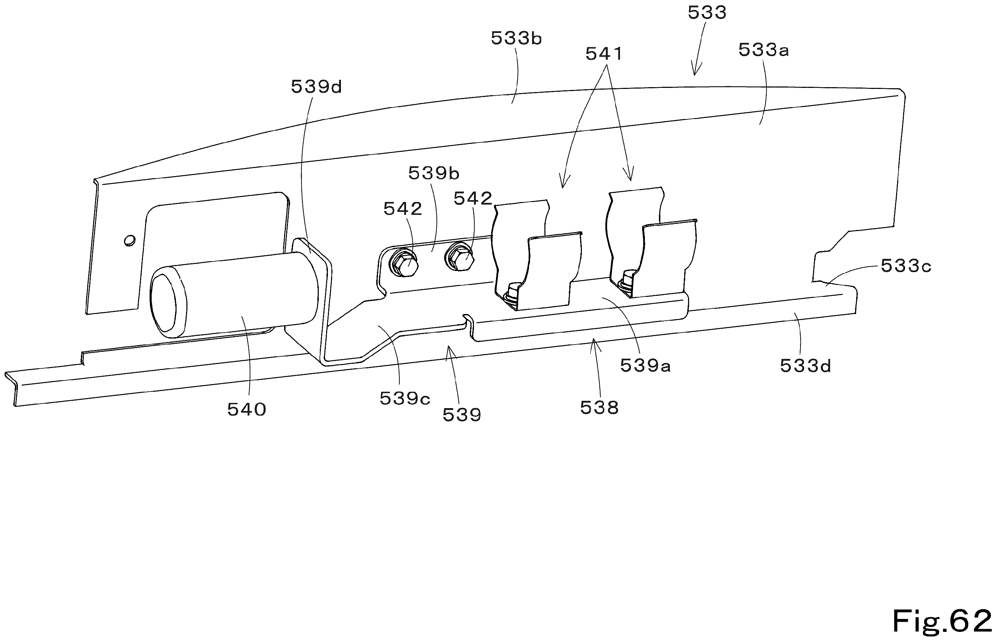

As illustrated in FIG. 62, the grease gun holder 538 includes a holder base 539 attached to the attachment frame 531, a pipe housing tool 540 that houses the discharge pipe 537b, and tank holding tool(s) 541 that elastically holds the grease tank 537a by pressing the grease tank 537a between portions thereof.

The holder base 539 is made of a plate material and includes a main wall portion 539a located forward of the main plate portion 533a of the vertical plate 533 such that plate surfaces face in the up-down direction, an attachment portion 539b extending upward from a rear end of a right portion of the main wall portion 539a and attached to the main plate portion 533a of the vertical plate 533 by bolt members 542, and a fixing portion 539c extending rightward from a right end of the main wall portion 539a and then rising upward. The pipe housing tool 540 is fixed to a rising portion 539d of the fixing portion 539c so as to protrude rightward from the rising portion 539d. The tank holding tool 541 is made of a plate material (spring plate material) having elasticity. The tank holding tool 541 is in a substantially U-shape in a side view with an upper side opened, and is attached to a left portion of the main wall portion 539a by a screw, a rivet, or the like.

As illustrated in FIG. 61, the grease gun holder 538 is attached to the vertical plate 533 (attachment frame 531) such that the pipe housing tool 540 is located below the IPU 59 (communication unit 58) and the tank holding tool 541 are located at a position deviated leftward from below the IPU 59 (communication unit 58). When the grease gun 537 is removed from the grease gun holder 538, the grease tank 537a is separated upward from the tank holding tool 541 as indicated by two-dot chain lines in FIG. 61. The grease gun 537 here is inclined such that the grease gun 537 extends diagonally upward and leftward (extends upward with increasing distance leftward from the IPU 59). Accordingly, the grease gun 537 is prevented from contacting the IPU 59 when the grease tank 537a is removed from the tank holding tool 541. That is, for example, when the grease gun holder 538 is attached in an inverted orientation in the machine-body width direction K2, the tank holding tool 541 is located below the IPU 59, and when the grease tank 537a is removed from the tank holding tool 541, the grease gun 537 may contact the IPU 59. In the present embodiment, since the tank holding tool 541 is located at the position deviated leftward from the IPU 59, the grease gun 537 can be prevented from contacting the IPU 59 when the grease tank 537a is removed from the tank holding tool 541.

As illustrated in FIGS. 60, 63, 64, and 65, the base bracket 602 includes an attachment member 605 attached to the attachment frame 531 (vertical plate 533). The attachment member 605 includes a body member 543 and reinforcing member(s) 544. The body member 543 is made of a plate material and includes a first section 543a and a second section 543b. The first section 543a is positioned such that plate surfaces face in the front-rear direction K1 and abuts on a front surface of the main plate portion 533a of the vertical plate 533. The second section 543b extends rearward from an upper end of the first section 543a and abuts on an upper surface of the upper wall portion 533b of the vertical plate 533.

The at least one reinforcing member 544 is made of a plate material, and includes reinforcing members 544 overlapped with a middle portion in the up-down direction of a right portion and a lower and left portion of the first section 543a of the body member 543 and fixed by welding or the like.

The attachment member 605 is fixed to the attachment frame 531 by bolt members 545 that penetrate the reinforcing members 544, the body member 543, and the main plate portion 533a and are screwed into nut members 546 fixed to a rear surface of the main plate portion 533a.

The base bracket 602 includes a vertical plate 547 fixed to the attachment member 605, a vertical member 548 protruding upward from the vertical plate 547, a fixing plate 549 fixed to an upper end portion of the vertical member 548, and an attachment plate 550 fixed to a front portion of the fixing plate 549.

The vertical plate 547 is made of a band plate material elongated in the up-down direction and is overlapped with a front surface of the attachment member 605 and fixed by welding or the like. An upper portion of the vertical plate 547 protrudes upward from the attachment member 605.

The vertical member 548 is made of a channel steel and is located above the attachment member 605 such that an opening faces forward and extends in the up-down direction. A lower portion of the vertical member 548 is fixed to the upper portion of the vertical plate 547 and an upper end of the attachment member 605 by welding or the like.

The fixing plate 549 is made of a plate material and includes an upper wall 549a that is located at an upper end of the vertical member 548 such that plate surfaces face in the up-down direction and is fixed to the upper end by welding or the like, and a side wall 549b extending downward from a right end of the upper wall 549a. The side wall 549b is provided to be spaced apart rightward from the vertical member 548. A reinforcing plate 551 is provided between the side wall 549b and the vertical member 548. The fixing plate 549 protrudes forward from the vertical member 548.

The attachment plate 550 is made of a plate material and is fixed to a front portion of the fixing plate 549 such that plate surfaces face in the front-rear direction K1.

As illustrated in FIGS. 60 and 63 to 65, the support member 536 includes an attachment stay 556, a plate member 558, and a support rod 557.

The attachment stay 556 is made of a plate material and is overlapped with the upper wall 549a of the fixing plate 549 such that plate surfaces face in the up-down direction. The attachment stay 556 is fixed to the fixing plate 549 by bolt members 560 that penetrate the attachment stay 556 and the upper wall 549a and are screwed into nut members 559 fixed to a lower surface of the upper wall 549a.

As illustrated in FIGS. 57 and 58, the plate member 558 is attached to the right rear pillar 450R of the cabin 415. Specifically, the plate member 558 is fixed to an inner plate member 567 provided on the right rear pillar 450R, on the interior side of the cabin 415, by bolt members 561. As illustrated in FIG. 57, the plate member 558 is attached to the inner plate member 567 such hat the plate member 558 closes an opening 566 in the inner plate member 567. The opening 566 is, for example, a hole that is used when wiring is provided in an internal space of the rear pillar 450R. However, this does not imply any limitation. It is enough that the support member 536 is attached to the rear pillar 449L (pillar) of the cabin 415.

The support rod 557 includes a first section 557a fixed to the attachment stay 556, a second section 557b fixed to the plate member 558, and a third section 557c coupling the first section 557a and the second section 557b. A distal end of the support rod 557 (an end portion of the second section 557b) is fixed to an extension piece 558a extending from a middle portion in the up-down direction of a front end of the plate member 558.

The first device bracket 603 includes an attachment stay 552, a vertical member 553, and a bracket body 554. The attachment stay 552 is attached to the attachment plate 550 by bolt members 562 or the like. The first device bracket 603 is configured substantially similarly to that in the main embodiment, and therefore description of the structure of the first device bracket 603 and the attachment of the DCU 60 will be omitted.

The second device bracket 604 is made of a plate material, is positioned such that plate surfaces face in the front-rear direction K1, and is fixed to an upper portion of the vertical plate 547, the vertical member 548, the vertical plate 533 (second section 543b), and the like by welding or the like. The IPU 59 is attached to a front surface of the second device bracket 604.

A working machine 1 according to the third embodiment includes a machine body 2; a seat 6 on the machine body 2; a console 44R located at one side of the seat 6 and including a manual operator 45R; and a communication unit 58 located rearward of the console 44R and including an information processing device (IPU 59) and a communication device (DCU 60) to receive data from and transmit data to the information processing device 59, the communication device 60 containing a communication antenna 92 and configured to transmit data.

With this configuration, since the communication unit 58 including the information processing device 59 and the communication device 60 is located rearward of the console 44R including the manual operator 45R, it is possible to achieve a useful layout in which the communication performance of the communication unit 58 and the ease of operation of the manual operator 45R can be ensured.

The seat 6 is provided at a position deviated in a first direction along a machine-body width direction K2 from a central portion in the machine-body width direction K2 of the machine body 2. The console 44R is located sideward of the seat 6 in a second direction along the machine-body width direction K2. The communication unit 58 is located diagonally rearward of the seat 6 and sideward of the seat 6 in the second direction along the machine-body width direction K2.

Also with this configuration, the communication unit 58 can be provided in a useful layout. Also, since the communication unit 58 is located at or near the central portion in the machine-body width direction K2 of the machine body 2, the restriction on attaching the communication unit 58 can be reduced.

The working machine 1 further includes a prime mover E1 provided at a rear portion of the machine body 2; and a hood 17 to house the prime mover E1. The communication unit 58 is located above the hood 17.

Also with this configuration, the communication unit 58 can be provided in a useful layout.

The working machine 1 includes a seat protector (canopy 405, cabin 415) provided on the machine body 2; a unit support 501 to support the communication unit 58; and a support frame 430 provided on the machine body 2 to support the hood 17. The seat protector 405, 415 includes an attachment frame 435, 531 attached to the support frame 430. The unit support 501 includes an attachment member 505, 605 attached to the attachment frame 435, 531.

With this configuration, the communication unit 58 can be attached using the attachment frame 435, 531 of the seat protector 405, 415, making it possible to simplify the structure.

The unit support 501 includes a first device bracket 503, 603 to which the communication device 60 is attached with a device front surface 60A of the communication device 60 facing rearward, and a second device bracket 504, 604 to which the information processing device 59 is attached.

With this configuration, since the communication device 60 is positioned with the device front surface facing rearward, the communication performance can be ensured.

Note that the information processing device 59 may be located below the communication device 60. The communication unit 58 can be compactly positioned in the front-rear direction K1 by providing the information processing device 59 below the communication device 60.

The working machine 1 further includes a lamp member 510; and a lamp stay 509 to which the lamp member 510 is attached. The unit support 501 includes a lamp stay attachment portion 508 to which the lamp stay 509 is attached.

With this configuration, since the lamp stay attachment portion 508 is provided on the unit support 501, the structure can be simplified.

In the working machine 1, the seat protector is a cabin 415 surrounding the seat 6. The unit support 501 includes a support member 536 attached to a pillar (rear pillar 450R) of the cabin 415.

With this configuration, the communication unit 58 can be supported stably.

The seat 6 includes a seat portion 6A for a user to sit on and a backrest portion 6B provided at a rear portion of the seat portion 6A such that the backrest portion 6B is reclineable. The communication unit 58 is located diagonally rearward of the backrest portion 6B and sideward of the backrest portion 6B in a second direction along a machine-body width direction K2 such that the backrest portion 6B does not contact the communication unit 58 even when the backrest portion 6B is reclined.

With this configuration, the communication unit 58 can be located rearward of the seat 6.

The working machine 1 further includes a grease gun holder 538 to hold a grease gun 537 including a grease tank 537a to store grease and a discharge pipe 537b to allow the grease to be discharged from the grease tank 537a. The grease gun holder 538 includes a pipe housing tool 540 to house the discharge pipe 537b, and a tank holding tool 541 to elastically hold the grease tank 537a by pressing the grease tank 537a between portions thereof, and the grease gun holder 538 is attached to the attachment frame 435, 531 such that the pipe housing tool 540 is located below the communication unit 58 and the tank holding tool 541 is located not below the communication unit 58.

With this configuration, when the grease gun 537 is removed from the grease gun holder 538, it is possible to prevent or reduce contact of the grease gun 537 with the communication unit 58.

While embodiments of the present invention have been described above, it is to be understood that the embodiments disclosed herein are considered as examples in all aspects and are not considered as limitations. The scope of the present invention is to be determined not by the foregoing description but by the claims, and is intended to include all variations and modifications within the scope of the claims and their equivalents.

### Reference Signs List

- 2: machine body
- 6: seat
- 6A: seat portion
- 6B: backrest portion
- 17: hood
- 37: pin
- 44R: console
- 45R: manual operator
- 49: guard member
- 50: pedal member
- 51: meter
- 58: communication unit
- 59: information processing device
- 59a: connection portion
- 60: communication device
- 60A: device front surface
- 61: unit support
- 64: harness
- 65: unit bracket
- 66: support bracket
- 67: attached section (attachment stay)
- 72: case
- 76: attachment tool
- 85: controller
- 86: controller support
- 91: electronic substrate
- 92: communication antenna
- 96b: constituent portion
- 108: harness guide
- 118: attaching section (attachment plate)
- 123: pin insertion hole
- 222: support bracket
- 226: fixing member
- 236: attachment bracket
- 238: attachment wall
- 238a: attachment surface
- 239: cover member
- 265: unit bracket
- 266: attachment member
- 267: vertical member
- 269: first bracket member
- 270: second bracket member
- 271: attachment stay
- 299: fixing bracket
- 301: coupling stay
- 405: seat protector (canopy)
- 415: seat protector (cabin)
- 430: support frame
- 435: attachment frame
- 450R: pillar (rear pillar)
- 501: unit support
- 503: first device bracket
- 504: second device bracket
- 505: attachment member
- 508: lamp stay attachment portion
- 509: lamp stay
- 510: lamp member
- 531: attachment frame
- 536: support member
- 537: grease gun
- 537a: grease tank
- 537b: discharge pipe
- 538: grease gun holder
- 540: pipe housing tool
- 541: tank holding tool
- 603: first device bracket
- 604: second device bracket
- 605: attachment member
- E1: prime mover
- K1: front-rear direction
- K2: machine-body width direction

## Claims

1. A working machine comprising:
a machine body;
a seat on the machine body;
a console located outward of the seat in a machine-body width direction;
a meter provided at a front portion of the console;
a communication unit located forward of the meter; and
a unit support to support the communication unit, wherein
the unit support includes a unit bracket to which the communication unit is attached, a support bracket located outward of the meter in the machine-body width direction and attached directly or indirectly to the machine body, and an attachment tool to attach the unit bracket to the support bracket,
the unit bracket includes an attached section,
the support bracket includes an attaching section with which the attached section overlaps in the machine-body width direction, and
the attachment tool attaches the attached section to the attaching section in the machine-body width direction.

2. The working machine according to claim 1, further comprising:
a pin provided at one of the attaching section and the attached section such that the pin is deviated from a position at which the attachment tool is attached; and a pin insertion hole provided in the other of the attaching section and the attached section, wherein
the attached section is attached to the attaching section via the attachment tool with the pin inserted through the pin insertion hole.

3. The working machine according to claim 2, wherein
the pin insertion hole is a long hole elongated in an up-down direction, and
the attachment tool fastens the attaching section and the attached section above the pin.

4. The working machine according to any one of claims 1 to 3, further comprising:
a controller located outward of the meter in the machine-body width direction; and
a controller support attached directly or indirectly to the machine body to support the controller, wherein
the support bracket is attached on the controller support along a front-rear direction, and
the controller support includes a constituent portion including an upper surface extending below the attaching section and the attached section and extending diagonally forward and downward.

5. The working machine according to any one of claims 1 to 4, wherein
the communication unit includes an information processing device and a communication device to receive data from and transmit data to the information processing device, the communication device containing a communication antenna and configured to transmit data,
the information processing device is located on a back side of the communication device and includes, at a lower side thereof, a connection portion to have a harness connected thereto, and
the unit bracket includes a guard member to guard the harness connected to the connection portion from below.

6. The working machine according to claim 5, wherein a pedal member to be depressed by a user seated on the seat is located below the guard member.

7. The working machine according to any one of claims 1 to 6, wherein the attachment tool is attached to the attached section and the attaching section through a space between the meter and the communication unit in an inward-to-outward direction along the machine-body width direction.

8. The working machine according to any one of claims 1 to 7, wherein the support bracket includes a harness guide to restrict a movement in the machine-body width direction and a downward movement of a harness guided rearward from the communication unit and extending above the support bracket.

9. A working machine comprising:
a machine body;
a seat on the machine body;
a console located at one side of the seat;
a communication unit;
a unit bracket to which the communication unit is attached;
a support bracket vertically provided directly or indirectly on the machine body to support the console; and
an attachment bracket provided at the support bracket to attach the unit bracket.

10. The working machine according to claim 9, wherein
the communication unit includes an information processing device and a communication device to receive data from and transmit data to the information processing device, the communication device containing a communication antenna and configured to transmit data, and
the information processing device and the communication device are arranged in a front-rear direction.

11. The working machine according to claim 10, wherein the communication device includes an electronic substrate with the communication antenna attached on an obverse side thereof, and a case to house the electronic substrate such that the obverse side faces in the same direction as a device front surface of the communication device, and the device front surface is positioned to face a space above a floor portion located forward of the seat.

12. The working machine according to claim 10 or 11, wherein
the unit bracket includes an attachment member attached to the attachment bracket, a vertical member extending in an up-down direction and including an upper portion to which the attachment member is fixed, a first bracket member fixed forward of the vertical member, and a second bracket member fixed rearward of the vertical member, and
one of the information processing device and the communication device is attached to the first bracket member, and the other of the information processing device and the communication device is attached to the second bracket member.

13. The working machine according to claim 12, wherein
the attachment bracket is provided at an upper portion of the support bracket such that the attachment bracket protrudes sideways from the support bracket away from the seat, and includes an attachment wall including an attachment surface facing in the up-down direction, and
the attachment member is attached to the attachment wall such that the attachment member and the attachment wall overlap each other in the up-down direction.

14. The working machine according to claim 12 or 13, further comprising:
a fixing member which is attached to the machine body and to which a lower portion of the support bracket is attached, wherein
the unit bracket includes an attachment stay fixed to a lower portion of the vertical member and attached to the fixing member.

15. The working machine according to claim 12 or 13, further comprising:
a fixing bracket fixed to a lower portion of the support bracket, wherein
the unit bracket includes a coupling stay fixed to a lower portion of the vertical member and coupled to the fixing bracket.

16. The working machine according to any one of claims 9 to 15, further comprising:
a harness connected to the communication unit; and
a cover member attached to the support bracket to cover a side of the harness that faces the seat.

17. The working machine according to any one of claims 9 to 16, further comprising a harness connected to the communication unit, the harness being for use for both working machines including a cabin on the machine body and working machines including no cabins on the machine body.

18. A working machine comprising:
a machine body;
a seat on the machine body;
a console located at one side of the seat and including a manual operator; and
a communication unit located rearward of the console and including an information processing device and a communication device to receive data from and transmit data to the information processing device, the communication device containing a communication antenna and configured to transmit data.

19. The working machine according to claim 18, wherein
the seat is provided at a position deviated in a first direction along a machine-body width direction from a central portion in the machine-body width direction of the machine body,
the console is located sideward of the seat in a second direction along the machine-body width direction, and
the communication unit is located rearward of the seat and sideward of the seat in the second direction along the machine-body width direction.

20. The working machine according to claim 18 or 19, further comprising:
a prime mover provided at a rear portion of the machine body; and
a hood to house the prime mover, wherein
the communication unit is located above the hood.

21. The working machine according to claim 20, further comprising:
a seat protector provided on the machine body;
a unit support to support the communication unit; and
a support frame provided on the machine body to support the hood, wherein
the seat protector includes an attachment frame attached to the support frame, and
the unit support includes an attachment member attached to the attachment frame.

22. The working machine according to claim 21, wherein the unit support includes a first device bracket to which the communication device is attached with a device front surface of the communication device facing rearward, and a second device bracket to which the information processing device is attached.

23. The working machine according to claim 21 or 22, further comprising:
a lamp member; and
a lamp stay to which the lamp member is attached, wherein
the unit support includes a lamp stay attachment portion to which the lamp stay is attached.

24. The working machine according to any one of claims 21 to 23, wherein:
the seat protector is a cabin surrounding the seat, and
the unit support includes a support member attached to a pillar of the cabin.

25. The working machine according to any one of claims 18 to 24, wherein
the seat includes a seat portion for a user to sit on and a backrest portion provided at a rear portion of the seat portion such that the backrest portion is reclineable, and
the communication unit is located diagonally rearward of the backrest portion and sideward of the backrest portion in a second direction along a machine-body width direction such that the backrest portion does not contact the communication unit even when the backrest portion is reclined.

26. The working machine according to any one of claims 21 to 24, further comprising:
a grease gun holder to hold a grease gun including a grease tank to store grease and a discharge pipe to allow the grease to be discharged from the grease tank, wherein
the grease gun holder includes a pipe housing tool to house the discharge pipe, and a tank holding tool to elastically hold the grease tank by pressing the grease tank between portions thereof, and the grease gun holder is attached to the attachment frame such that the pipe housing tool is located below the communication unit and the tank holding tool is located not below the communication unit.
